# EUROPEAN PATENT APPLICATION

(11) **EP 4 704 148 A1**
(43) Date of publication of application: **04.03.2026**
(21) Application number: 24797141.9
(22) Date of filing: 25.04.2024
(51) Int. Cl.: H01L 23/12, H01L 21/768, H01L 23/532, H05K 1/02, H05K 1/09, H05K 1/11, H05K 3/16, H05K 3/18, H05K 3/24, H05K 3/40, H05K 3/46

(54) **WIRING DEVICE, METHOD FOR MANUFACTURING WIRING DEVICE, AND REWIRING LAYER**

(30) Priority: 25.04.2023 JP 2023071817; 22.03.2024 JP 2024047039
(71) Applicant: Dai Nippon Printing Co., Ltd., Tokyo 162-8001 (JP)
(72) Inventor: ARITSUKA, Yuki, Tokyo 162-8001 (JP); KURAMOCHI, Satoru, Tokyo 162-8001 (JP); TAKANO, Takamasa, Tokyo 162-8001 (JP); KUDO, Hiroshi, Tokyo 162-8001 (JP)
(74) Representative: Müller-Boré & Partner Patentanwälte PartG mbB
(86) International application number: PCT/JP2024/016320
(87) International publication number: WO 2024/225396

(57) **Abstract**

A wiring device includes a first organic layer including a first upper surface and a first lower surface located opposite the first upper surface, and a plurality of first wires located on the first upper surface. The first organic layer includes a first recess located on the first upper surface between two of the first wires.

## Description

### Technical Field

An embodiment of the present disclosure relates to a wiring device, a manufacturing method for a wiring device, and a redistribution layer.

### Background Art

A packaging technology that mounts a plurality of semiconductor elements with different functions, such as a CPU and a memory, with high density on a single wiring device has been attracting attention. The wiring device includes a redistribution layer that includes an insulating layer and a conductor including fine wires.

### Citation List

### Patent Literature

PTL 1: Japanese Patent No. 6159820

### Disclosure of Invention

As the spacing between wires is reduced, the size of the wiring device can be reduced. However, as the spacing between the wires is reduced, leakage current occurs between the wires.

A first embodiment of the present disclosure aims to provide a wiring device and a manufacturing method for a wiring device, which can effectively solve such inconveniences.

The first embodiment of the present disclosure relates to the following [1] to [23].
[1] A wiring device includes:
   a first organic layer including a first upper surface and a first lower surface located opposite the first upper surface; and
   a plurality of first wires located on the first upper surface, wherein
   the first organic layer includes a first recess located on the first upper surface between two adjacent ones of the first wires.
[2] In the wiring device according to [1], the first recess may have a depth greater than or equal to 0.10 µm. The depth of the first recess is a distance in a thickness direction of the first organic layer from the first upper surface overlapping the first wires to a first bottom surface of the first recess, and, when there is a distribution in depth, the depth refers to a depth at the deepest portion of the recess.
[3] In the wiring device according to [1] or [2], the first organic layer may include a first transition layer that constitutes the first upper surface overlapping the first wires, and the first transition layer may contain metal particles.
[4] In the wiring device according to [3], the first transition layer may have a thickness greater than or equal to 0.05 µm.
[5] In the wiring device according to [3] or [4], the first transition layer may include an upper transition layer that constitutes the first upper surface and a lower transition layer that is in contact with the upper transition layer in a thickness direction of the first organic layer. The upper transition layer may contain metal particles at a concentration higher than or equal to a first threshold. The lower transition layer may contain metal particles at a concentration lower than the first threshold.
[6] The wiring device according to any one of [1] to [5] may further include a first inorganic layer covering the first recess.
[7] In the wiring device according to [6], the first recess may include a first bottom surface and a first side surface extending from the first upper surface toward the first bottom surface, and the first side surface may have a curved shape.
[8] In the wiring device according to [7], the first side surface may have a width greater than or equal to 0.10 µm.
[9] In the wiring device according to any one of [6] to [8], the first inorganic layer may cover the first wires.
[10] In the wiring device according to any one of [6] to [9], each of the plurality of first wires may include a seed layer located on the first upper surface and a body layer located on the seed layer, the seed layer may include a side surface located inside the body layer, and the first inorganic layer may be in contact with the side surface of the seed layer.
[11] In the wiring device according to any one of [6] to [10], the first inorganic layer may have a first opening formed so as to overlap the first upper surface in plan view.
[12] The wiring device according to any one of [3] to [5] may further include a first inorganic layer covering the first recess, the first recess may include a first bottom surface and a first side surface extending from the first upper surface toward the first bottom surface, the first transition layer may include an exposed side surface located at the first side surface of the first recess, and the first inorganic layer may be in contact with the exposed side surface.
[13] The wiring devices according to any one of [1] to [12] may further include a pad located on a surface of the wiring device.
[14] The wiring device according to [13] may further include a semiconductor element including a terminal connected to the pad.
[15] The wiring device according to any one of [1] to [14] may further include a support carrier facing the first lower surface.
[16] The wiring device according to [15] may further include a release layer located between the first lower surface and the support carrier.
[17] The wiring device according to any one of [1] to [16] may further include a substrate facing the first lower surface and a through via penetrating the substrate.
[18] The wiring device according to [17] may further include a wiring substrate including a wire electrically connected to the through via and facing the substrate.
[19] In the wiring device according to [18], the wiring substrate may be a BGA substrate.
[20] The wiring device according to any one of [1] to [19] may further include a second organic layer including a second lower surface covering the first organic layer and the first wires and a second upper surface located opposite the second lower surface, and a plurality of second wires located on the second upper surface. The second organic layer may include a second recess located on the second upper surface between two of the second wires.
[21] In the wiring device according to any one of [1] to [10], each of the first wires may have an aspect ratio greater than or equal to 2.0 and less than or equal to 4.0.
[22] A manufacturing method for a wiring device includes:
   a step of preparing a support carrier;
   a step of forming a first organic layer on the support carrier;
   a first conductor forming step of forming a first conductor including a plurality of first wires located on a first upper surface of the first organic layer; and
   a step of forming a first recess on the first upper surface of the first organic layer between two adjacent ones of the first wires.
[23] In the manufacturing method for a wiring device according to [22], the first conductor forming step may include a reverse sputtering step of colliding ions or plasma with the first organic layer, a sputtering step of forming a seed layer on the first organic layer by sputtering, and a plating step of forming a body layer on the seed layer by electrolytic plating.

### Advantageous Effects of Invention

According to the embodiment of the present disclosure, it is possible to suppress occurrence of leakage current between wires.

### Brief Description of Drawings

[Fig. 1] Fig. 1 is a plan view that shows a wiring device according to a first embodiment.
[Fig. 2] Fig. 2 is a cross-sectional view of the wiring device, taken along the line II-II in Fig. 1.
[Fig. 3A] Fig. 3A is a cross-sectional view that shows an example of a first wiring layer.
[Fig. 3B] Fig. 3B is a plan view that shows an example of first wires and a first recess.
[Fig. 3C] Fig. 3C is a cross-sectional view that shows an example of the first wire and a first transition layer.
[Fig. 4] Fig. 4 is a cross-sectional view that shows an example of a second wiring layer.
[Fig. 5] Fig. 5 is a cross-sectional view that shows a step of forming wires on a release layer.
[Fig. 6] Fig. 6 is a cross-sectional view that shows a step of forming a first organic layer.
[Fig. 7] Fig. 7 is a cross-sectional view that shows a step of forming openings in the first organic layer.
[Fig. 8] Fig. 8 is a cross-sectional view that shows a reverse sputtering step.
[Fig. 9] Fig. 9 is a cross-sectional view that shows a step of forming a first transition layer.
[Fig. 10] Fig. 10 is a cross-sectional view that shows a step of forming a seed layer.
[Fig. 11] Fig. 11 is a cross-sectional view that shows a step of forming a resist layer.
[Fig. 12] Fig. 12 is a cross-sectional view that shows a step of forming a body layer.
[Fig. 13] Fig. 13 is a cross-sectional view that shows a step of removing the resist layer.
[Fig. 14A] Fig. 14A is a cross-sectional view that shows a step of removing part of the seed layer.
[Fig. 14B] Fig. 14B is a plan view that shows a step of removing part of the seed layer.
[Fig. 15] Fig. 15 is a cross-sectional view that shows a step of forming the first recesses.
[Fig. 16] Fig. 16 is a cross-sectional view that shows a step of forming the second wiring layer.
[Fig. 17A] Fig. 17A is a cross-sectional view that shows a step of forming connecting portions and a surface layer.
[Fig. 17B] Fig. 17B is a plan view that shows a step of forming the connecting portions and the surface layer.
[Fig. 18A] Fig. 18A is a cross-sectional view that shows a step of mounting semiconductor elements.
[Fig. 18B] Fig. 18B is a plan view that shows a step of mounting the semiconductor elements.
[Fig. 19] Fig. 19 is a cross-sectional view that shows a step of forming a molding resin layer.
[Fig. 20] Fig. 20 is a plan view that shows a cutting step.
[Fig. 21] Fig. 21 is a cross-sectional view that shows an example of the wiring device.
[Fig. 22] Fig. 22 is a cross-sectional view that shows an example of the wiring device.
[Fig. 23] Fig. 23 is a cross-sectional view that shows an example of the wiring device.
[Fig. 24A] Fig. 24A is a cross-sectional view that shows an example of the first wiring layer.
[Fig. 24B] Fig. 24B is a cross-sectional view that shows an example of the first wire and the first transition layer.
[Fig. 25] Fig. 25 is a cross-sectional view that shows an example of the second wiring layer.
[Fig. 26] Fig. 26 is a cross-sectional view that shows an example of the wiring device.
[Fig. 27] Fig. 27 is a diagram that shows examples of a product to which the wiring device is mounted.
[Fig. 28] Fig. 28 is a cross-sectional view that shows a first area to a sixth area of the first wiring layer.
[Fig. 29] Fig. 29 is a cross-sectional image of the first area.
[Fig. 30] Fig. 30 shows graphs that illustrate the results of EDX in the first area.
[Fig. 31] Fig. 31 is a cross-sectional image of the second area.
[Fig. 32] Fig. 32 shows graphs that illustrate the results of EDX in the second area.
[Fig. 33] Fig. 33 is a cross-sectional image of the third area and the fourth area.
[Fig. 34] Fig. 34 shows graphs that illustrate the results of EDX in the third area.
[Fig. 35] Fig. 35 shows graphs that illustrate the results of EDX in the fourth area.
[Fig. 36] Fig. 36 is a cross-sectional image of the fifth area and the sixth area.
[Fig. 37] Fig. 37 shows graphs that illustrate the results of EDX in the fifth area.
[Fig. 38] Fig. 38 shows graphs that illustrate the results of EDX in the sixth area.
[Fig. 39] Fig. 39 is a cross-sectional view that shows a seventh area to an eleventh area of the first wiring layer.
[Fig. 40] Fig. 40 is a cross-sectional image of the seventh area to the eleventh area.
[Fig. 41] Fig. 41 shows graphs that illustrate the results of EDX in the seventh area.
[Fig. 42] Fig. 42 shows graphs that illustrate the results of EDX in the eighth area.
[Fig. 43] Fig. 43 shows graphs that illustrate the results of EDX in the ninth area.
[Fig. 44] Fig. 44 shows graphs that illustrate the results of EDX in the tenth area.
[Fig. 45] Fig. 45 shows graphs that illustrate the results of EDX in the eleventh area.
[Fig. 46] Fig. 46 is a cross-sectional view that shows an example of the first wire and the first transition layer.
[Fig. 47] Fig. 47 is a cross-sectional view that shows an example of the first wire and the first transition layer.
[Fig. 48] Fig. 48 is a cross-sectional view that shows an example of the first wire and the first transition layer in a first comparative embodiment.
[Fig. 49] Fig. 49 is a cross-sectional view that shows an example of a step of forming the first inorganic layer on the first wire of Fig. 48.
[Fig. 50] Fig. 50 is a cross-sectional view that shows an example of a step of forming the first inorganic layer on the first wire of Fig. 48.
[Fig. 51] Fig. 51 is a cross-sectional view that shows an example of the first wire and the first transition layer.
[Fig. 52] Fig. 52 is a cross-sectional view that shows an example of the first wire and the first transition layer.
[Fig. 53] Fig. 53 is a cross-sectional view that shows an example of the first wire and the first transition layer.
[Fig. 54] Fig. 54 is a cross-sectional view that shows an example of the first wire and the first transition layer.
[Fig. 55] Fig. 55 is a cross-sectional view that shows an example of the first wire and the first transition layer.
[Fig. 56] Fig. 56 is a cross-sectional view that shows an example of the first wire and the first transition layer.
[Fig. 57] Fig. 57 is a cross-sectional view that shows an example of the first wire and the first transition layer.
[Fig. 58] Fig. 58 is a cross-sectional view that shows an example of the first wiring layer.
[Fig. 59] Fig. 59 is a cross-sectional view that shows an example of the first wiring layer and the second wiring layer.
[Fig. 60] Fig. 60 is a plan view that shows an array of wiring devices according to a second embodiment.
[Fig. 61] Fig. 61 is a cross-sectional view of the array of wiring devices, taken along the line LXI-LXI in Fig. 60.
[Fig. 62] Fig. 62 is a cross-sectional view that shows an example of a redistribution layer.
[Fig. 63] Fig. 63 is a cross-sectional view that shows an example of an inorganic layer and conductors.
[Fig. 64] Fig. 64 is a plan view that shows an example of a plurality of first openings.
[Fig. 65] Fig. 65 is a plan view that shows an example of the plurality of first openings.
[Fig. 66] Fig. 66 is a plan view that shows an example of the first openings.
[Fig. 67A] Fig. 67A is a plan view that shows an example of the first opening.
[Fig. 67B] Fig. 67B is a plan view that shows an example of the first openings.
[Fig. 68] Fig. 68 is a cross-sectional view that shows a step of forming the first wiring layer.
[Fig. 69] Fig. 69 is a cross-sectional view that shows a step of forming a fourth opening in an organic layer of the first wiring layer.
[Fig. 70] Fig. 70 is a cross-sectional view that shows a step of forming an adhesion layer and a seed layer of the second wiring layer.
[Fig. 71] Fig. 71 is a cross-sectional view that shows a step of forming the body layer of the second wiring layer.
[Fig. 72] Fig. 72 is a cross-sectional view that shows a step of removing part of the adhesion layer and seed layer of the second wiring layer.
[Fig. 73] Fig. 73 is a cross-sectional view that shows a step of forming the inorganic layer of the second wiring layer.
[Fig. 74] Fig. 74 is a cross-sectional view that shows a step of forming the first openings and a second opening in the inorganic layer of the second wiring layer.
[Fig. 75] Fig. 75 is a cross-sectional view that shows a step of forming the organic layer of the second wiring layer.
[Fig. 76] Fig. 76 is a cross-sectional view that shows a step of forming the conductors on the second wiring layer.
[Fig. 77] Fig. 77 is a cross-sectional view that shows a step of joining an upper surface of the redistribution layer to a substrate.
[Fig. 78] Fig. 78 is a cross-sectional view of a step of irradiating light onto the release layer.
[Fig. 79] Fig. 79 is a cross-sectional view that shows a step of separating the redistribution layer from the support carrier.
[Fig. 80] Fig. 80 is a cross-sectional view that shows a step of forming the organic layer of the second wiring layer in a first modification.
[Fig. 81] Fig. 81 is a cross-sectional view that shows a step of forming the first openings in the inorganic layer of the second wiring layer in a second modification.
[Fig. 82] Fig. 82 is a cross-sectional view that shows a step of forming the organic layer of the second wiring layer in the second modification.
[Fig. 83] Fig. 83 is a cross-sectional view that shows a step of forming the second opening in the inorganic layer of the second wiring layer in the second modification.
[Fig. 84] Fig. 84 is a cross-sectional view that shows a step of forming the inorganic layer and organic layer of the second wiring layer in a third modification.
[Fig. 85] Fig. 85 is a cross-sectional view that shows a step of forming third openings and a fourth opening in the organic layer of the second wiring layer in the third modification.
[Fig. 86] Fig. 86 is a cross-sectional view that shows a step of forming the first openings and the second opening in the inorganic layer of the second wiring layer in the third modification.
[Fig. 87] Fig. 87 is a cross-sectional view that shows a step of forming a third wiring layer in the third modification.
[Fig. 88] Fig. 88 is a cross-sectional view that shows the redistribution layer in a sixth modification.
[Fig. 89] Fig. 89 is a plan view that shows the second wiring layer of the redistribution layer in the sixth modification.
[Fig. 90] Fig. 90 is a cross-sectional view that shows the redistribution layer in a seventh modification.
[Fig. 91] Fig. 91 is a cross-sectional view that shows the redistribution layer in an eighth modification.
[Fig. 92] Fig. 92 is a plan view that shows the wiring device according to an embodiment.
[Fig. 93] Fig. 93 is a cross-sectional view of the wiring device, taken along the line XCIII-XCIII in Fig. 92.
[Fig. 94] Fig. 94 is a cross-sectional view that shows an example of the first wiring layer.
[Fig. 95A] Fig. 95A is a cross-sectional view that shows an example of the first wire.
[Fig. 95B] Fig. 95B is a cross-sectional view that shows an example of the first wire.
[Fig. 96] Fig. 96 is a cross-sectional view that shows a step of forming a base layer;
[Fig. 97] Fig. 97 is a cross-sectional view that shows a step of forming the seed layer.
[Fig. 98] Fig. 98 is a cross-sectional view that shows a step of forming the first resist layer.
[Fig. 99] Fig. 99 is a cross-sectional view that shows a step of forming the body layer.
[Fig. 100] Fig. 100 is a cross-sectional view that shows a step of removing the resist layer.
[Fig. 101] Fig. 101 is a cross-sectional view that shows a step of removing part of the seed layer.
[Fig. 102] Fig. 102 is a cross-sectional view that shows a step of forming the first inorganic layer.
[Fig. 103] Fig.103 is a cross-sectional view that shows a step of forming the first organic layer.
[Fig. 104] Fig. 104 is a cross-sectional view that shows a step of separating the redistribution layer from the support carrier.
[Fig. 105] Fig. 105 is a plan view that shows an example of the wiring device.
[Fig. 106] Fig. 106 is a cross-sectional view of the wiring device, taken along the line CVI-CVI in Fig. 105.
[Fig. 107] Fig. 107 is a cross-sectional view that shows an example of the wiring device.
[Fig. 108] Fig. 108 is a table that shows the evaluation results of Examples B1 to B4 and Comparative Examples B1 to B2.
[Fig. 109] Fig. 109 is a graph that shows an example of the evaluation results of signal quality.
[fig. 110] Fig. 110 is a table that shows the evaluation results of Examples B5 to B9.
[Fig. 111] Fig. 111 is a view that shows an example of a cross-sectional image of the first wiring layer.
[Fig. 112] Fig. 112 is an example of an enlarged cross-sectional image that shows the surface of the first wire.
[Fig. 113] Fig. 113 is a cross-sectional view that shows an example in which the first wiring layer of the first embodiment includes the first wires of the third embodiment.
[Fig. 114] Fig. 114 is a cross-sectional view that shows an example in which the first wiring layer of the first embodiment includes the first wires of the third embodiment.

### Description of Embodiments

The configuration of a wiring device 10 and a manufacturing method therefor will be described in detail with reference to the drawings. Embodiments described below are examples of the embodiment of the present disclosure, and the present disclosure is not interpreted limitedly to these embodiments. In the specification, the terms "substrate", "base", "sheet", "film", and the like are not distinguished from each other by the name difference. For example, "substrate" is a concept including a member that can be called a sheet or a film. A "surface" indicates a surface that coincides with a plane direction of a plate-like member that is a target in a case where a target plate-like member is viewed from an overall and macro perspective. A normal direction used for a plate-like member indicates a normal direction to a surface of the member. Terms "parallel", "orthogonal", and the like, values of length and angle, and the like that determine shapes, geometrical conditions and the degrees of them, used in the specification, are not limited to strict meanings and are interpreted so as to include the range of degrees to which similar functions can be expected.

In the specification, when a plurality of upper limit candidates and a plurality of lower limit candidates are listed for a parameter, the numeric range of the parameter may be a combination of a selected one upper limit candidate and a selected one lower limit candidate. For example, the sentence "Parameter B, for example, may be larger than or equal to A1, may be larger than or equal to A2, and may be larger than or equal to A3. Parameter B, for example, may be smaller than or equal to A4, may be smaller than or equal to A5, and may be smaller than or equal to A6." will be discussed. In this case, the numeric range of parameter B may be larger than or equal to A1 and smaller than or equal to A4, may be larger than or equal to A1 and smaller than or equal to A5, may be larger than or equal to A1 and smaller than or equal to A6, may be larger than or equal to A2 and smaller than or equal to A4, may be larger than or equal to A2 and smaller than or equal to A5, may be larger than or equal to A2 and smaller than or equal to A6, may be larger than or equal to A3 and smaller than or equal to A4, may be larger than or equal to A3 and smaller than or equal to A5, and may be larger than or equal to A3 and smaller than or equal to A6.

In the attached drawings to be referenced in the present embodiments, the same or similar reference signs denote the same portions or portions having similar functions, and the repeated description can be omitted. The scale ratio of the drawings can be different from the actual ratio for the sake of convenience of illustration, and one or some of components can be omitted from the drawings.

### (First Embodiment)

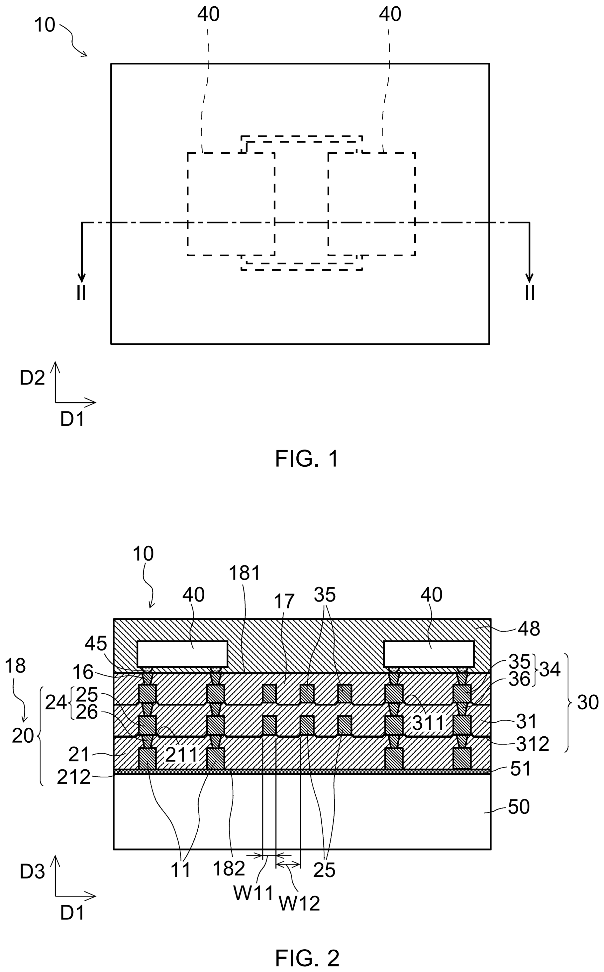

The first embodiment is based on Japanese Patent Application No. 2023-071817 filed on April 25, 2023, the priority of which is claimed. Fig. 1 is a plan view that shows an example of the wiring device 10. Fig. 2 is a cross-sectional view of the wiring device 10, taken along the line II-II in Fig. 1. The wiring device 10 has a first direction D1, a second direction D2, and a third direction D3. The first direction D1 and the second direction D2 are included in a plane direction of the wiring device 10. The first direction D1 is orthogonal to the second direction D2. The third direction D3 is a thickness direction of the wiring device 10. The third direction D3 is orthogonal to the first direction D1 and the second direction D2.

The wiring device 10 includes a redistribution layer 18, semiconductor elements 40, and a molding resin layer 48. The wiring device 10 may include a support carrier 50. The wiring device 10 including the semiconductor elements 40 is also referred to as a semiconductor package.

The component elements of the wiring device 10 will be described.

### (Support Carrier)

The support carrier 50 is a member that supports the redistribution layer 18. The support carrier 50 faces a first wiring layer 20 of the redistribution layer 18. The support carrier 50 may be configured to be separable from the redistribution layer 18. The wiring device 10 may include a release layer 51 located between the support carrier 50 and the redistribution layer 18. As a result, the support carrier 50 can be more easily separated from the redistribution layer 18.

As will be described later, the wiring device 10 is obtained by cutting an intermediate into N pieces. The support carrier 50 is obtained by cutting a support carrier substrate simultaneously with the intermediate into N pieces. The value of N is defined based on the dimensions of the support carrier 50, the dimensions of the wiring device 10, and the like. The fact that the wiring device 10 includes the support carrier 50 means that the wiring device 10 is distributed in a state where the redistribution layer 18 is supported by the support carrier 50. When the redistribution layer 18 is separated from the support carrier 50, the support carrier 50 does not necessarily need to be cut.

Examples of the support carrier 50 may include a glass substrate, a quartz substrate, a sapphire substrate, a resin substrate, a silicon substrate, a silicon carbide substrate, an alumina (Al2O3) substrate, an aluminum nitride (AIN) substrate, a zirconium oxide (ZrO2) substrate, a lithium niobate substrate, and a tantalum niobate substrate. The resin substrate may include an organic material. For example, the resin substrate may include epoxy resin, polyethylene, polypropylene, or the like. The thickness of the support carrier 50 is, for example, greater than or equal to 100 µm, may be greater than or equal to 200 µm, and may be greater than or equal to 500 µm. The thickness of the support carrier 50 is, for example, less than or equal to 2 mm, may be less than or equal to 1.5 mm, and may be less than or equal to 1.1 mm.

The release layer 51 may include a thermoplastic resin. In this case, by heating the wiring device 10, the release layer 51 is more easily separated from the redistribution layer 18. Alternatively, the release layer 51 may include a resin that is more easily separated by irradiating light of a specific wavelength. The thickness of the release layer 51 is, for example, greater than or equal to 0.3 µm, and may be greater than or equal to 1 µm. The thickness of the release layer 51 is, for example, less than or equal to 30 µm, and may be less than or equal to 50 µm.

### (Redistribution Layer)

The redistribution layer 18 includes an upper surface 181 and a lower surface 182. The lower surface 182 faces the support carrier 50. The lower surface 182 may be in contact with the release layer 51. The upper surface 181 is located on the side opposite from the lower surface 182 in the thickness direction. The redistribution layer 18 includes at least one wiring layer. The wiring layer includes at least an organic layer and conductors. In the example shown in Fig. 2, the redistribution layer 18 includes the first wiring layer 20 and a second wiring layer 30 adjacent to the first wiring layer 20 in the thickness direction. The first wiring layer 20 and the second wiring layer 30 are arranged in the thickness direction from the lower surface 182 toward the upper surface 181.

The redistribution layer 18 may include wires 11 that are in contact with the first wiring layer 20. The redistribution layer 18 may include a surface layer 17. The surface layer 17 may constitute the upper surface 181. The redistribution layer 18 may include connecting portions 16 with electronic components such as the semiconductor elements 40 exposed from the surface layer 17. The connecting portions 16 are, for example, pads.

The component elements of the redistribution layer 18 will be described.

### [Wire]

Each of the wires 11 includes a conductive layer that extends in the plane direction of the wiring device 10. The wire 11 may include a portion extending in the first direction D1 and may include a portion extending in the second direction D2. The wires 11 may be located on the release layer 51. The wires 11 may be located between the support carrier 50 and the first wiring layer 20 in the third direction D3. The wires 11 may include connections for connecting with semiconductor elements and other electronic components.

### [First Wiring Layer]

The first wiring layer 20 includes a first organic layer 21 and first conductors 24. The first organic layer 21 includes a first upper surface 211 and a first lower surface 212. The first lower surface 212 faces the support carrier 50. The first upper surface 211 is located on the side opposite from the first lower surface 212 in the thickness direction. The first organic layer 21 may cover the wires 11.

The first organic layer 21 includes an organic material. Examples of the first organic layer may include polyimide, epoxy-based resin, acrylic-based resin, and a combination of two or more of these resins. The thickness of the first organic layer 21 is, for example, greater than or equal to 3 µm, may be greater than or equal to 5 µm, and may be greater than or equal to 10 µm. The thickness of the first organic layer 21 is, for example, less than or equal to 50 µm, may be less than or equal to 30 µm, and may be less than or equal to 20 µm.

The first conductors 24 include a plurality of first wires 25 located on the first upper surface 211. Each of the first wires 25 may include a portion extending in the first direction D1 and may include a portion extending in the second direction D2.

In Fig. 2, reference sign W11 represents the width of the first wire 25. Reference sign W12 represents the spacing between two of the first wires 25. The width W11 and the spacing W12 are defined in a direction orthogonal to the direction in which the first wire 25 extends. The width W11 is, for example, greater than or equal to 0.5 µm, and may be greater than or equal to 1.0 µm. The width W11 is, for example, less than or equal to 5.0 µm, may be less than or equal to 3.0 µm, and may be less than or equal to 2.0 µm. The spacing W12 is, for example, greater than or equal to 0.5 µm, and may be greater than or equal to 1.0 µm. The spacing W12 is, for example, less than or equal to 5.0 µm, may be less than or equal to 3.0 µm, and may be less than or equal to 2.0 µm. The first wiring layer 20 may include the first wires 25 that do not satisfy these numeric ranges in addition to the first wires 25 that satisfy these numeric ranges.

The thickness of the first wire 25 is, for example, greater than or equal to 0.5 µm, and may be greater than or equal to 1.0 µm. The thickness of the first wire 25 is, for example, less than or equal to 15.0 µm, and may be less than or equal to 6.0 µm.

The above-described wires 11 may have similar widths, spacings, and thicknesses to those of the first wires 25. The numeric ranges of the widths, spacings, and thicknesses of the first wires 25 may be adopted as the numeric ranges of the widths, spacings, and thicknesses of the wires 11.

The first conductors 24 may include first through portions 26 located between the first upper surface 211 and the first lower surface 212. The first through portions 26 may be connected to the first wires 25. The first through portions 26 may be connected to the wires 11. Each of the first through portions 26 may be located between the first wire 25 and the wire 11 and may be connected to the first wire 25 and the wire 11.

The first conductors 24, including the first wires 25, the first through portions 26, and the like, include a conductive material. Examples of the first conductors 24 may include metals such as copper, gold, silver, platinum, rhodium, tin, aluminum, nickel, titanium, chromium, and zinc, and alloys using one or more of these metals.

### [Second Wiring Layer]

The second wiring layer 30 includes a second organic layer 31 and second conductors 34. The second organic layer 31 includes a second upper surface 311 and a second lower surface 312. The second lower surface 312 faces the first wiring layer 20. The second upper surface 311 is located on the side opposite from the second lower surface 312 in the thickness direction. The second organic layer 31 may cover the first wires 25 of the first wiring layer 20.

The second organic layer 31 includes an organic material. The material of the above-described first organic layer 21 may be adopted as the material of the second organic layer 31. The numeric ranges of the thickness of the above-described first organic layer 21 may be adopted as the numeric ranges of the thickness of the second organic layer 31.

The second conductors 34 include a plurality of second wires 35 located on the second upper surface 311. Each of the second wires 35 may include a portion extending in the first direction D1 and may include a portion extending in the second direction D2. The numeric ranges of the widths, spacings, and thicknesses of the above-described first wires 25 may be adopted as the numeric ranges of the widths, spacings, and thicknesses of the second wires 35.

The second conductors 34 may include second through portions 36 located between the second upper surface 311 and the second lower surface 312. The second through portions 36 may be connected to the second wires 35. The second through portions 36 may be connected to the first wires 25. Each of the second through portions 36 may be located between the second wire 35 and the first wire 25 and may be connected to the second wire 35 and the first wire 25.

The second conductors 34, including the second wires 35, the second through portions 36, and the like, include a conductive material. The material of the above-described first conductors 24 may be adopted as the material of the second conductors 34.

The widths, spacings, thicknesses, and the like, are calculated based on the cross-sectional image of the wiring device 10, taken with a scanning electron microscope.

### [Surface Layer]

The surface layer 17 may cover the second wires 35 of the second wiring layer 30. The surface layer 17 includes a material having insulating properties. For example, the material of the above-described first organic layer 21 may be adopted as the material of the surface layer 17.

### [Connecting Portion]

The connecting portions 16 include conductive layers connected to terminals 45 of the semiconductor elements 40. The connecting portions 16 may be connected to the wires of a wiring layer such as the second wiring layer 30. For example, the material of the above-described first conductors 24 may be adopted as the material of the connecting portions 16, and a conductive material, such as solder, may also be adopted as the material of the connecting portions 16,.

### (Semiconductor Element)

The semiconductor element 40 includes transistors formed of a semiconductor, such as silicon. Examples of the semiconductor element 40 include a CPU, a GPU, an FPGA, a sensor, and a memory. The semiconductor element 40 may be a chiplet into which a semiconductor element, such as a CPU, a GPU, an FPGA, a sensor, and a memory, is separated by function. The semiconductor element 40 may include a plurality of laminated substrates. The number of semiconductor elements 40 may be one for the single wiring device 10 and may be two or more for the single wiring device 10. When the number of semiconductor elements 40 is two or more for the single wiring device 10, the semiconductor elements 40 may have the same function or may have different functions.

### (Molding Resin Layer)

The molding resin layer 48 is a member for enhancing the strength of a semiconductor package including the wiring device 10. The molding resin layer 48 may cover the semiconductor elements 40.

The molding resin layer 48 includes a resin. The molding resin layer 48 may include, for example, any one of polyimide, epoxy resin, acrylic, bismaleimide, polybenzoxazole, and benzocyclobutene, or a combination of two or more of these resins. The molding resin layer 48 may include a thermosetting resin, such as an epoxy-based resin.

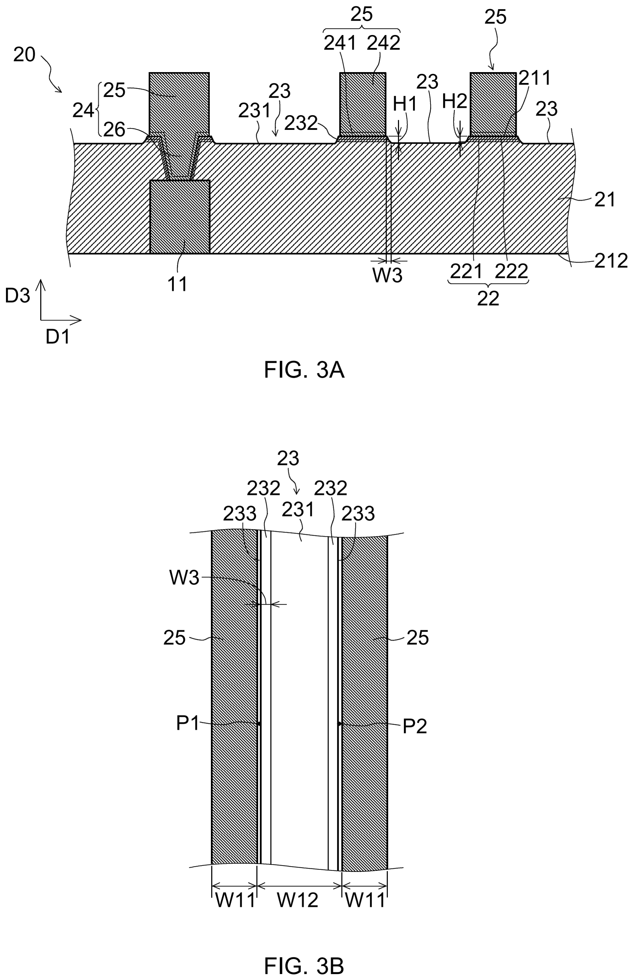

Next, the redistribution layer 18 will be described in detail. Fig. 3A is a cross-sectional view that shows an example of the first wiring layer 20.

As shown in Fig. 3A, the first organic layer 21 may include first recesses 23 located on the first upper surface 211. Each of the first recesses 23 is located between two adjacent first wires 25 in plan view. Each of the first recesses 23 is formed so as to suppress occurrence of leakage current between two adjacent first wires 25 in plan view.

The first recesses 23 may be formed between all pairs of adjacent first wires 25. For example, the first recesses 23 may be formed in all the region of the first organic layer 21 that does not overlap the first wires 25 in plan view. Alternatively, the first recesses 23 may be formed between some pairs of adjacent first wires 25. In that case, the first recesses 23 are preferably formed in the region where the distance between adjacent wires is short, and where leakage current is most likely.

Each of the first recesses 23 may include a first bottom surface 231 and first side surfaces 232. Each of the first side surfaces 232 extends from the first upper surface 211 toward the first bottom surface 231.

Each of the first recesses 23 has a depth of H1. The depth H1 is the maximum value of the distance in the thickness direction from the first upper surface 211 overlapping the first wire 25 to the first bottom surface 231. The depth H1 is, for example, greater than or equal to 0.10 µm, may be greater than or equal to 0.15 µm, and may be greater than or equal to 0.20 µm. By setting the depth H1 to be greater than or equal to 0.10 µm, it is possible to suppress occurrence of leakage current between two adjacent first wires 25. The depth H1 is, for example, less than or equal to 0.50 µm, may be less than or equal to 0.45 µm, and may be less than or equal to 0.40 µm.

In this application, the term "overlap" means that two component elements overlap when viewed along the thickness direction of the wiring device 10.

The first side surface 232 is a portion of the first recess 23 that is adjacent to the first upper surface 211 in the plane direction of the wiring device 10 and located within a distance of 0.9 × H1 from the first upper surface 211 in the thickness direction.

The first side surface 232 of the first recess 23 may have a curved shape. As a result, it is possible to suppress occurrence of concentration of local stress in the first side surface 232 and the layer in contact with the first side surface 232. For this reason, it is possible to suppress occurrence of defects such as cracks in the first organic layer 21 and the layers in contact with the first organic layer 21. In particular, when an inorganic layer (described later) is adopted, it is preferable to suppress stress using the curved shape because the inorganic layer is made of a material that is likely to crack under stress.

The width W3 of the first side surface 232 is, for example, greater than or equal to 0.10 µm, may be greater than or equal to 0.20 µm, may be greater than or equal to 0.30 µm, and may be greater than or equal to 0.50 µm. As the width W3 increases, it is possible to suppress occurrence of concentration of local stress in the first side surface 232 and the layer in contact with the first side surface 232.

The width W3 of the first side surface 232 will be described. Fig. 3B is a plan view of an example of the first wires 25 and the first recess 23. In plan view, two adjacent first wires 25 are also referred to as a first one of the two adjacent first wires 25 and a second one of the two adjacent first wires 25, respectively. In the example shown in Fig. 3B, the left first wire 25 is referred to as the first one of the two adjacent first wires 25, and the right first wire 25 is referred to as the second one of the two adjacent first wires 25. The first recess 23 includes outer edges 233 that represent the contour of the first recess 23 in plan view. The outer edges 233 may include a first outer edge 233 extending along the first one of the two adjacent first wires 25 and a second outer edge 233 extending along the second one of the two adjacent first wires 25. The width W3 of the first side surface 232 is the dimension of the first side surface 232 in a direction orthogonal to the direction in which the outer edge 233 extends. In Fig. 3B, each of the first wires 25 is illustrated as a linear line for convenience; however, each of the first wires 25 may include a curved portion in addition to a straight portion, or may extend in an overall curved shape.

The width W3 of the first side surface 232 is calculated by averaging the measured value at a first position P1 and the measured value at a second position P2. The first position P1 is a position on the first outer edge 233 midway in the direction in which the first wire 25 extends in a region in which the two adjacent first wires 25 extend in parallel. The second position P2 is a position on the second outer edge 233, facing the first position P1 in a direction orthogonal to the direction in which the outer edge 233 extends. Measurement at the first position P1 and measurement at the second position P2 are performed based on the cross-sectional image of the wiring device 10, taken with a scanning electron microscope. The first side surface 232 located at the first position P1 and the first side surface 232 located at the second position P2 appear on one cross-sectional image. Therefore, measurement of the width W3 at the first position P1 and measurement of the width W3 at the second position P2 are performed based on one cross-sectional image.

An element, like the above-described width W11, measured at each of the first position P1 and the second position P2 is calculated by averaging the measured value at a position corresponding to the first position P1 and the measured value at a position corresponding to the second position P2. The first wire 25 adjacent to the first position P1 and the first wire 25 adjacent to the second position P2 appear on one cross-sectional image. Therefore, measurement of the width W11 at the position corresponding to the first position P1 and measurement of the width W11 at the position corresponding to the second position P2 are performed based on one cross-sectional image. An element, like the above-described spacing W12, for which one measured value is obtained between the first position P1 and the second position P2 is calculated based on that one measured value.

As shown in Fig. 3A, each of the first conductors 24 may include a seed layer 241 and a body layer 242. The seed layer 241 is a layer having electrical conductivity and formed by physical film deposition, such as sputtering. The seed layer 241 of each of the first wires 25 is located on the first upper surface 211 of the first organic layer 21. The seed layer 241 of each of the first through portions 26 is located on the wall surface of the opening of the first organic layer 21. The body layer 242 is a layer having electrical conductivity and formed on the seed layer 241 by electrolytic plating.

The seed layer 241 may include a metal material, such as copper, nickel, titanium, chromium, and zinc. The seed layer 241 may include a compound of these metal materials. The seed layer 241 may include a plurality of layers. The body layer 242 may include a metal, such as copper, gold, silver, platinum, rhodium, tin, aluminum, nickel, titanium, chromium, and zinc, or an alloy using one or more of these metals.

As shown in Fig. 3A, the first organic layer 21 may include a first transition layer 22 located at the first upper surface 211. The first transition layer 22 may constitute the first upper surface 211 of the first organic layer 21 at an area where the the first transition layer 22 overlaps the first wire 25 in plan view. The first transition layer 22 is formed, for example, when metal particles that constitute the seed layer 241 enter into the first organic layer 21, for example, through diffusion during physical film deposition, such as sputtering.

The first transition layer 22 containing metal particles that constitute the seed layer 241 can contribute to enhancing the adhesion between the first organic layer 21 and the seed layer 241. In other words, the first transition layer 22 can suppress delamination of the first conductor 24 including the seed layer 241 from the first organic layer 21.

The first transition layer 22 may contain particles of a metal different from the metal that constitutes the seed layer 241. For example, a step of bringing a liquid containing metal particles into contact with the first upper surface 211 of the first organic layer 21 may be performed before a step of forming the seed layer 241. As a result, particles of a metal different from the metal that constitutes the seed layer 241 can enter into the first organic layer 21. The first transition layer 22 that contains particles of a metal different from the metal that constitutes the seed layer 241 can also contribute to enhancing the adhesion between the first organic layer 21 and the seed layer 241.

The first transition layer 22 has a thickness H2. The thickness H2 is, for example, greater than or equal to 0.05 µm, may be greater than or equal to 0.10 µm, and may be greater than or equal to 0.15 µm. The thickness H2 is, for example, less than or equal to 0.35 µm, may be less than or equal to 0.30 µm, and may be less than or equal to 0.25 µm. The thickness H2 of the first transition layer 22 may be less than the depth H1 of the first recess 23. Although not shown in the drawing, the thickness H2 of the first transition layer 22 may be greater than the depth H1 of the first recess 23. For example, the depth of the first recess 23 may be greater than the thickness of an upper transition layer 221 (described later); however, the depth of the first recess 23 may be less than the sum of the thickness of the upper transition layer 221 and the thickness of a lower transition layer 222 (described later).

The concentration of metal particles in the first transition layer 22 may decrease as the distance from the first upper surface 211 increases. For example, as shown in Fig. 3A, the first transition layer 22 may include the upper transition layer 221 and the lower transition layer 222. The upper transition layer 221 constitutes the first upper surface 211 of the first organic layer 21 at an area where the upper transition layer 221 overlaps the first wire 25 in plan view. The lower transition layer 222 is in contact with the upper transition layer 221 in the thickness direction of the first organic layer 21. The upper transition layer 221 contains metal particles at a concentration higher than or equal to a predetermined threshold. The lower transition layer 222 contains metal particles at a concentration lower than the threshold.

The concentration of metal particles in the first transition layer 22 is measured by energy dispersive X-ray analysis (EDX). In measurement, first, a sample of which the surface is constituted by the first organic layer 21 including the first transition layer 22 is prepared. Subsequently, a primary beam is irradiated onto the sample. Based on the detection results of characteristic X-rays generated from the sample, the concentration of metal particles in the first transition layer 22 is calculated.

The metal component that constitutes the seed layer 241 is also referred to as a first metal component. The first metal component is a metal component that accounts for 50mass% or more in the seed layer 241. The metal component that constitutes the body layer 242 is also referred to as a second metal component. The second metal component is a metal component that accounts for 50mass% or more in the body layer 242.

The concentration of the first metal component in the first transition layer 22 and the concentration of the second metal component in the first transition layer 22 may be measured by EDX. The sum of the concentration of the first metal component in the first transition layer 22 and the concentration of the second metal component in the first transition layer 22 may be calculated as the concentration of metal particles in the first transition layer 22. For example, when the first metal component is titanium and the second metal component is copper, the sum of the concentration of titanium and the concentration of copper, measured by EDX, may be calculated as the concentration of metal particles in the first transition layer 22. In this case, the upper transition layer 221 is defined based on whether the sum of the concentration of the first metal component and the concentration of the second metal component is higher than or equal to the threshold. The threshold for evaluating the sum of the concentration of the first metal component and the concentration of the second metal component is referred to as a first threshold. The "main component" refers to a metal component that accounts for 50mass% or more in the layer.

In measurement using EDX, the concentration of a metal component is detected as the count of the characteristic X-rays corresponding to the metal component. The concentration of titanium is detected as the count of the titanium Kα line. The concentration of copper is detected as the count of the copper Kα line. The sum of the count of the titanium Kα line and the count of the copper Kα line is calculated as the concentration of the metal component. The conditions for measurement using EDX are as follows.
Acceleration voltage: 200 kV
The diameter of the primary beam: 0.1 nm
Energy resolution: 140 eV
X-ray take-off angle: 21.9°
Solid angle: 0.98sr
Temperature: 25°C
Time: 30 seconds

The first threshold is, for example, 10 counts, may be 30 counts, may be 50 counts, or may be 100 counts.

The upper transition layer 221 may be defined based on the ratio of the sum of the concentration of the first metal component and the concentration of the second metal component in the first transition layer 22 to the concentration of carbon in the first transition layer 22. For example, the upper transition layer 221 may be defined based on the ratio of the sum of the concentration of titanium and the concentration of copper to the concentration of carbon. A threshold for evaluating the ratio is referred to as a second threshold. The upper transition layer 221 contains metal particles at a ratio higher than or equal to the second threshold. The lower transition layer 222 contains metal particles at a ratio lower than the second threshold. In measurement using EDX, the concentration of carbon is detected as the count of the carbon Kα line.

The second threshold is, for example, 0.1, may be 0.3, may be 0.5, or may be 1.0.

The concentration of metal particles in the first transition layer 22 may be calculated as the concentration of the first metal component that constitutes the seed layer 241 in the first transition layer 22. In this case, the upper transition layer 221 is defined based on the concentration of the first metal component in the first transition layer 22. A threshold for evaluating the concentration of the first metal component is referred to as a third threshold. The upper transition layer 221 contains particles of the first metal component at a concentration higher than or equal to the third threshold. The lower transition layer 222 contains particles of the first metal component at a concentration lower than the third threshold.

The third threshold is, for example, five counts, may be 10 counts, may be 20 counts, or may be 30 counts.

The upper transition layer 221 may be defined based on the ratio of the concentration of the first metal component in the first transition layer 22 to the concentration of carbon in the first transition layer 22. For example, the upper transition layer 221 may be defined based on the ratio of the concentration of titanium to the concentration of carbon. A threshold for evaluating the ratio is referred to as a fourth threshold. The upper transition layer 221 contains particles of the first metal component at a ratio higher than or equal to the fourth threshold. The lower transition layer 222 contains particles of the first metal component at a ratio lower than the fourth threshold.

The fourth threshold is, for example, 0.05, may be 0.10, may be 0.20, or may be 0.30.

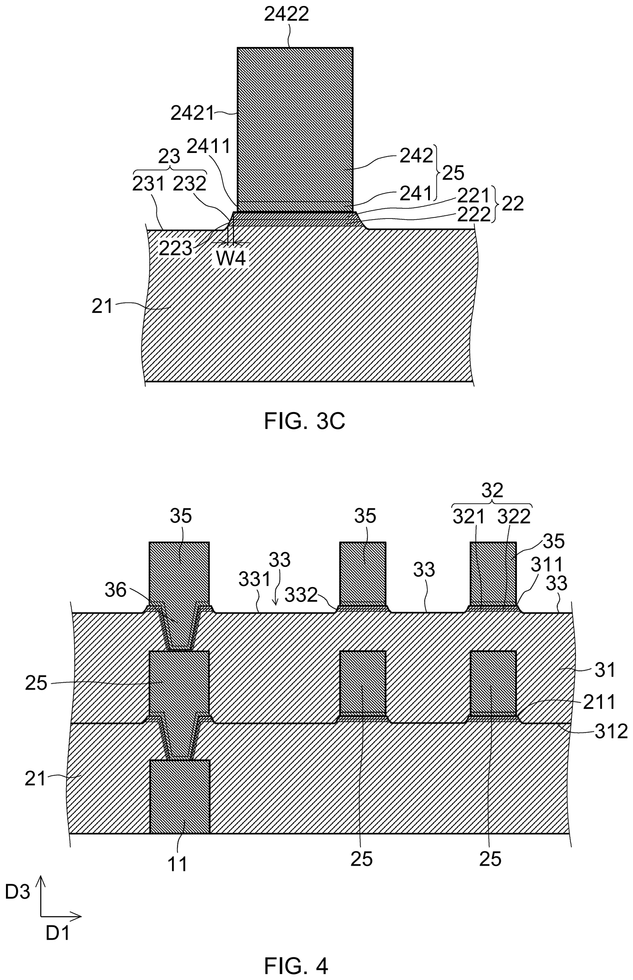

Fig. 3C is a cross-sectional view that shows an example of the first wire 25 and the first transition layer 22. The seed layer 241 of the first wire 25 includes a side surface 2411. The body layer 242 of the first wire 25 includes a side surface 2421 and an upper surface 2422. The upper surface 2422 may constitute the upper surface of the first wire 25. The side surface 2411 of the seed layer 241 may be continuous with the side surface 2421 of the body layer 242 in the cross-sectional view. As will be described later, the side surface 2411 of the seed layer 241 may be located inside the side surface 2421 of the body layer 242 in the cross-sectional view. The "inside" refers to a direction that approaches the center of the first wire 25 in the plane direction of the wiring device 10 in the cross-sectional view taken in a direction orthogonal to the direction in which the first wire 25 extends.

As shown in Fig. 3C, the first transition layer 22 includes a side surface 223 located at the first side surface 232 of the first recess 23. The side surface 223 of the first transition layer 22, located at the first side surface 232 of the first recess 23, is also referred to as an exposed side surface 223.

The exposed side surface 223 has a width W4. The width W4 of the exposed side surface 223 is the dimension of the exposed side surface 223 in a direction orthogonal to the direction in which the outer edge 233 extends.

The width W4 of the exposed side surface 223 is, for example, greater than or equal to 0.05 µm, may be greater than or equal to 0.10 µm, may be greater than or equal to 0.20 µm, and may be greater than or equal to 0.30 µm. The width W4 of the exposed side surface 223 is, for example, less than or equal to 1.00 µm, may be less than or equal to 0.80 µm, may be less than or equal to 0.60 µm, and may be less than or equal to 0.40 µm. The width W4 of the exposed side surface 223 may be less than the width W3 of the first side surface 232.

Fig. 4 is a cross-sectional view that shows an example of the second wiring layer 30. The second wiring layer 30 may also include second recesses 33 located on the second upper surface 311, similarly to the first wiring layer 20. Each of the second recesses 33 is located between two adjacent second wires 35 in plan view. Each of the second recesses 33 is formed so as to suppress occurrence of leakage current between two adjacent second wires 35 in plan view.

Each of the second recesses 33 may include a second bottom surface 331 and second side surfaces 332, similarly to the first recesses 23. The configuration of the second bottom surface 331 and second side surfaces 332 is similar to the configuration of the above-described first bottom surface 231 and first side surfaces 232. For example, the above-described numeric ranges of the depth H1 of the first recess 23 may be adopted as the numeric ranges of the depth of the second recess 33. For example, the above-described numeric ranges of the width W3 of the first side surface 232 may be adopted as the numeric ranges of the width of the second side surface 332.

Each of the second conductors 34 may include a seed layer and a body layer, similarly to the first conductors 24. The configuration of the seed layer and body layer of the second conductor 34 is similar to the configuration of the seed layer 241 and body layer 242 of the above-described first conductor 24.

As shown in Fig. 4, the second organic layer 31 may include a second transition layer 32 located at the second upper surface 311. The configuration of the second transition layer 32 is similar to the configuration of the above-described first transition layer 22.

### (Manufacturing Method for Wiring Device)

Next, a manufacturing method for the wiring device 10 will be described.

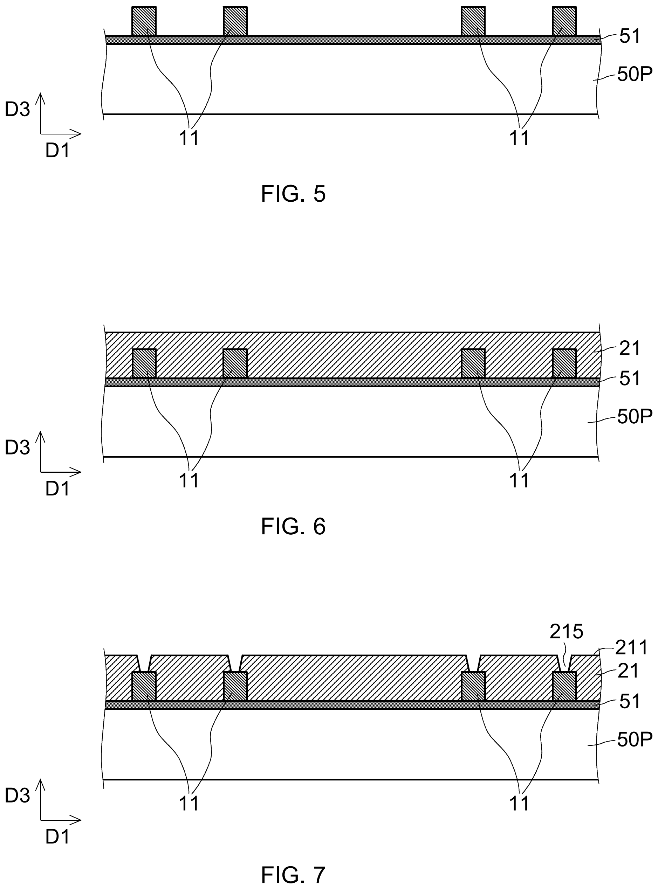

First, as shown in Fig. 5, a support carrier substrate 50P is prepared. Subsequently, the release layer 51 is formed on the support carrier substrate 50P. After that, the wires 11 are formed on the release layer 51.

Subsequently, as shown in Fig. 6, the first organic layer 21 is formed above the support carrier substrate 50P. Subsequently, as shown in Fig. 7, openings 215 are formed in the first upper surface 211 of the first organic layer 21. The openings 215 are formed so as to overlap the wires 11, respectively.

Subsequently, a first conductor forming step of forming the first conductors 24 is performed. The first conductor forming step may include a reverse sputtering step, a sputtering step, and a plating step.

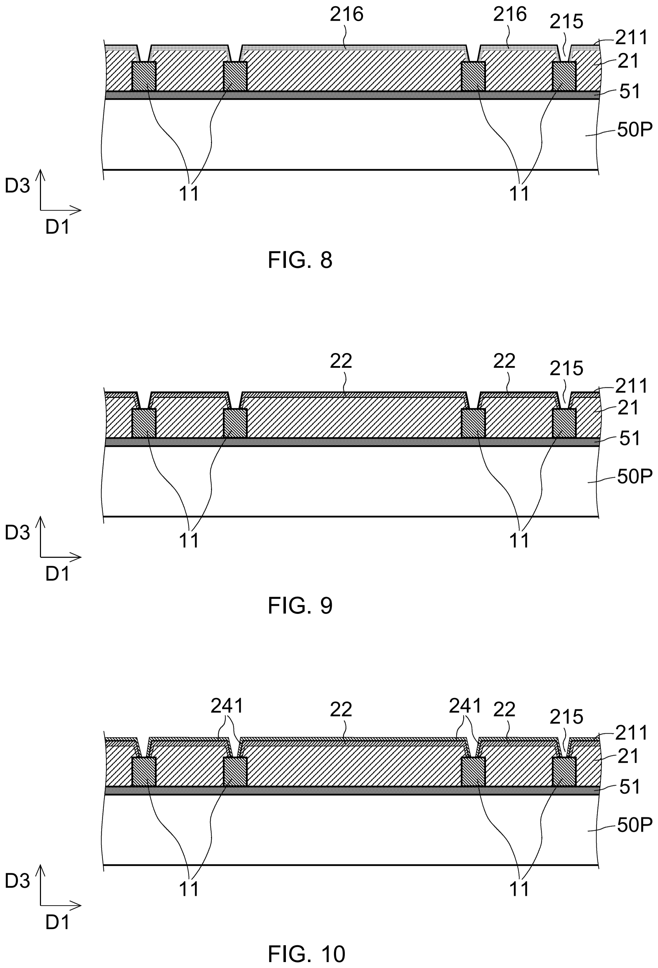

The reverse sputtering step is a step of colliding ions or plasma with the first organic layer 21. Ions are, for example, argon ions. When ions or plasma collide with the first upper surface 211 of the first organic layer 21, the first upper surface 211 is roughened. In Fig. 8, reference sign 216 represents the layer formed by the collision of ions or plasma with the first upper surface 211.

The reverse sputtering step is achieved by generating a voltage in the opposite direction compared to the sputtering step. For example, in the reverse sputtering step, a bias voltage is applied to the first organic layer 21. As a result, ions or plasma is accelerated toward the first organic layer 21 and collides with the first upper surface 211.

After the reverse sputtering step, the sputtering step is performed. In the sputtering step, a bias voltage is applied to a target including a metal material for forming the seed layer 241. In the sputtering step, ions or plasma is accelerated toward a target and collides with the target. Particles of the metal material ejected from the target move toward the first upper surface 211 of the first organic layer 21.

Some of the particles of the metal material that have reached the first upper surface 211 enter into the first organic layer 21, for example, by diffusion. A layer 216 resulting from the reverse sputtering step can facilitate the entry of metal particles into the first organic layer 21. By the entry of particles of the metal material into the first organic layer 21, the first transition layer 22 is formed at the first upper surface 211 of the first organic layer 21, as shown in Fig. 9. As shown in Fig. 10, the seed layer 241 is formed by deposition of particles of the metal material on the first upper surface 211 of the first organic layer 21.

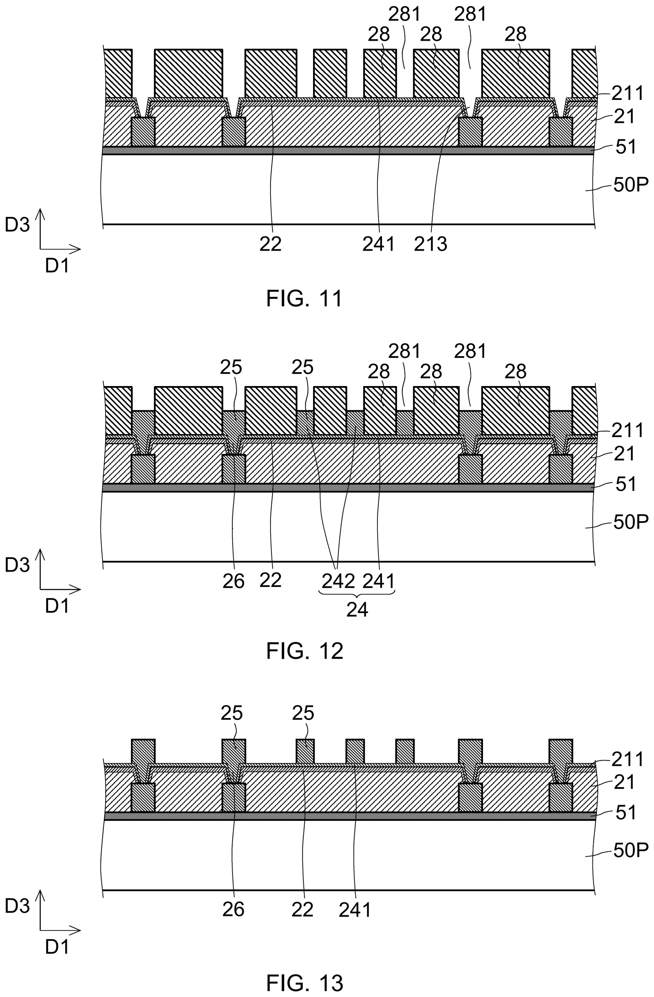

After the seed layer 241 is formed, the first resist layer 28 is formed on the seed layer 241, as shown in Fig. 11. The first resist layer 28 has openings 281 that penetrate the first resist layer 28 in the thickness direction. The openings 281 are formed so as to overlap the openings 215 of the first organic layer 21.

Subsequently, the plating step is performed. In the plating step, the body layers 242 are formed in the openings 281 by electrolytic plating, as shown in Fig. 12. In this way, the first conductors 24 each including the seed layer 241 and the body layer 242 are formed. Portions of the first conductors 24 located in the openings 215 of the first organic layer 21 constitute the first through portions 26. Portions of the first conductors 24 located on the first upper surface 211 of the first organic layer 21 constitute the first wires 25. Subsequently, as shown in Fig. 13, the first resist layer 28 is removed.

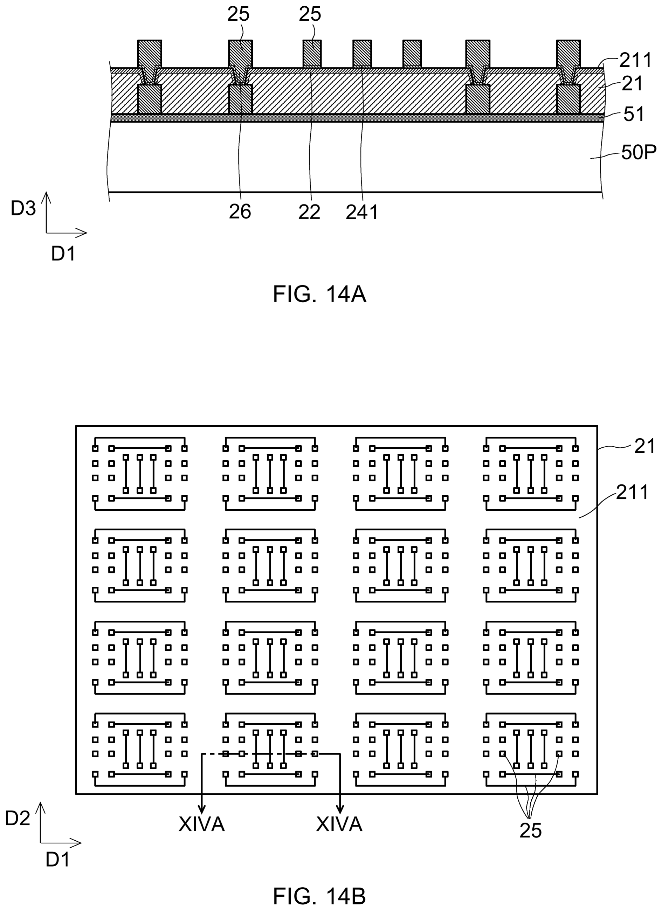

After that, as shown in Fig. 14A, the portions of the seed layer 241 that do not overlap the first wires 25 are removed. As a result, two adjacent first wires 25 are electrically insulated from each other. Fig. 14B is a plan view that shows the first wires 25. Fig. 14A corresponds to a cross-sectional view taken along the line XIVA-XIVA in Fig. 14B.

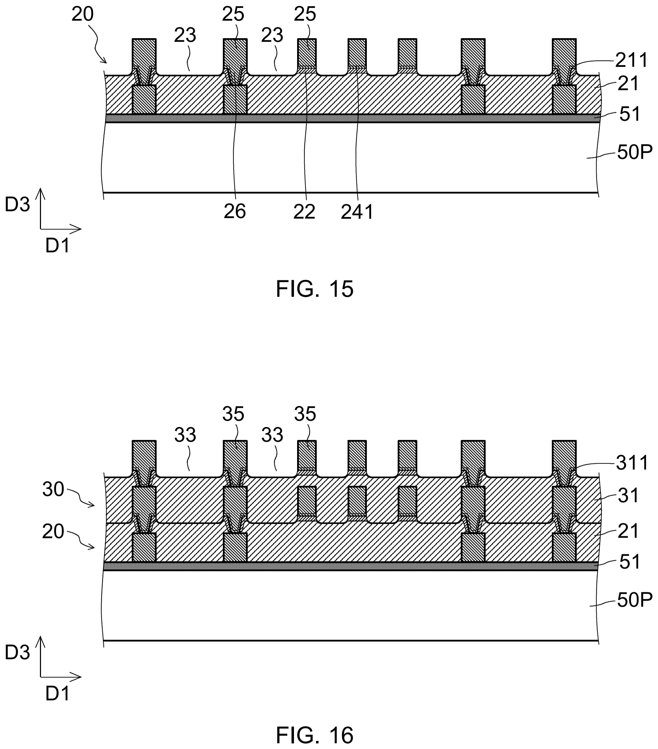

Incidentally, as described above, the first transition layer 22 that constitutes the first upper surface 211 of the first organic layer 21 contains metal particles. For this reason, when the first transition layer 22 continuously extends between two adjacent first wires 25, leakage current may occur between the two adjacent first wires 25. Considering such issues, a step of forming the first recesses 23 on the first upper surface 211 of the first organic layer 21 is performed, as shown in Fig. 15. As a result, it is possible to reduce the electrical conductivity of the first upper surface 211 of the first organic layer 21 located between two adjacent first wires 25. Therefore, it is possible to suppress occurrence of leakage current between two adjacent first wires 25.

A method of forming the first recesses 23 is not limited. For example, the first recesses 23 may be formed by dry etching. The etching gas used in dry etching is, for example, oxygen, nitrogen, fluorocarbon gas represented as C_{X}F_{Y}, hydrocarbon gas represented as C_{X}H_{Y}, or the like, and these gases may be used in combination.

Subsequently, as shown in Fig. 16, the second wiring layer 30 is formed on the first wiring layer 20. A step of forming the second wiring layer 30 is similar to the step of forming the first wiring layer 20, so the description is omitted.

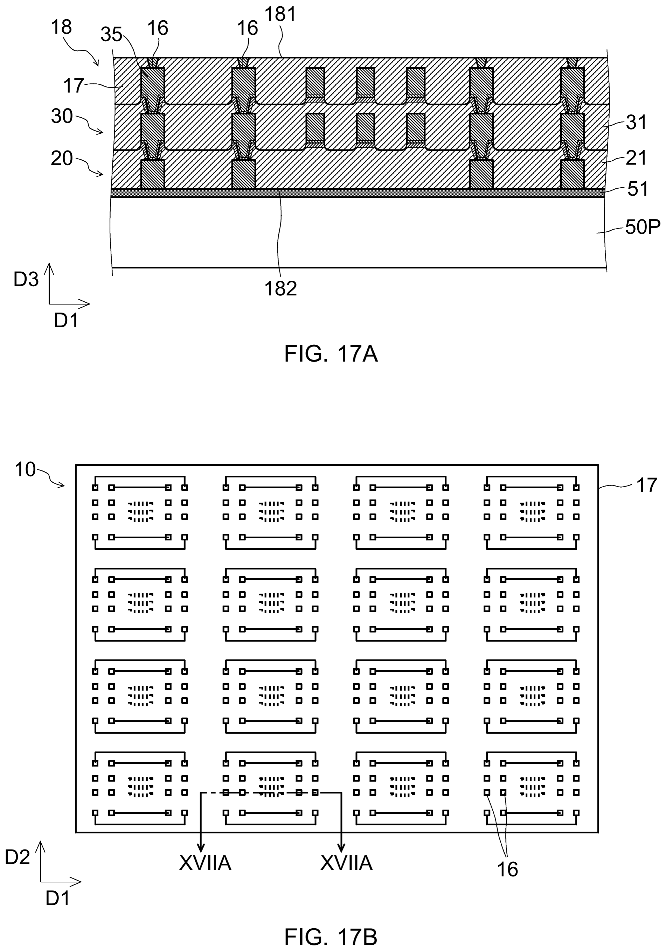

Subsequently, as shown in Fig. 17A, the surface layer 17 may be formed on the second wiring layer 30. The connecting portions 16 may also be formed. Fig. 17B is a plan view that shows the connecting portions 16 and the surface layer 17. Fig. 17A corresponds to a cross-sectional view taken along the line XVIIA-XVIIA in Fig. 17B.

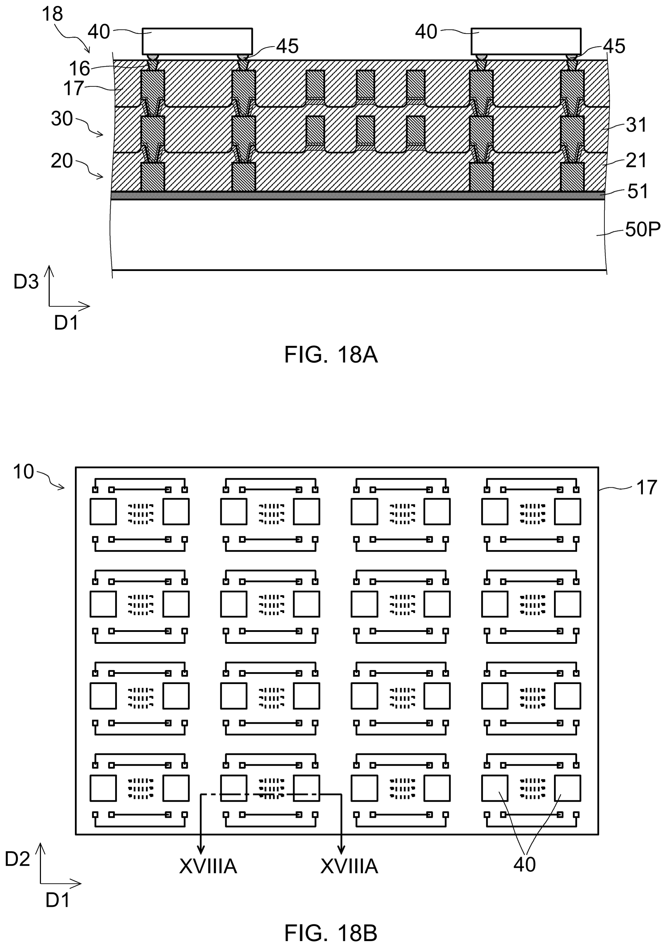

Subsequently, as shown in Fig. 18A, a step of mounting the semiconductor elements 40 on the connecting portions 16 is performed. Fig. 18B is a plan view that shows the semiconductor elements 40 mounted on the connecting portions 16. Fig. 18A corresponds to a cross-sectional view taken along the line XVIIIA-XVIIIA in Fig. 18B. The laminated body shown in Figs 18A and 18B, to which the plurality of semiconductor elements 40 is mounted, is also referred to as a semiconductor package intermediate 1.

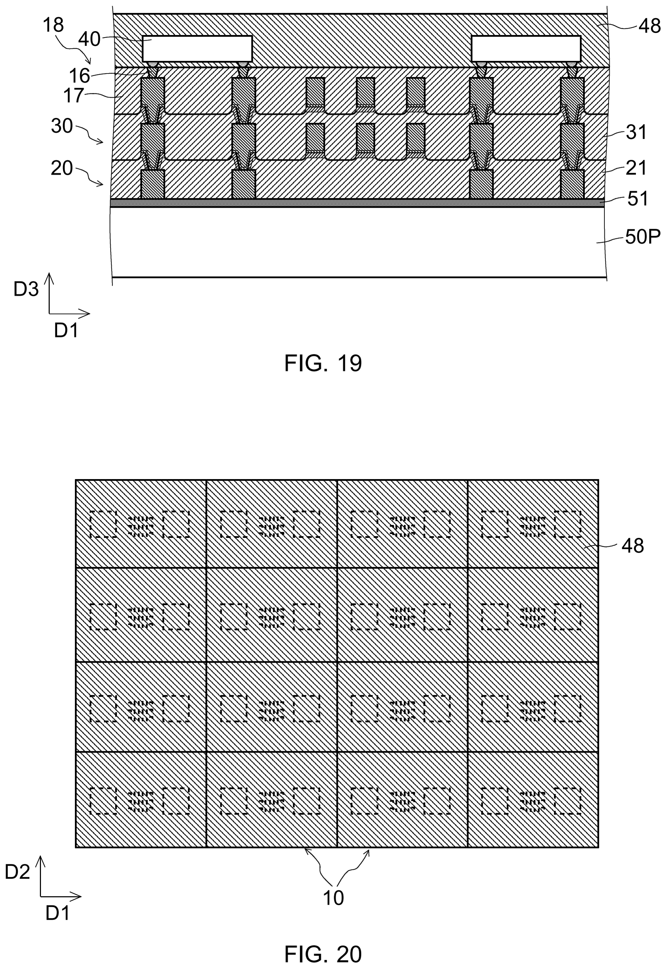

Subsequently, as shown in Fig. 19, a step of forming the molding resin layer 48 is performed. The molding resin layer 48 may be formed by compression molding. For example, first, the laminated body shown in Figs. 18A and 18B is placed in the cavity between a first mold and a second mold. Subsequently, in the cavity, liquid or granular resin is brought into contact with the laminated body. The resin is also compressed between the first mold and the second mold. The molding resin layer 48 is obtained by cooling and solidifying the resin.

Subsequently, as shown in Fig. 20, a cutting step of cutting the semiconductor package intermediate 1 is performed. In the cutting step, the semiconductor package intermediate 1 is cut along the first direction D1 and the second direction D2 according to the dimensions such as the dimensions of each individual wiring device 10. As a result, the plurality of wiring devices 10 is obtained. At this time, there are also cases where the support carrier 50 is not cut and only the laminated body is cut and the support carrier is separated using the release layer as a boundary.

In the present embodiment, the first organic layer 21 includes the first transition layers 22 that constitute the first upper surface 211 overlapping the first wires 25. The first transition layers 22 contain particles of the same metal as the metal that constitutes the lower surfaces of the first wires 25. Therefore, it is possible to enhance the adhesion between the first organic layer 21 and the first wires 25. Therefore, even when the width of the first wire 25 is small, it is possible to suppress delamination of the wires from the organic layer. For example, even when the width W11 of the first wire 25 is less than or equal to 5.0 µm, less than or equal to 3.0 µm, or less than or equal to 2.0 µm as described above, it is possible to suppress delamination of the first wires 25 from the first organic layer 21.

In the present embodiment, the first organic layer 21 includes the first recesses 23 located on the first upper surface 211 between two adjacent first wires 25. Therefore, even when the spacing between two adjacent first wires 25 is small, it is possible to suppress occurrence of leakage current between the two adjacent first wires 25. For example, even when the spacing W12 between two adjacent first wires 25 is less than or equal to 5.0 µm, less than or equal to 3.0 µm, or less than or equal to 2.0 µm, it is possible to suppress occurrence of leakage current between two adjacent first wires 25.

The above-described embodiment can be variously modified. Hereinafter, modifications will be described with reference to the drawings as needed. In the following description and the drawings used in the following description, like reference signs to the reference signs used for corresponding portions in the above-described embodiment are used for portions that can be similarly configured to those of the above-described embodiment. Repeated descriptions are omitted. When the operation and advantageous effects obtained in the above-described embodiment are also apparently obtained in the modifications, the description thereof may be omitted.

### (First Modification)

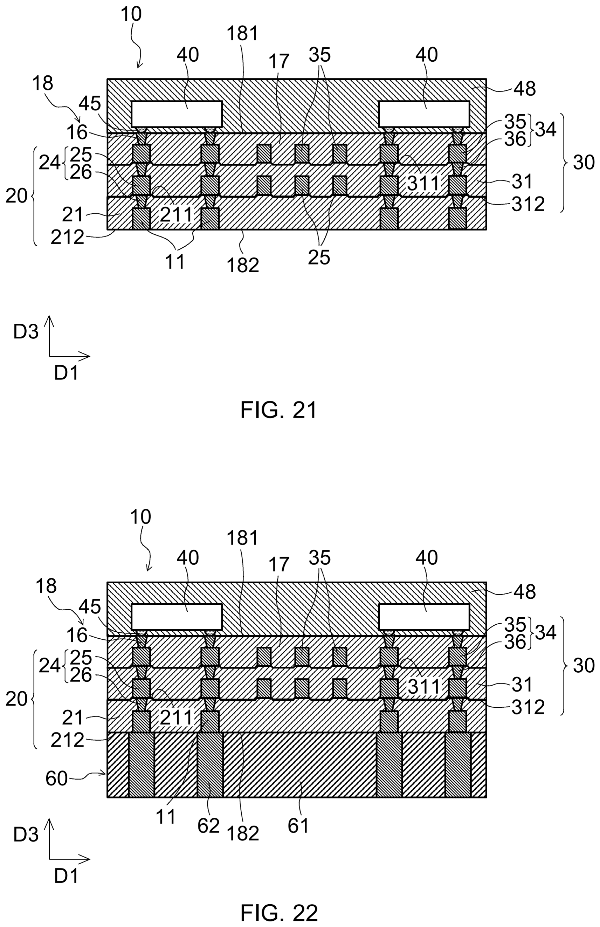

Fig. 21 is a cross-sectional view that shows the wiring device 10 in the first modification. The wiring device 10 does not need to include the support carrier 50. In other words, the wiring device 10 may be used in a state separated from the support carrier 50.

### (Second Modification)

Fig. 22 is a cross-sectional view that shows the wiring device 10 in the second modification. The wiring device 10 may include a through-via substrate 60 facing the first lower surface 212 of the first organic layer 21.

The through-via substrate 60 includes a substrate 61 facing the first lower surface 212 and through vias 62 penetrating the substrate 61 in the thickness direction. The through vias 62 may be electrically connected to the wires of the redistribution layer 18. For example, the through vias 62 may be electrically connected to the first wires 25 of the first wiring layer 20.

### (Third Modification)

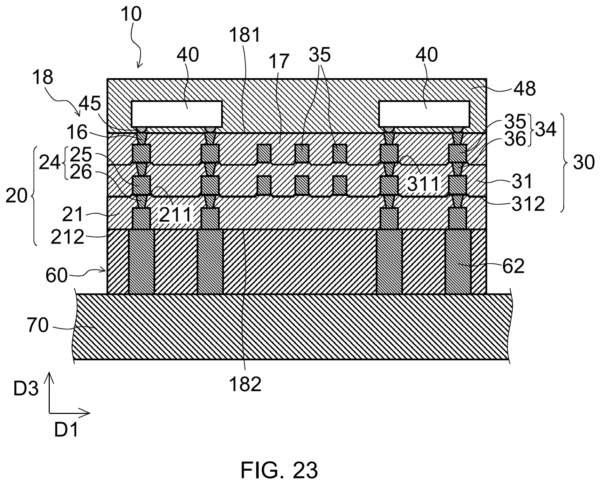

Fig. 23 is a cross-sectional view that shows the wiring device 10 in the third modification. The wiring device 10 may include a wiring substrate 70. The wiring substrate 70 may be connected to the through-via substrate 60.

The wiring substrate 70 may be a BGA substrate. BGA is an abbreviation for ball grid array. A BGA substrate is a wiring substrate that can mount ball grid array (BGA) chips. The wiring substrate 70 may be an FC-BGA substrate. FC is an abbreviation for flip chip. An FC-BGA substrate is a wiring substrate that can mount ball grid array (BGA) chips using flip chip bonding.

The redistribution layer 18 or the through-via substrate 60 may include pads or terminals arranged in a grid pattern in the first direction D1 and the second direction D2. The pads or terminals of the redistribution layer 18 or the through-via substrate 60 are connected to the wiring substrate 70 via bumps.

### (Fourth Modification)

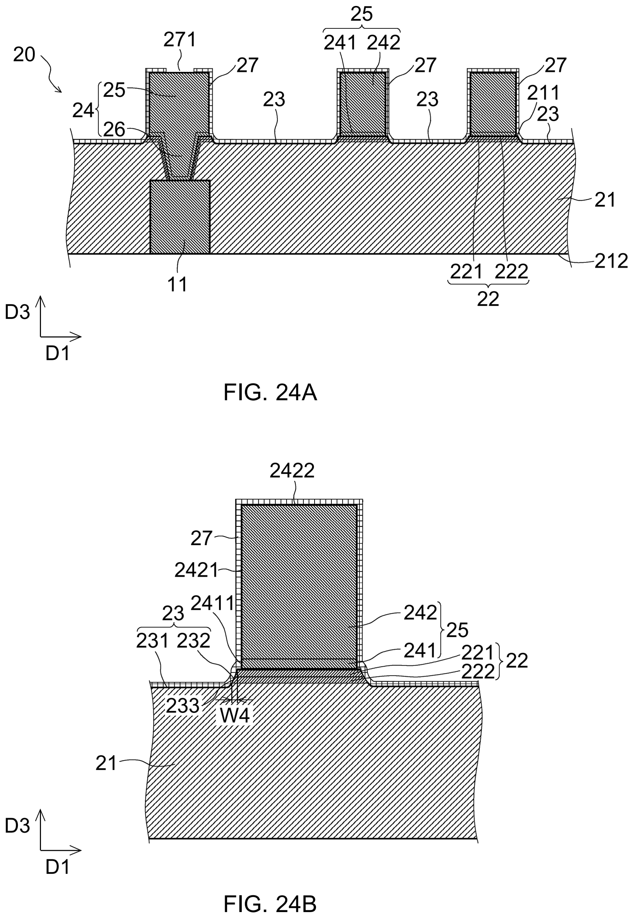

Fig. 24A is a cross-sectional view that shows the first wiring layer 20 in the fourth modification. The first wiring layer 20 may include a first inorganic layer 27 covering the first recesses 23. The first inorganic layer 27 may be in contact with the first wires 25. For example, the first inorganic layer 27 may cover the side surfaces of the first wires 25. The first inorganic layer 27 may at least partially cover the upper surfaces of the first wires 25. The first inorganic layer 27 can suppress occurrence of migration in the first wires 25.

In a step of forming the first recesses 23 by dry etching, part of the side surfaces of the first wires 25 may also be etched. The first inorganic layer 27 can fill the recesses formed by etching on the side surfaces of the first wires 25. Thus, it is possible to enhance the mechanical strength of the first wires 25.

The first inorganic layer 27 includes an inorganic insulating material. Examples of the inorganic insulating material include silicon nitride and silicon oxide. The first inorganic layer 27 may include a silicon nitride layer and a silicon oxide layer.

Fig. 24B is a cross-sectional view that shows an example of the first wire 25 and the first transition layer 22. The first inorganic layer 27 may be in contact with the exposed side surface 223 of the first transition layer 22. The first inorganic layer 27 can suppress diffusion of metal particles contained in the first transition layer 22 from the exposed side surface 223 into the above-described second organic layer 31.

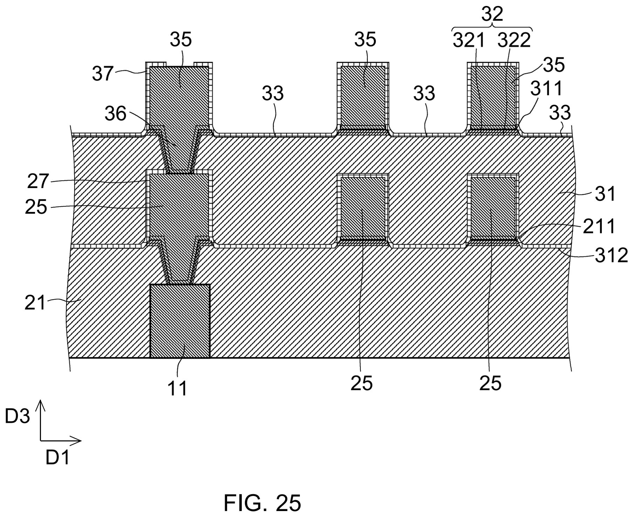

Fig. 25 is a cross-sectional view that shows the second wiring layer 30 in the fourth modification. Like the first wiring layer 20, the second wiring layer 30 may also include a second inorganic layer 37 covering the second recesses 33. The second inorganic layer 37 may be in contact with the second wires 35. For example, the second inorganic layer 37 may cover the side surfaces of the second wires 35. The second inorganic layer 37 may at least partially cover the upper surfaces of the second wires 35. The second inorganic layer 37 includes an inorganic insulating material, similarly to the first inorganic layer 27.

### (Fifth Modification)

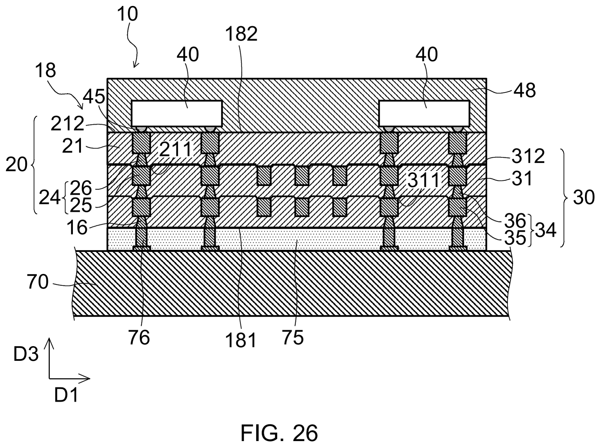

Fig. 26 is a cross-sectional view that shows the first wiring layer 20 in the fifth modification. The wiring device 10 may include the wiring substrate 70 facing the upper surface 181 of the redistribution layer 18. In the fifth modification, after the wiring device 10 including the redistribution layer 18 is separated from the support carrier 50, the redistribution layer 18 is inverted upside down, and then the redistribution layer 18 is mounted onto the wiring substrate 70.

As shown in Fig. 26, the wiring device 10 may include a bonding layer 75 located between the upper surface 181 of the redistribution layer 18 and the wiring substrate 70. The wiring device 10 may include connecting members 76 that electrically connect the redistribution layer 18 and the wiring substrate 70. The connecting members 76 may be embedded within the bonding layer 75.

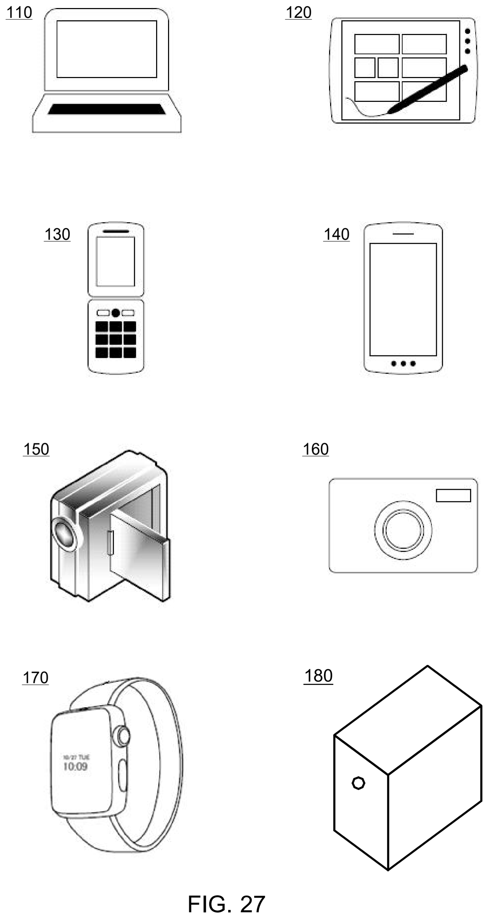

Fig. 27 is a diagram that shows examples of a product to which the wiring device 10 is mounted. The wiring device 10 can be used in various products. The wiring device 10 is mounted to, for example, a notebook personal computer 110, a tablet terminal 120, a mobile phone 130, a smartphone 140, a digital video camera 150, a digital camera 160, a digital clock 170, a server 180, or the like.

### (Sixth Modification)

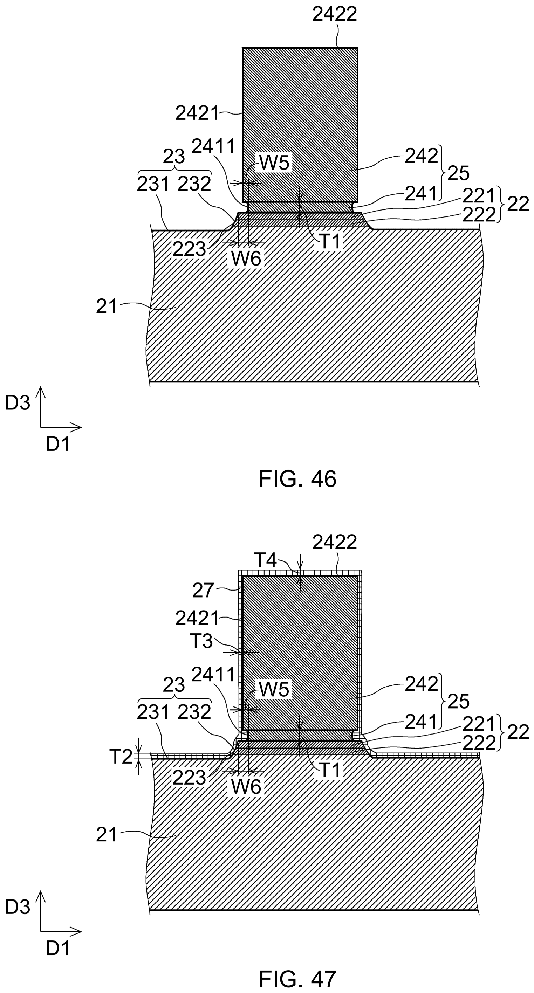

Fig. 46 is a cross-sectional view that shows an example of the first wire 25 and the first transition layer 22 according to the sixth modification. The side surface 2411 of the seed layer 241 of the first wire 25 may be located inside the side surface 2421 of the body layer 242 in the cross-sectional view. In other words, the side surface 2411 of the seed layer 241 may be recessed relative to the side surface 2421 of the body layer 242.

The recess on the side surface 2411 of the seed layer 241 is caused by, for example, side etching of the side surface 2411 of the seed layer 241, which, for example, occurs in the above-described step shown in Figs. 14A and 14B. In the step shown in Figs. 14A and 14B, portions of the seed layer 241 that do not overlap the first wires 25 are removed, for example, by wet etching.

As the wet etching time extends, portions of the seed layer 241 that do not overlap the first wires 25 are more reliably removed. If portions of the seed layer 241 that do not overlap the first wires 25 remain, the subsequent step of forming the first recesses 23, which is performed thereafter, is hindered. For example, the first recesses 23 are less likely to be formed in the portions of the first organic layer 21 where the seed layer 241 remains. By extending the wet etching time, the remaining of the seed layer 241 on the first organic layer 21 is suppressed.

On the other hand, as the wet etching time extends, side etching that occurs in the portions of the seed layer 241 that overlap the first wires 25 increases. Reference sign W5 represents the distance in the plane direction of the wiring device 10 between the lower end of the side surface 2421 of the body layer 242 and the side surface 2411 of the seed layer 241. When the material of the seed layer 241 is different from the material of the body layer 242, the distance W5 increases as the wet etching time extends. To suppress delamination of the body layer 242 from the seed layer 241, the distance W5 is preferably not excessively long relative to the width W11 of the first wire 25.

Therefore, W5/W11 that is the ratio of the distance W5 to the width W11 is, for example, greater than or equal to 1/40, may be greater than or equal to 1/30, and may be greater than or equal to 1/25. W5/W11 is, for example, less than or equal to 1/6, may be less than or equal to 1/5, and may be less than or equal to 1/4.

The distance W5 may be defined relatively to the thickness T1 of the seed layer 241. W5/T1 that is the ratio of the distance W5 to the thickness T1 is, for example, greater than or equal to 0.05, may be greater than or equal to 0.10, and may be greater than or equal to 0.50. W5/T1 is, for example, less than or equal to 5.0, may be less than or equal to 3.0, and may be less than or equal to 1.0.

As shown in Fig. 46, the side surface 2411 of the seed layer 241 of the first wire 25 may be located inside the first side surface 232 of the first recess 23 in the cross-sectional view. In other words, the side surface 2411 of the seed layer 241 may be recessed relative to the first side surface 232 of the first recess 23.

In the above-described step shown in Fig. 15, the first recesses 23 are likely to be formed in portions of the first organic layer 21 that do not overlap the first wires 25. When the seed layer 241 is side-etched, the first side surface 232 of the first recess 23 is located outside the side surface 2411 of the seed layer 241. The term "outside" refers to a direction away from the center of the first wire 25 in the plane direction of the wiring device 10 in the cross-sectional view taken in a direction orthogonal to the direction in which the first wire 25 extends.

Reference sign W6 represents the distance in the plane direction of the wiring device 10 between the upper end of the first side surface 232 of the first recess 23 and the side surface 2411 of the seed layer 241. The distance W6 may match the distance W5 or may be greater than the distance W5. When the distance W6 is greater than the distance W5, the difference between the distance W6 and the distance W5 is, for example, greater than or equal to 0.01 µm, may be greater than or equal to 0.02 µm, and may be greater than or equal to 0.05 µm. When the distance W6 is greater than the distance W5, the difference between the distance W6 and the distance W5 is, for example, less than or equal to 3.00 µm, may be less than or equal to 2.00 µm, and may be less than or equal to 1.00 µm.

The distance W6 may be defined relatively to the thickness T1 of the seed layer 241. W6/T1 that is the ratio of the distance W6 to the thickness T1 is, for example, greater than or equal to 0.05, may be greater than or equal to 0.10, and may be greater than or equal to 0.50. W6/T1 is, for example, less than or equal to 5.0, may be less than or equal to 4.0, and may be less than or equal to 3.0.

Fig. 47 is a cross-sectional view that shows an example of the first wire and the first transition layer. As shown in Fig. 47, when the side surface 2411 of the seed layer 241 is located inside the side surface 2421 of the body layer 242, the first inorganic layer 27 covering the first recess 23 and the first wire 25 may be formed. The first inorganic layer 27 may be in contact with the side surface 2411 of the seed layer 241.

When the side surface 2411 of the seed layer 241 is located inside the side surface 2421 of the body layer 242 and the first side surface 232 of the first recess 23, a space recessed inward is formed between the lower surface of the body layer 242 and the upper surface of the first transition layer 22 of the first organic layer 21. In order for the first inorganic layer 27 to be in contact with the side surface 2411 of the seed layer 241, the material of the first inorganic layer 27 needs to be filled into the space recessed inward in the step of forming the first inorganic layer 27. In this modification, since the first recess 23 is formed in the first organic layer 21, the material of the first inorganic layer 27 is likely to be filled into the space recessed inward. As a result, it is possible to stably manufacture the wiring device 10 including the first inorganic layer 27 that is in contact with the side surface 2411 of the seed layer 241.

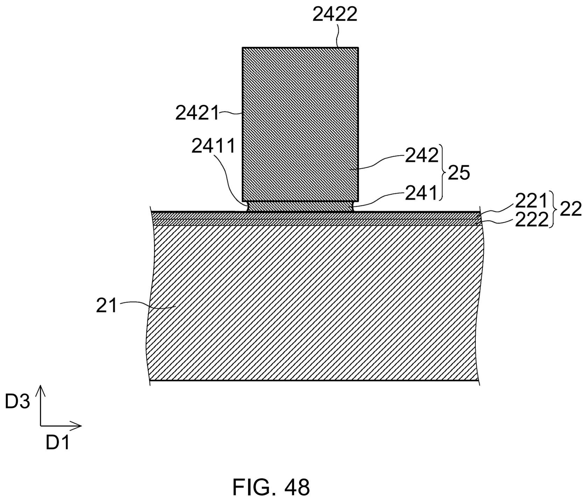

One example of the advantageous effects of this modification will be described based on a comparison with a comparative embodiment. Fig. 48 is a cross-sectional view that shows an example of the first wire 25 and the first transition layer 22 in the first comparative embodiment. The first wire 25 and the first transition layer 22 shown in Fig. 48 are the same as the first wire 25 and the first transition layer 22 shown in Fig. 46 except that the first recess 23 is not formed in the first organic layer 21.

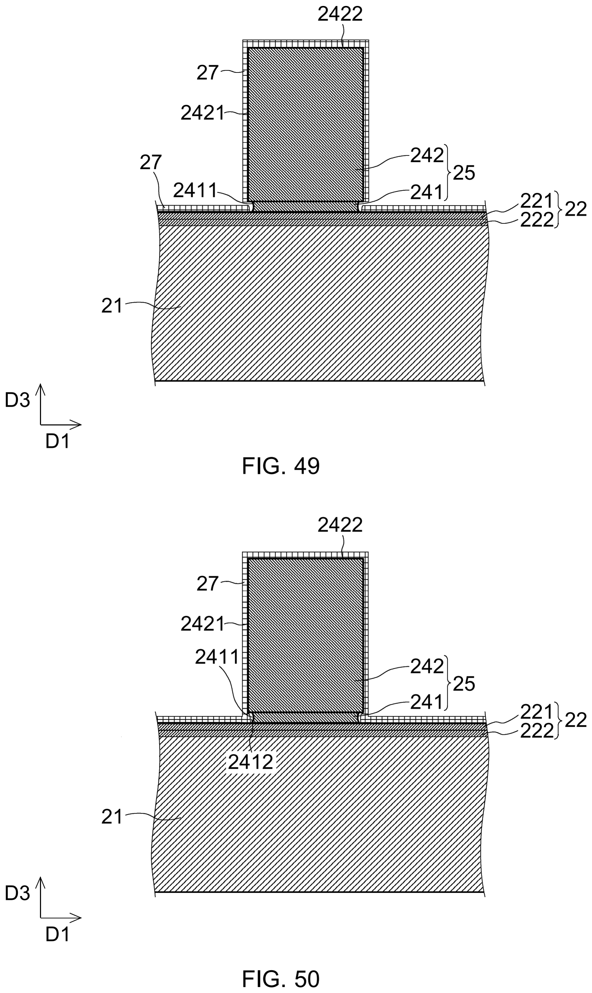

Figs. 49 and 50 show cross-sectional views of an example of the step of forming the first inorganic layer 27 on the first wire 25 shown in Fig. 48. The first inorganic layer 27 is formed on the surface of the first wire 25 and the surface of the first organic layer 21 by a vapor deposition method, such as CVD, ALD, and PVD.

In the step of forming the first inorganic layer 27, the deposition rate of the first inorganic layer 27 in the thickness direction of the wiring device 10 is higher than the deposition rate of the first inorganic layer 27 in the plane direction of the wiring device 10. As shown in Fig. 49, the first inorganic layer 27 grows faster in the third direction D3 than in the first direction D1.

When the side surface 2411 of the seed layer 241 is located inside the side surface 2421 of the body layer 242 and the first side surface 232 of the first recess 23, it is difficult for the first inorganic layer 27 to be formed on the side surface 2411 in the early stage of the step of forming the first inorganic layer 27. In the first comparative embodiment, when the first inorganic layer 27 formed on the first transition layer 22 of the first organic layer 21 grows in the first direction D1, the first inorganic layer 27 can come into contact with the side surface 2411. However, when the first inorganic layer 27 grows faster in the third direction D3, it is conceivable that the first inorganic layer 27 on the first transition layer 22 connects to the first inorganic layer 27 on the side surface 2421 of the body layer 242 before the first inorganic layer 27 grows to reach the side surface 2411 as shown in Fig. 50. When the connection of the first inorganic layer 27 occurs, the growth of the first inorganic layer 27 in the first direction D1 toward the side surface 2411 of the seed layer 241 is stopped. As a result, as shown in Fig. 50, a gap 2412 not filled with the first inorganic layer 27 may occur between the first inorganic layer 27 and the side surface 2411 of the seed layer 241. The gap 2412, for example, causes defects, such as cracks, in the first inorganic layer 27. The gap 2412, for example, causes defects, such as delamination and cracks, in the first wire 25. When defects, such as cracks, occur in the first inorganic layer 27, it may not be possible to sufficiently obtain the advantageous effect of suppressing migration between two adjacent first wires 25.

In this modification, as shown in Fig. 46, the first recess 23 is formed in the first organic layer 21. Therefore, before the first inorganic layer 27 on the first organic layer 21 is connected to the first inorganic layer 27 on the side surface 2421 of the body layer 242, the first inorganic layer 27 can be formed in contact with the side surface 2411 of the seed layer 241. According to this modification, occurrence of a gap between the first inorganic layer 27 and the side surface 2411 of the seed layer 241 is suppressed. As a result, occurrence of defects in the first inorganic layer 27 and the first wire 25 is suppressed.

In Fig. 47, reference sign T2 represents the thickness of the first inorganic layer 27 located on the first bottom surface 231 of the first recess 23. Reference sign T3 represents the thickness of the first inorganic layer 27 located on the side surface 2421 of the body layer 242. Reference sign T4 represents the thickness of the first inorganic layer 27 located on the upper surface 2422 of the body layer 242.

The thickness T2 may be greater than the thickness T3. When the first inorganic layer 27 grows faster in the third direction D3 than in the first direction D1, the thickness T2 is greater than the thickness T3. The thickness T2 is measured at the center of the first bottom surface 231 of the first recess 23 in the first direction D1. The thickness T3 is measured at the center of the body layer 242 in the third direction D3.

T2/T3 that is the ratio of thickness T2 to thickness T3 is, for example, greater than or equal to 1.10, may be greater than or equal to 1.30, and may be greater than or equal to 1.50. T2/T3 is, for example, less than or equal to 3.00, may be less than or equal to 2.50, and may be less than or equal to 2.00.

The thickness T4 may be greater than the thickness T3. When the first inorganic layer 27 grows faster in the third direction D3 than in the first direction D1, the thickness T4 is greater than the thickness T3. The thickness T4 is measured at the center of the upper surface 2422 of the body layer 242 in the first direction D1. The numeric range of T2/T3 can be adopted as the numeric range of T4/T3 that is the ratio of the thickness T4 to the thickness T3.

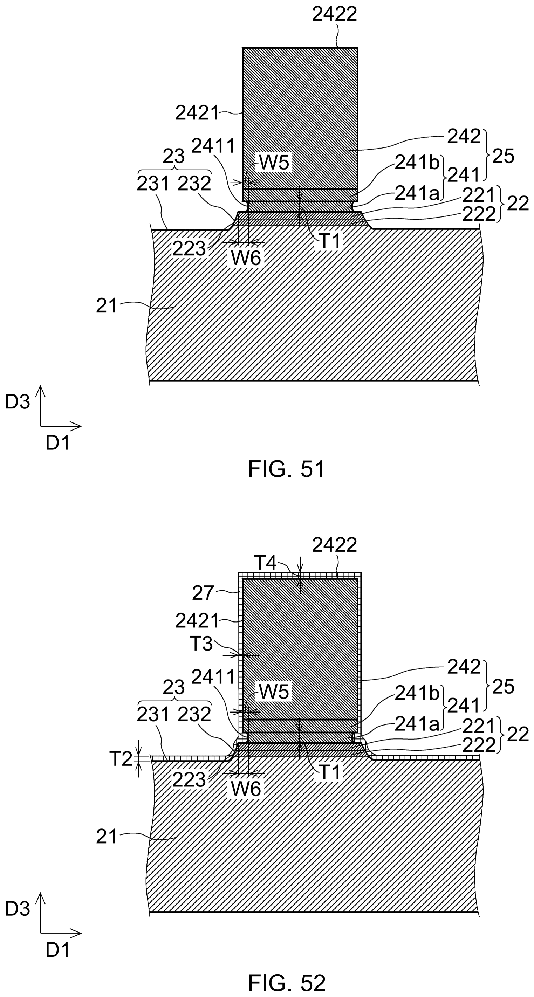

Fig. 51 is a cross-sectional view that shows an example of the first wire 25 and the first transition layer 22 according to this modification. The seed layer 241 may include a plurality of layers. For example, the seed layer 241 may include a first seed layer 241a and a second seed layer 241b located on the first seed layer 241a.

The first seed layer 241a may include a material different from the material of the body layer 242. The second seed layer 241b may include the same material as the material of the body layer 242. For example, the first seed layer 241a may include nickel, titanium, chromium, or zinc, or an alloy of these metals, and the second seed layer 241b and the body layer 242 may include copper or a copper alloy.

The above-described step of partially removing the seed layer 241, shown in Figs. 14A and 14B, may include a step of partially removing the second seed layer 241b and a step of partially removing the first seed layer 241a. In the step of partially removing the first seed layer 241a, side etching of the first seed layer 241a progresses faster than side etching of the second seed layer 241b. As a result, as shown in Fig. 51, the side surface of the first seed layer 241a is located inside the side surface of the second seed layer 241b in the cross-sectional view. In other words, in the example shown in Fig. 51, the side surface 2411 of the seed layer 241, which is located inside the side surface 2421 of the body layer 242, is formed of the side surface of the first seed layer 241a.

In the example shown in Fig. 51, the thickness T1 is the thickness of the first seed layer 241a. In the example shown in Fig. 51, the distance W5 is the distance in the plane direction of the wiring device 10 between the lower end of the side surface of the second seed layer 241b and the side surface of the first seed layer 241a.

Fig. 52 is a cross-sectional view that shows an example of the first wire and the first transition layer. As shown in Fig. 52, when the side surface of the first seed layer 241a is located inside the side surface of the second seed layer 241b, the first inorganic layer 27 covering the first recess 23 and the first wire 25 may be formed.

The distances W5 and W6 and the thicknesses T1 to T4 are calculated based on the cross-sectional image of the wiring device 10, taken with a scanning electron microscope.

### (Seventh Modification)

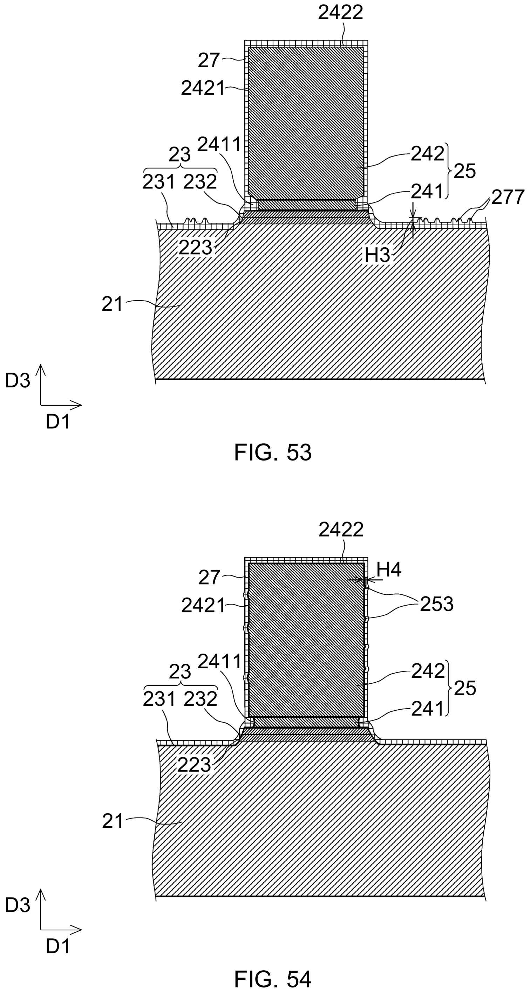

Fig. 53 is a cross-sectional view that shows an example of the first wire 25 and the first transition layer 22 according to the seventh modification. The surface of the first inorganic layer 27 located on the first bottom surface 231 of the first recess 23 may have roughness. For example, the surface of the first inorganic layer 27 located on the first bottom surface 231 of the first recess 23 may include a plurality of protrusions 277. The plurality of protrusions 277 increases the surface area of the first inorganic layer 27. With an increase in the surface area of the first inorganic layer 27, the contact area between the first inorganic layer 27 and the above-described second organic layer 31 increases. Therefore, delamination of the second organic layer 31 from the first inorganic layer 27 is suppressed.

In Fig. 53, reference sign H3 represents the height of the protrusions 277. The height of the protrusions 277 is the distance in the third direction D3 between the lowest part and the highest part of the first inorganic layer 27 located on the first bottom surface 231. The statement "the first inorganic layer 27 has roughness" means that the height H3 of the protrusions 277 of the first inorganic layer 27 is greater than the height of protrusions of a reference plane. The reference plane is the lower surface of the first wire 25 that is in contact with the upper surface of the first organic layer 21.

The height H3 of the protrusions 277 of the first inorganic layer 27 and the height of the protrusions of the reference plane are calculated based on the cross-sectional image of the wiring device 10, taken with a scanning electron microscope. The cross-sectional image contains two first wires 25 and a first recess 23 located between the two first wires 25. The interfaces between the lower surfaces of the two first wires 25 and the first organic layer 21 also appear in the cross-sectional image.

The height H3 is, for example, greater than or equal to 0.05 µm, may be greater than or equal to 0.10 µm, and may be greater than or equal to 0.15 µm. The height H3 is, for example, less than or equal to 0.40 µm, may be less than or equal to 0.35 µm, and may be less than or equal to 0.30 µm.

### (Eighth Modification)

Fig. 54 is a cross-sectional view that shows an example of the first wire 25 and the first transition layer 22 according to the eighth modification. The side surface of the first wire 25, such as the side surface 2411 and the side surface 2421, may have roughness. For example, the side surface of the first wire 25 may include a plurality of protrusions 253. The plurality of protrusions 253 increases the surface area of the side surface of the first wire 25. By increasing the surface area of the side surface of the first wire 25, the contact area between the side surface of the first wire 25 and the first inorganic layer 27 increases. Therefore, delamination of the first inorganic layer 27 from the first wire 25 is suppressed.

In Fig. 54, reference sign H4 represents the height of the protrusions 253. The height of the protrusions 253 is measured in a direction orthogonal to the direction in which the side surface of the first wire 25 extends. The statement "the side surface of the first wire 25 has roughness" means that the height H4 of the protrusions 253 of the side surface of the first wire 25 is greater than the height of protrusions of the reference plane. The reference plane is the lower surface of the first wire 25 that is in contact with the upper surface of the first organic layer 21, similarly to the seventh modification.

The height H4 of the protrusions 253 of the side surface of the first wire 25 and the height of the protrusions of the reference plane are calculated based on the cross-sectional image of the wiring device 10, taken with a scanning electron microscope. The cross-sectional image contains one first wire 25. The interface between the lower surface of one first wire 25 and the first organic layer 21 also appears in the cross-sectional image. The height of the highest protrusion 253 among the plurality of protrusions 253 appearing in the cross-sectional image is adopted as the height H4.

As shown in Fig. 54, the surface of the first inorganic layer 27 may have roughness corresponding to the roughness of the side surface of the first wire 25. As the roughness of the first inorganic layer 27 increases, the surface area of the first inorganic layer 27 increases. With an increase in the surface area of the first inorganic layer 27 on the side surface of the first wire 25, the contact area between the first inorganic layer 27 and the above-described second organic layer 31 increases. Therefore, delamination of the second organic layer 31 from the first inorganic layer 27 is suppressed.

### (Ninth Modification)

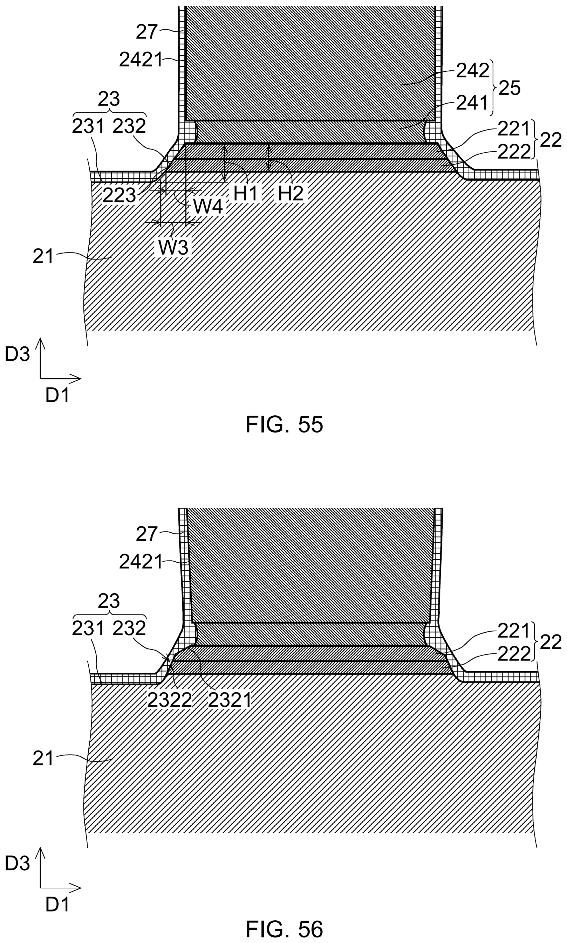

Fig. 55 is a cross-sectional view that shows an example of the first wire 25 and the first transition layer according to the ninth modification. The first side surface 232 of the first recess 23 may include a portion that is inclined so as to displace outward from the upper surface of the first transition layer 22 toward the first bottom surface 231. The inclined portion is also referred to as an inclined surface.

Since the first side surface 232 includes an inclined surface, a material that constitutes the first inorganic layer 27 is more easily filled into a space below the lower surface of the body layer 242 in the step of forming the first inorganic layer 27. As a result, it is possible to stably manufacture the wiring device 10 including the first inorganic layer 27 that is in contact with the side surface 2411 of the seed layer 241.

The inclination angle of the inclined surface of the first side surface 232 may be represented by W3/H1 or W4/H2. W3/H1 is the ratio of the width W3 of the first side surface 232 to the depth H1 of the first recess 23. W4/H2 is the ratio of the width W4 of the exposed side surface 223 of the first transition layer 22 to the thickness H2 of the first transition layer 22.

W3/H1 is, for example, greater than or equal to 0.01, may be greater than or equal to 0.05, and may be greater than or equal to 0.10. W3/H1 is, for example, less than or equal to 1.00, may be less than or equal to 0.70, and may be less than or equal to 0.50. The numeric range of W4/H2 may be the same as the numeric range of W4/H2.

W4/H2 may be greater than W3/H1. For example, as shown in Fig. 56, the first side surface 232 of the first recess 23 may include a first inclined surface 2321 and a second inclined surface 2322 located between the first inclined surface 2321 and the first bottom surface 231. The inclination angle of the first inclined surface 2321 may be larger than the inclination angle of the second inclined surface 2322. The inclination angle is the angle formed by the inclined surface relative to the third direction D3.

The inclination angle of the inclined surface of the first side surface 232 of the first recess 23 may decrease from the upper surface of the first transition layer 22 toward the first bottom surface 231.

### (Tenth Modification)

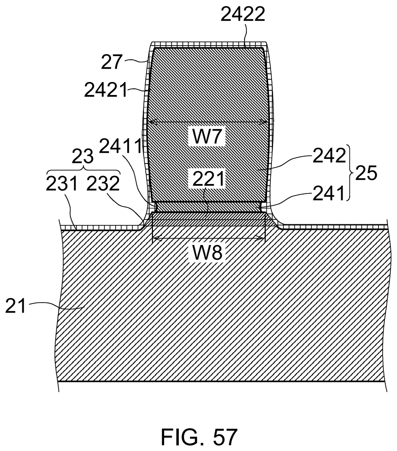

Fig. 57 is a cross-sectional view that shows an example of the first wire 25 and the first transition layer according to the tenth modification. Reference sign W7 represents the maximum value of the width of the first wire 25. Reference sign W8 represents the width of the upper surface of the upper transition layer 221 of the first organic layer 21 located below the first wire 25 between two adjacent first recesses 23 in plan view. As shown in Fig. 57, the width W8 of the upper surface of the upper transition layer 221 may be less than or equal to the maximum value W7 of the width of the first wire 25.

The portion of the first wire 25 having the maximum value W7 is preferably located above the lower surface of the body layer 242. In this case, the side surface 2421 of the body layer 242 of the first wire 25 includes an inclined surface that displaces inward from the portion of the first wire 25 having the maximum value W7 toward the lower surface of the body layer 242. Since the side surface 2421 of the body layer 242 includes an inclined surface, the material that constitutes the first inorganic layer 27 is more easily filled into the space below the lower surface of the body layer 242 in the step of forming the first inorganic layer 27. As a result, it is possible to stably manufacture the wiring device 10 including the first inorganic layer 27 that is in contact with the side surface 2411 of the seed layer 241.

W8/W7 that is the ratio of the width W8 of the upper surface of the upper transition layer 221 to the maximum value W7 of the width of the first wire 25 is, for example, less than or equal to 1.00, may be less than or equal to 0.90, and may be less than or equal to 0.80. W8/W7 is, for example, greater than or equal to 0.50, may be greater than or equal to 0.60, and may be greater than or equal to 0.70. The maximum value W7 and the width W8 are calculated based on the cross-sectional image of the wiring device 10, taken with a scanning electron microscope.

### (Eleventh Modification)

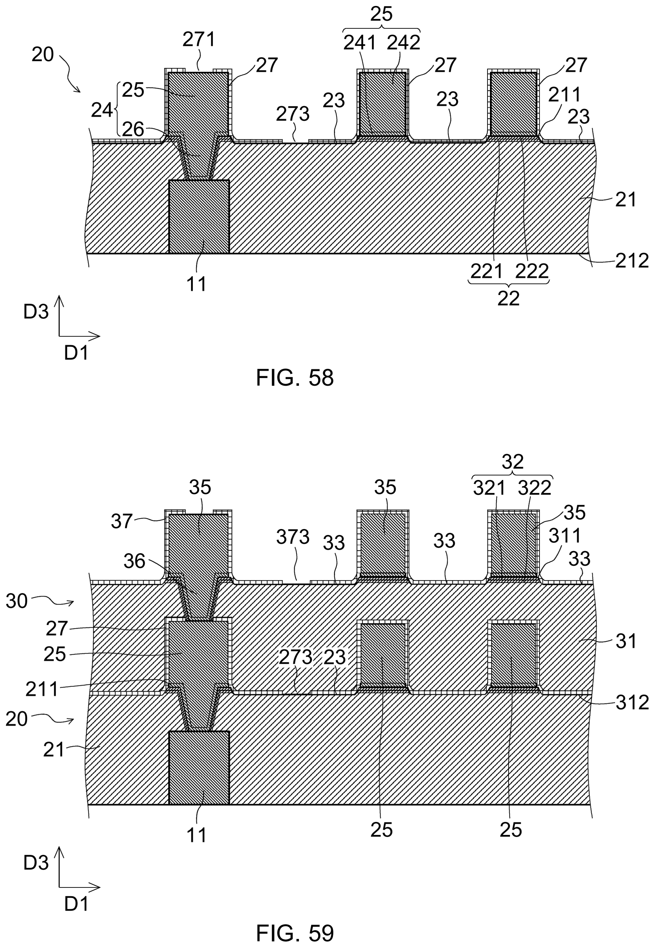

Fig. 58 is a cross-sectional view that shows an example of the first wiring layer 20 according to the eleventh modification. The first wiring layer 20 according to this modification includes the first inorganic layer 27, similarly to the first wiring layer 20 shown in Fig. 24A. The first inorganic layer 27 can suppress occurrence of migration in the first wire 25.

The first inorganic layer 27 can also reduce warpage of the wiring device 10.

A step of forming the redistribution layer 18 may include steps performed at high temperatures, such as a heating step of heating the resin of the first organic layer 21. The coefficient of thermal expansion of the organic material of the first organic layer 21 is higher than the coefficient of thermal expansion of the other component elements of the redistribution layer 18. For example, the coefficient of thermal expansion of the organic material of the first organic layer 21 is higher than the coefficient of thermal expansion of the substrate, such as the support carrier 50. For example, the coefficient of thermal expansion of the organic material of the first organic layer 21 is higher than the coefficient of thermal expansion of the material of the first conductor 24. After the heating step, when the temperature of the component elements of the redistribution layer 18 decreases, stress presumably occurs due to the difference in the coefficient of thermal expansion between the first organic layer 21 and the other component elements. For example, it is presumable that stress occurs in the substrate, the first conductor 24, and the like.

The first inorganic layer 27 can suppress the influence of stress due to the first organic layer 21, on the component elements other than the first inorganic layer 27. As a result, for example, occurrence of warpage in the wiring device 10, the redistribution layer 18, and the like, is suppressed. For example, since occurrence of stress in the first conductor 24 is suppressed, occurrence of defects, such as deformation and damage, in the first conductor 24 is suppressed.

Incidentally, when the temperature of the first organic layer 21 increases due to the heating step, or the like, gas may be generated within the first organic layer 21. Depending on the type of organic material, gas may be generated within the first organic layer 21 due to a change in molecular structure caused by light or heat originating from a storage environment. When gas is retained, for example, at the interface between the first organic layer 21 and the first inorganic layer 27, there is a concern that the first inorganic layer 27 may delaminate from the first organic layer 21.

To solve such issues, in this modification, it is proposed that an opening penetrating the first inorganic layer 27 in the third direction D3 be formed in the first inorganic layer 27. For example, as shown in Fig. 58, the first inorganic layer 27 of the first wiring layer 20 includes at least one opening 273. The opening 273 is formed so as not to overlap the first conductors 24, such as the first wires 25, in plan view. A plurality of the openings 273 may be formed in the first inorganic layer 27. The opening 273 may overlap the first recess 23 in plan view. The opening 273 may be located inside the outer edge of the first recess 23 in plan view.

Fig. 59 is a cross-sectional view that shows an example of the first wiring layer 20 and the second wiring layer 30 according to this modification. Gas generated within the first organic layer 21 can move to the second organic layer 31 of the second wiring layer 30 through the opening 273. As a result, retention of gas at the interface between the first organic layer 21 of the first wiring layer 20 and the second organic layer 31 of the second wiring layer 30 is suppressed. By suppressing retention of gas, for example, delamination of the first inorganic layer 27 from the first organic layer 21 is suppressed.

As shown in Fig. 59, the second inorganic layer 37 of the second wiring layer 30 may include at least one opening 373. The opening 373 is formed so as not to overlap the second conductors 34, such as the second wires 35, in plan view. A plurality of the openings 373 may be formed in the second inorganic layer 37. The opening 373 may overlap the second recess 33 in plan view. The opening 373 may be located inside the outer edge of the second recess 33 in plan view.

Gas generated within the second organic layer 31 can move upward through the opening 373. Therefore, for example, delamination of the second inorganic layer 37 from the second organic layer 31 is suppressed.

The dimension L1 of the openings, such as the opening 273 and the opening 373, is set so that gas can appropriately pass through. The dimension L1 is, for example, greater than or equal to 1.0 µm, may be greater than or equal to 2.0 µm, and may be greater than or equal to 3.0 µm. The dimension L1 is, for example, less than or equal to 100 µm, may be less than or equal to 50 µm, may be less than or equal to 30 µm, and may be less than or equal to 20 µm. The dimension L1 is measured in a direction orthogonal to the direction in which the outer edge of the first recess 23 extends.

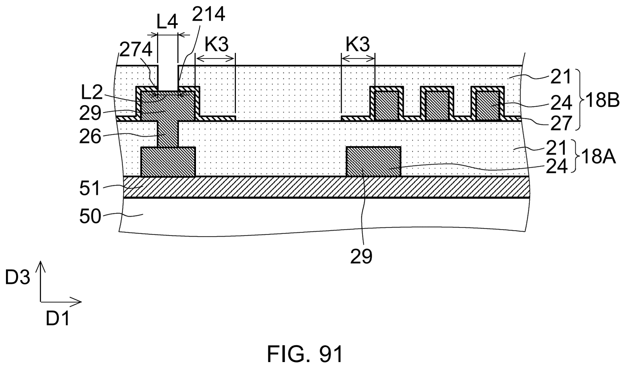

In the examples shown in Figs. 58 and 59, the advantageous effect of adjusting stress with the inorganic layers and planarizing the redistribution layer can be expected, so openings are provided in the inorganic layers as needed within the numeric range of the above-described dimension L1. However, when it is not necessary to request such advantageous effects from the inorganic layers, the inorganic layers other than the portions covering the wires may be removed to form openings. For example, the structure of an inorganic film shown in Fig. 91 (described later) may be adopted in the examples shown in Figs. 58 and 59.

Some modifications to the above-described embodiment have been described; of course, it is also possible to apply a plurality of modifications in combination as needed to the above-described embodiment.

### [Examples]

Next, the embodiment of the present disclosure will be further specifically described by way of examples. The embodiment of the present disclosure is not limited to the following examples without departing from the scope of the present disclosure.

### (Example 1)

Using the method shown in Figs. 5 to 15, the first wiring layer 20 including the first organic layer 21, the plurality of first wires 25, and the plurality of first recesses 23 was manufactured. Subsequently, the first inorganic layer 27 covering the side surfaces of the first wires 25 and the first recesses 23 was formed. Subsequently, the second organic layer 31 covering the first inorganic layer 27 was formed.

The width of the first wire 25 was 5 µm. The spacing between two adjacent first wires 25 was 5 µm. The first organic layer 21 and the second organic layer 31 were made of polyimide. Each of the first wires 25 included the seed layer 241 made of titanium and the body layer 242 made of copper. The first inorganic layer 27 was made of silicon oxide.

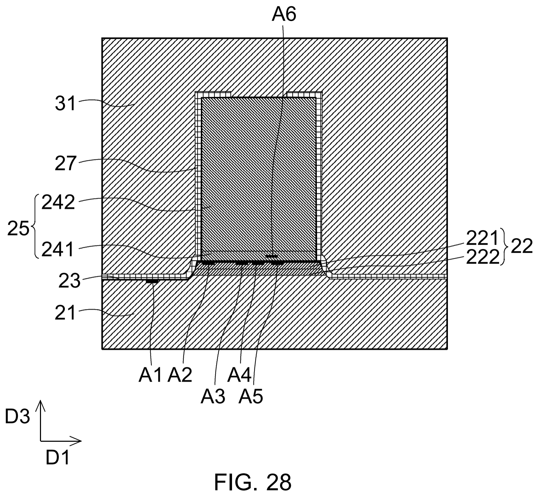

A sample including the cross section of the manufactured first wiring layer 20 was analyzed using EDX. Specifically, the cross section of the first wiring layer 20 was analyzed in a first area A1 to a sixth area A6 shown in Fig. 28. The first area A1 was the surface of the bottom surface of the first recess 23. The second area A2 was the surface of the first transition layer 22 adjacent to the side surface of the first recess 23. The third area A3 to the fifth area A5 were the surfaces of the first transition layer 22 located at the center of the first transition layer 22 in the plane direction. The sixth area A6 was located in the seed layer 241.

The apparatuses used for the analysis and the analysis conditions are as follows.
Transmission electron microscope: JEM-ARM200F manufactured by JEOL Ltd.
Acceleration voltage: 200 kV
The diameter of the primary beam: 0.1 nm
Element analyzer: JED-2300T
X-ray detector: silicon drift detector
Energy resolution: 140 eV
X-ray take-off angle: 21.9°
Solid angle: 0.98sr
Temperature: 25°C
Time: 30 seconds

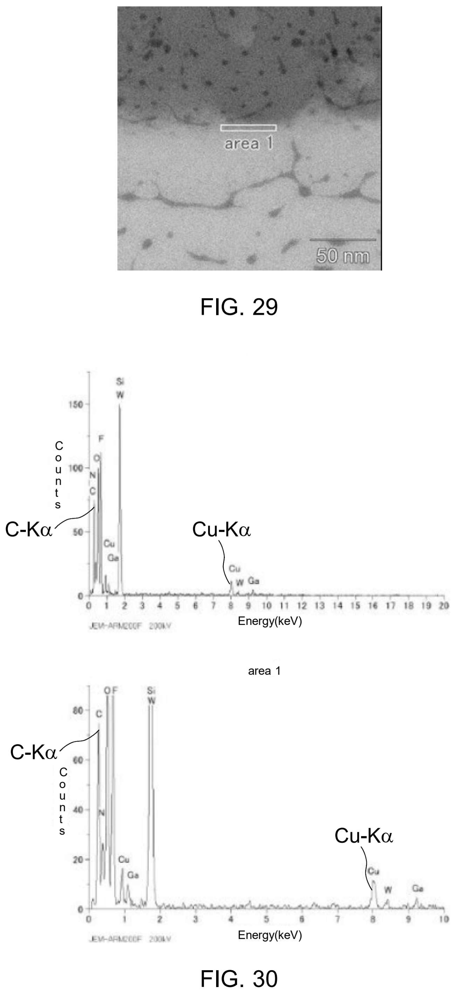

Fig. 29 is a cross-sectional image of the first area A1. Fig. 30 shows graphs that illustrate the results of EDX in the first area A1. The horizontal axes of the graphs represent the energy level of characteristic X-rays emitted from the sample. The vertical axes of the graphs represent the count of characteristic X-rays. In the first area A1, the titanium Kα line was not detected.

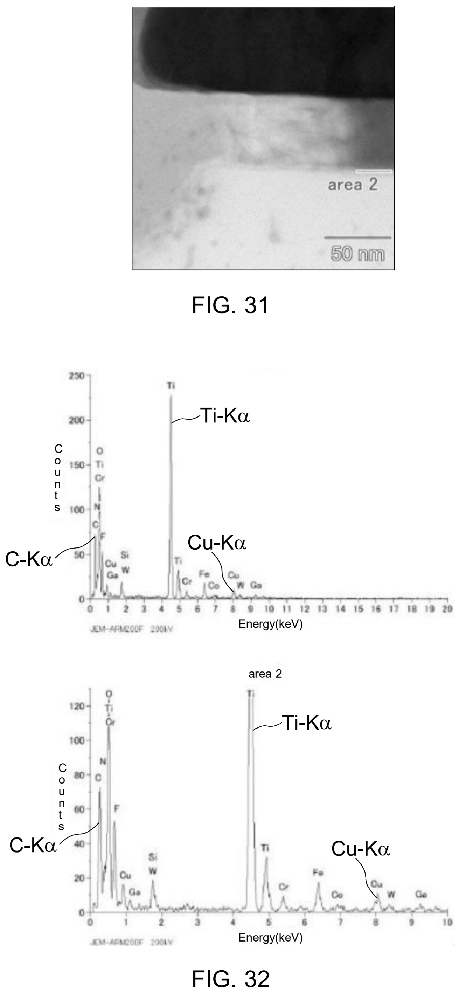

Fig. 31 is a cross-sectional image of the second area A2. Fig. 32 shows graphs that illustrate the results of EDX in the second area A2. In the second area A2, the titanium Kα line was detected. The count of the titanium Kα line was greater than the count of the carbon Kα line.

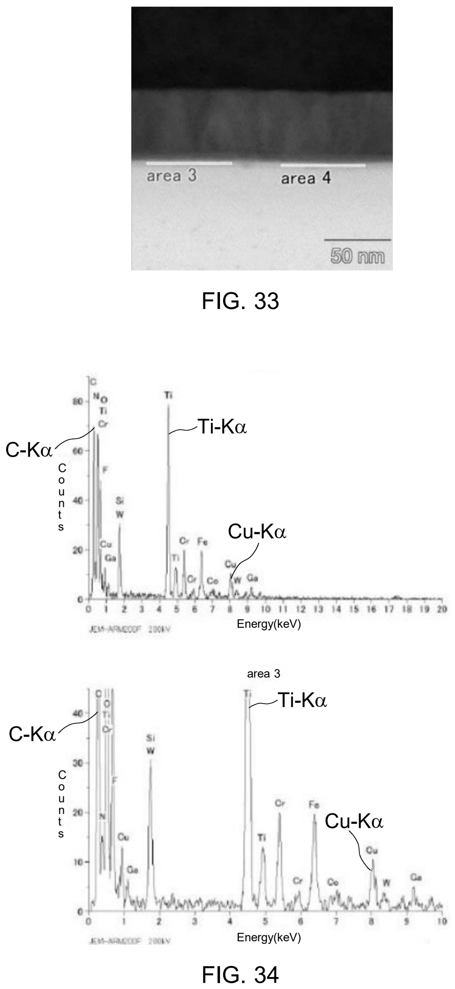

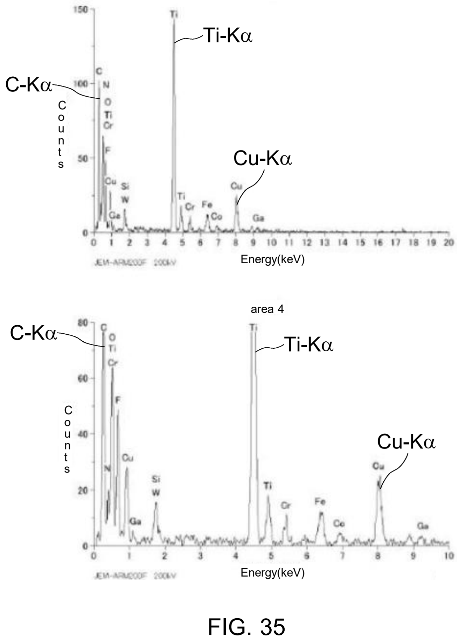

Fig. 33 is a cross-sectional image of the third area A3 and the fourth area A4. Fig. 34 shows graphs that illustrate the results of EDX in the third area A3. Fig. 35 shows graphs that illustrate the results of EDX in the fourth area A4. In the third area A3 and the fourth area A4 as well, the titanium Kα line was detected. The count of the titanium Kα line was greater than the count of the carbon Kα line.

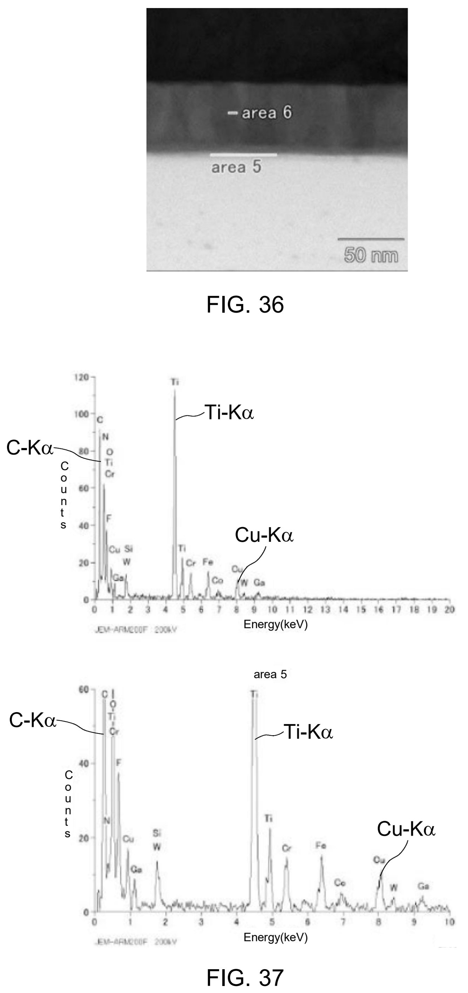

Fig. 36 is a cross-sectional image of the fifth area A5 and the sixth area A6. Fig. 37 shows graphs that illustrate the results of EDX in the fifth area A5. In the fifth area A5 as well, the titanium Kα line was detected. The count of the titanium Kα line was greater than the count of the carbon Kα line.

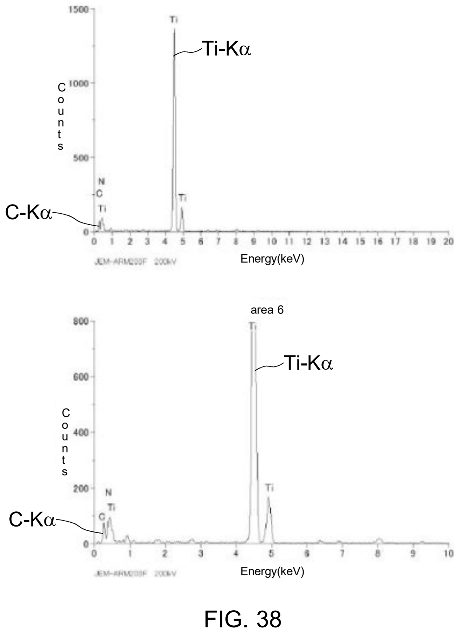

Fig. 38 shows graphs that illustrate the results of EDX in the sixth area A6. In the sixth area A6, the titanium Kα line accounted for the majority of the detected characteristic X-rays.

### (Example 2)

The first wiring layer 20 was manufactured using a method similar to that of Example 1. The width of the first wire 25 was 2 µm. The spacing between two adjacent first wires 25 was 2 µm. The remaining configuration of the first wiring layer 20 in Example 2 was the same as that in Example 1.

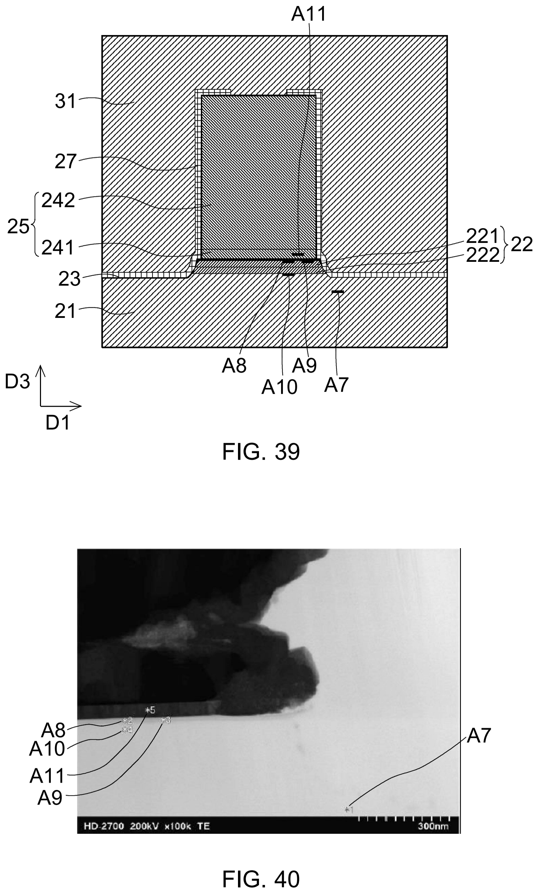

Similarly to Example 1, a sample including the cross section of the manufactured first wiring layer 20 was analyzed using EDX. Specifically, the cross section of the first wiring layer 20 was analyzed in a seventh area A7 to an eleventh area A11 shown in Fig. 39. The seventh area A7 was the surface of the bottom surface of the first recess 23. The eighth area A8 and the ninth area A9 were the surfaces of the first transition layer 22. The tenth area A10 was 100 nm away from the eighth area A8 in the thickness direction. The eleventh area A11 was located in the seed layer 241.

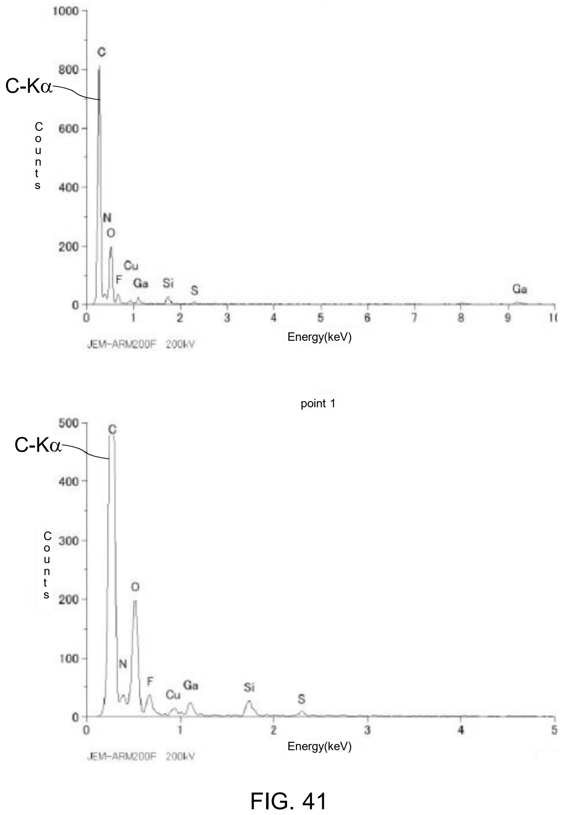

Fig. 40 is a cross-sectional image of the seventh area A7 to the eleventh area A11. Fig. 41 shows graphs that illustrate the results of EDX in the seventh area A7. In the seventh area A7, the titanium Kα line was not detected.

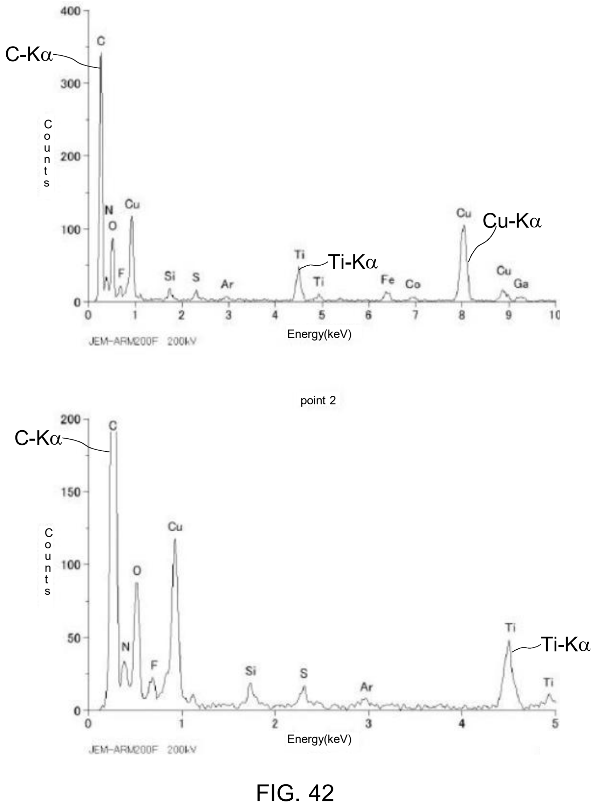

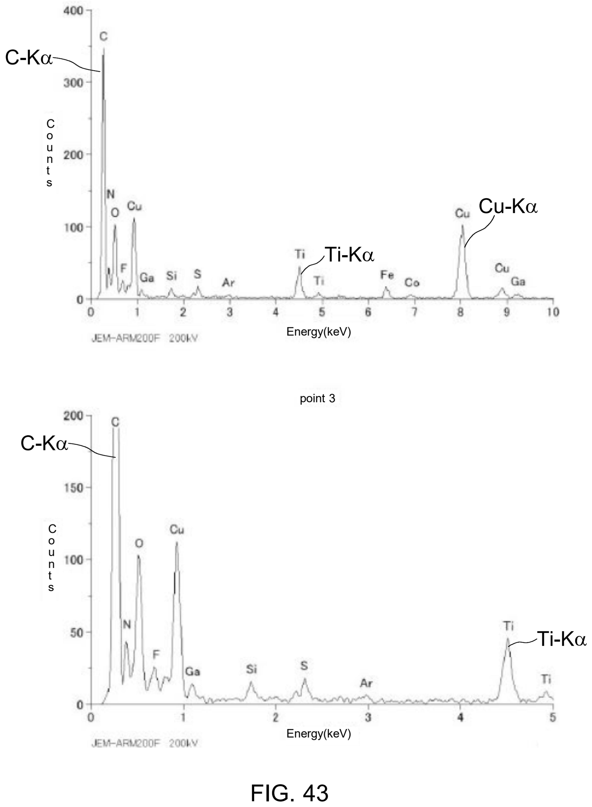

Fig. 42 shows graphs that illustrate the results of EDX in the eighth area A8. Fig. 43 shows graphs that illustrate the results of EDX in the ninth area A9. In the eighth area A8 and the ninth area A9, the titanium Kα line was detected. The ratio of the count of the titanium Kα line to the count of the carbon Kα line was approximately 0.25.

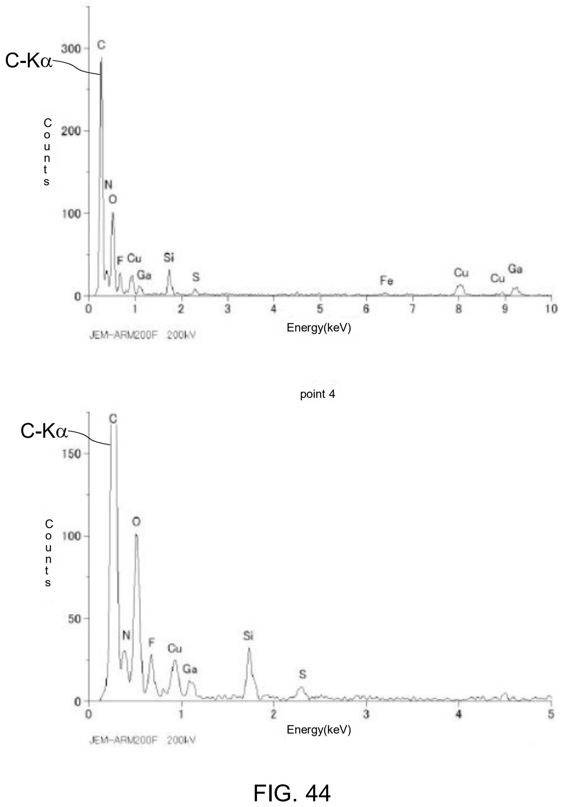

Fig. 44 shows graphs that illustrate the results of EDX in the tenth area A10. In the tenth area A10, the titanium Kα line was not detected.

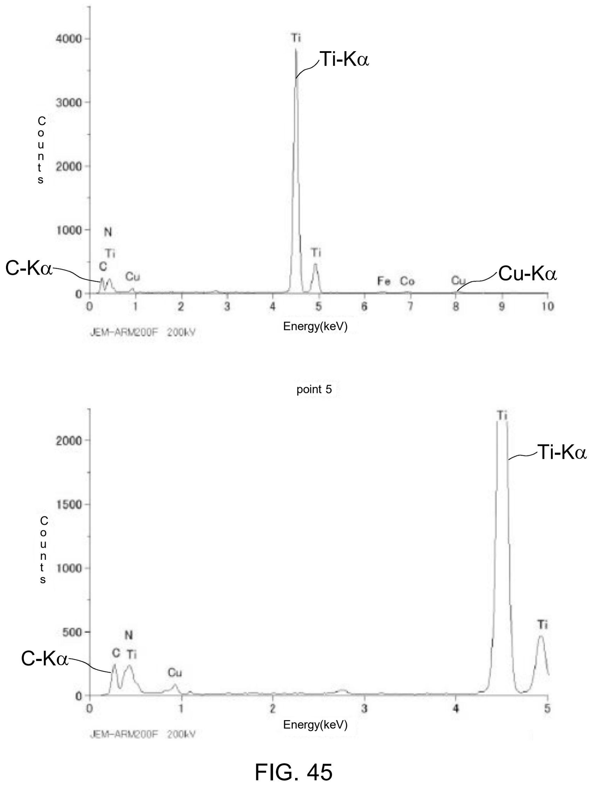

Fig. 45 shows graphs that illustrate the results of EDX in the eleventh area A11. In the eleventh area A11, the titanium Kα line accounted for the majority of the detected characteristic X-rays.

### (Second Embodiment)

The second embodiment is based on Japanese Patent Application No. 2024-047039 filed on March 22, 2024, the priority of which is claimed. The second embodiment relates to a manufacturing method for a redistribution layer and an array of wiring substrates. The names of the component elements in the specification of Japanese Patent Application No. 2024-047039 are converted in this application as shown in Table 1 below.

**[Table 1]**

| Names in JP No. 2024-047039 | Names in This Application |
|---|---|
| an array of wiring substrates | an array of wiring devices |
| wiring substrate | wiring device |
| conductive layer | conductor |
| through via | through portion |
| carrier substrate | support carrier |

A packaging technology that mounts a plurality of semiconductor elements with different functions, such as a CPU and a memory, with high density on a single substrate has been attracting attention. A structure that electrically connects a plurality of semiconductor elements is also referred to as an interposer. The interposer includes, for example, a wiring layer that includes conductors and an insulating layer. The wiring layer serves, for example, to redistribute pads or terminals of a semiconductor element to a different location. A structure in which a plurality of wiring layers is laminated is also referred to as a redistribution layer.

Each of the wiring layers includes conductors and an insulating layer that at least partially covers the conductors. PTL 2 (Japanese Unexamined Patent Application Publication No. 2018-022894) describes a structure in which an insulating layer includes an inorganic layer that at least partially covers the conductors and an organic layer that covers the inorganic layer.

A step of forming a redistribution layer may include steps performed at high temperatures, such as a step of heating the organic layer. When the organic layer contains moisture, low-molecular components, or the like, or when the molecular structure of the organic layer changes over time, gas may be generated within the organic layer during the step of forming a redistribution layer. When gas is retained, for example, at the interface between the organic layer and the inorganic layer, there is a concern that the inorganic layer may delaminate from the organic layer.

The second embodiment of the present disclosure aims to provide a redistribution layer and a manufacturing method for the redistribution layer, which can effectively solve such inconveniences.

The second embodiment of the present disclosure relates to the following [1] to [18].
[1] A redistribution layer includes:
   a plurality of wiring layers, wherein
   each of the plurality of wiring layers includes a conductor and an insulating layer at least partially covering the conductor,
   in at least one of the wiring layers, the insulating layer includes an inorganic layer that is in contact with the conductor so as to at least partially cover the conductor, and an organic layer located on the inorganic layer, and
   the inorganic layer has a plurality of first openings formed so as not to overlap the conductor in plan view.
[2] In the redistribution layer according to [1], the inorganic layer may include a second opening formed so as to overlap the conductor in plan view, and the organic layer may include a fourth opening formed so as to at least partially overlap the second opening in plan view.
[3] In the redistribution layer according to [2], a dimension of the fourth opening may be less than a dimension of the second opening.
[4] In the redistribution layer according to [2], a dimension of the fourth opening may be greater than a dimension of the second opening.
[5] In the redistribution layer according to [2], a dimension of the fourth opening may be equal to a dimension of the second opening.
[6] In the redistribution layer according to [5], the organic layer may include a third opening formed so as to at least partially overlap the first opening in plan view.
[7] In the redistribution layer according to [6], the plurality of wiring layers may include a first wiring layer, a second wiring layer located on the first wiring layer, and a third wiring layer located on the second wiring layer, the insulating layer of the second wiring layer may include the inorganic layer and the organic layer, and the insulating layer of the third wiring layer may be in contact with the insulating layer of the first wiring layer at locations of the first opening and the third opening.
[8] In the redistribution layer according to any one of [1] to [6], the plurality of wiring layers may include a first wiring layer and a second wiring layer located on the first wiring layer, the insulating layer of the second wiring layer may include the inorganic layer and the organic layer, and the organic layer of the second wiring layer may be in contact with the insulating layer of the first wiring layer at a location of the first opening.
[9] In the at least one of the wiring layers of the redistribution layer according to any one of [1] to [8], the conductor may include a wire having a first width and covered by the inorganic layer, and a dimension of the first opening may be greater than or equal to the first width.
[10] The redistribution layer according to any one of [1] to [9] may include a first region that is a square region having a side length of 1000 µm in plan view, the first region may include an inorganic layer that has at least one of the first openings formed so as not overlap the conductor in plan view, and an area ratio of the at least one of the first openings in the first region may be higher than or equal to 0.07%.
[11] In the redistribution layer according to any one of [1] to [10], at least one of the plurality of first openings may be a linear opening extending along the conductor in plan view.
[12] In the redistribution layer according to any one of [1] to [11], at least one of the plurality of first openings may be a surrounding opening that surrounds the conductor in plan view.
[13] A manufacturing method for a redistribution layer includes:
   a redistribution step of forming a redistribution layer, including a plurality of wiring layers, on a substrate, wherein
   each of the plurality of wiring layers includes a conductor and an insulating layer at least partially covering the conductor,
   in at least one of the wiring layers, the insulating layer includes an inorganic layer that is in contact with the conductor so as to at least partially cover the conductor, and an organic layer located on the inorganic layer, and
   the redistribution step includes a step of forming a plurality of first openings in the inorganic layer so as not to overlap the conductor in plan view.
[14] In the manufacturing method for a redistribution layer according to [13], the redistribution step may include a first wiring step of forming a first wiring layer and a second wiring step of forming a second wiring layer on the first wiring layer, the insulating layer of the second wiring layer may include the inorganic layer and the organic layer, the second wiring step may include a step of forming the conductor on the insulating layer of the first wiring layer, a step of forming the inorganic layer covering the conductor, a step of forming a plurality of first openings in the inorganic layer so as not to overlap the conductor in plan view, and a step of forming the organic layer covering the inorganic layer.
[15] In the manufacturing method for a redistribution layer according to [14], the inorganic layer of the second wiring layer may include a second opening formed so as to overlap the conductor in plan view, and the second opening may be formed in the inorganic layer simultaneously with the plurality of first openings.
[16] In the manufacturing method for a redistribution layer according to [14], the inorganic layer of the second wiring layer may include a second opening formed so as to overlap the conductor in plan view, and the second wiring step may include a step of forming a fourth opening in the organic layer so as to overlap the conductor in plan view, and a step of forming the second opening in the inorganic layer so as to overlap the fourth opening in plan view.
[17] In the manufacturing method for a redistribution layer according to [13], the redistribution step may include a first wiring step of forming a first wiring layer and a second wiring step of forming a second wiring layer on the first wiring layer, the insulating layer of the second wiring layer may include the inorganic layer and the organic layer, and the second wiring step may include a step of forming the conductor on the insulating layer of the first wiring layer, a step of forming the inorganic layer covering the conductor, a step of forming the organic layer covering the inorganic layer, a step of forming a plurality of third openings in the organic layer so as not to overlap the conductor in plan view, and a step of forming a plurality of first openings in the inorganic layer so as to overlap the plurality of third openings in plan view.
[18] In the manufacturing method for a redistribution layer according to [17], the inorganic layer of the second wiring layer may include a second opening formed so as to overlap the conductor in plan view, the organic layer of the second wiring layer may include a fourth opening formed so as to at least partially overlap the second opening in plan view, the fourth opening may be formed in the organic layer simultaneously with the plurality of third openings, and the second opening may be formed in the inorganic layer simultaneously with the plurality of first openings.

According to the second embodiment of the present disclosure, it is possible to suppress delamination of the inorganic layer.

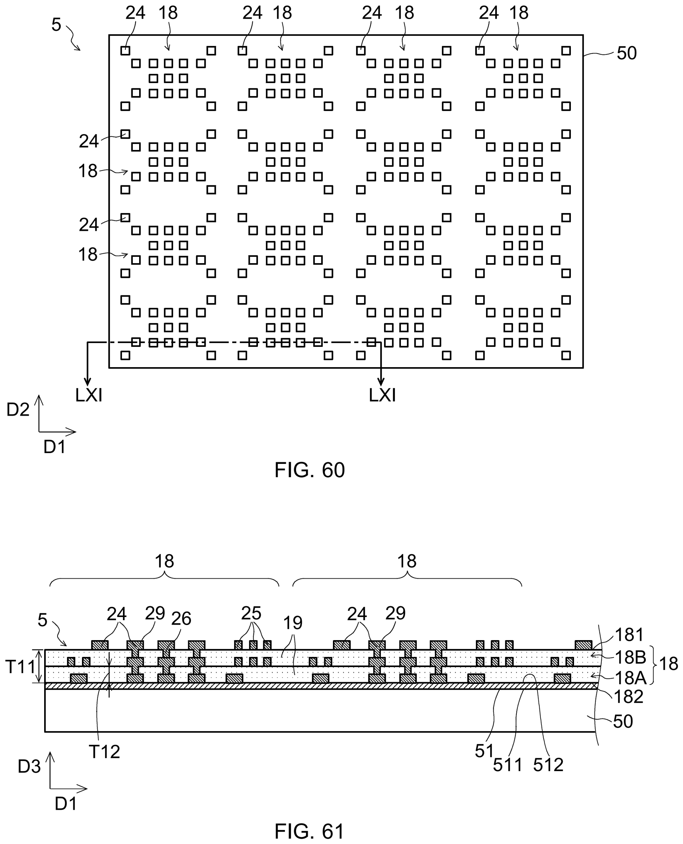

Fig. 60 is a plan view that shows an example of an array of wiring devices 5. Fig. 61 is a cross-sectional view of the array of wiring devices 5, taken along the line LXI-LXI in Fig. 60. The array of wiring devices 5 includes a plurality of wiring devices having the same structure. By cutting the array of wiring devices 5 as will be described later, a plurality of wiring devices is obtained. Each of the plurality of wiring devices includes a redistribution layer. In other words, the array of wiring devices 5 includes a plurality of the redistribution layers 18.

The array of wiring devices 5 has the first direction D1, the second direction D2, and the third direction D3. The first direction D1 and the second direction D2 are included in the plane direction of the array of wiring devices 5. The first direction D1 is orthogonal to the second direction D2. The third direction D3 is the thickness direction of the array of wiring devices 5. The third direction D3 is orthogonal to the first direction D1 and the second direction D2.

The array of wiring devices 5 includes the support carrier 50, the release layer 51, and the plurality of redistribution layers 18. The release layer 51 is located between the support carrier 50 and the redistribution layers 18 in the thickness direction of the array of wiring devices 5. The release layer 51 is located on the support carrier 50.

Although not shown in the drawing, a member supporting the redistribution layers 18 is not limited to the support carrier 50. For example, the redistribution layers 18 may be disposed on an electrode substrate that has openings penetrating through upper and lower surfaces and that has electrodes provided by forming metal wires in the openings, instead of the support carrier 50. The electrodes located in the openings may be connected to the conductors of the redistribution layers 18.

The redistribution layers 18 may be provided on any one of the surface or back surface of the substrate, such as the support carrier 50 and the electrode substrate, or on both the surface and the back surface. The pattern of the conductors in the redistribution layer 18 located on the back surface may be the same as the pattern of the redistribution layer 18 located on the surface or may be different.

The component elements of the array of wiring devices 5 will be described.

### (Redistribution Layer)

The plurality of redistribution layers 18 each has the same structure. For example, as shown in Fig. 60, the plurality of redistribution layers 18 may have the same structure in plan view. As shown in Fig. 60, the plurality of redistribution layers 18 may be arranged regularly in the plane direction of the array of wiring devices 5. For example, the plurality of redistribution layers 18 may be arranged regularly in the first direction D1 and the second direction D2. The first direction D1 and the second direction D2 may be directions parallel to the pairs of edges of the support carrier 50.

Fig. 61 is a cross-sectional view of the array of wiring devices 5, taken along the line LXI-LXI in Fig. 60. The redistribution layers 18 include the lower surface 182 and the upper surface 181. The lower surface 182 faces the support carrier 50. The upper surface 181 is located on the side opposite from the lower surface 182. Each of the redistribution layers 18 includes the insulating layers 19 and the plurality of conductors 24. Each of the insulating layers 19 at least partially covers the conductors 24. The insulating layer 19 may extend in the third direction D3 of the array of wiring devices 5 from the lower surface 182 to the upper surface 181.

In the specification, the "lower surface" such as the lower surface 182 refers to the surface facing the support carrier 50 in a state of the array of wiring devices 5. The "upper surface" refers to the surface located on the side opposite from the "lower surface" in the thickness direction.

Some of the plurality of conductors 24 may be pads 29. Each of the pads 29 may include an upper surface or lower surface that includes a portion not in contact with an insulating material such as the insulating layer 19. For example, when the pad 29 is located on the lower surface 182 of the redistribution layer 18, the lower surface of the pad 29 is not in contact with the insulating material. For example, when the pad 29 is located on the upper surface 181 of the redistribution layer 18, the upper surface of the pad 29 is not in contact with the insulating material. For example, when part of the upper surface of the pad 29 is connected to the through portion (described later), the upper surface of the pad 29 may include an area that is not in contact with the insulating material. The pad 29 has dimensions larger than the dimensions of the wire and the dimensions of the through portion (described later) in plan view.

Some of the plurality of conductors 24 may be the wires 25. Each of the wires 25 extends at least partially in the first direction D1 or the second direction D2. Both the upper surface and lower surface of the wire 25 may be in contact with an insulating material such as the insulating layer 19. The insulating material has insulating properties. The insulating material may be an organic material or may be an inorganic material.

Some of the plurality of conductors 24 may be the through portions 26. The through portion 26 is also referred to as a via. The through portion 26 extends in the third direction D3. For example, the through portion 26 is located in the opening formed in the insulating layer 19. The through portion 26, for example, can electrically connect the conductors 24 of two adjacent wiring layers in the third direction D3. The through portion 26 may be connected to the pad 29.

The redistribution layer 18 may include a plurality of laminated wiring layers. In the example shown in Fig. 61, each of the redistribution layers 18 includes a first wiring layer 18A and a second wiring layer 18B. Each of the plurality of wiring layers may include the insulating layer 19 and the plurality of conductors 24. In each of the plurality of wiring layers, the insulating layer 19 at least partially covers the conductors 24.

The first wiring layer 18A may constitute the lower surface 182 of the redistribution layers 18. The insulating layer 19 of the second wiring layer 18B may constitute the upper surface 181 of the redistribution layer 18. The array of wiring devices 5 may include the conductors 24 that are located on the insulating layer 19 of the second wiring layer 18B and that constitute the pads 29.

The redistribution layer 18 has a thickness T11. The thickness T11 is, for example, greater than or equal to 8 µm, may be greater than or equal to 16 µm, and may be greater than or equal to 24 µm. The thickness T11 is, for example, less than or equal to 100 µm, may be less than or equal to 90 µm, and may be less than or equal to 80 µm. The thickness T11 is a distance in the third direction D3 from the lower surface 182 to the upper surface 181. The dimensions of the component elements of the array of wiring devices 5, such as the thickness T11, are calculated based on the cross-sectional image of the array of wiring devices 5, taken with a scanning electron microscope.

The thickness T12 of each of the plurality of wiring layers of the redistribution layer 18 is, for example, greater than or equal to 4.0 µm, and may be greater than or equal to 6.0 µm. The thickness T12 of each of the plurality of wiring layers of the redistribution layer 18 is, for example, less than or equal to 12.0 µm, and may be less than or equal to 10.0 µm. The thicknesses T12 of the plurality of wiring layers may be the same or may be different.

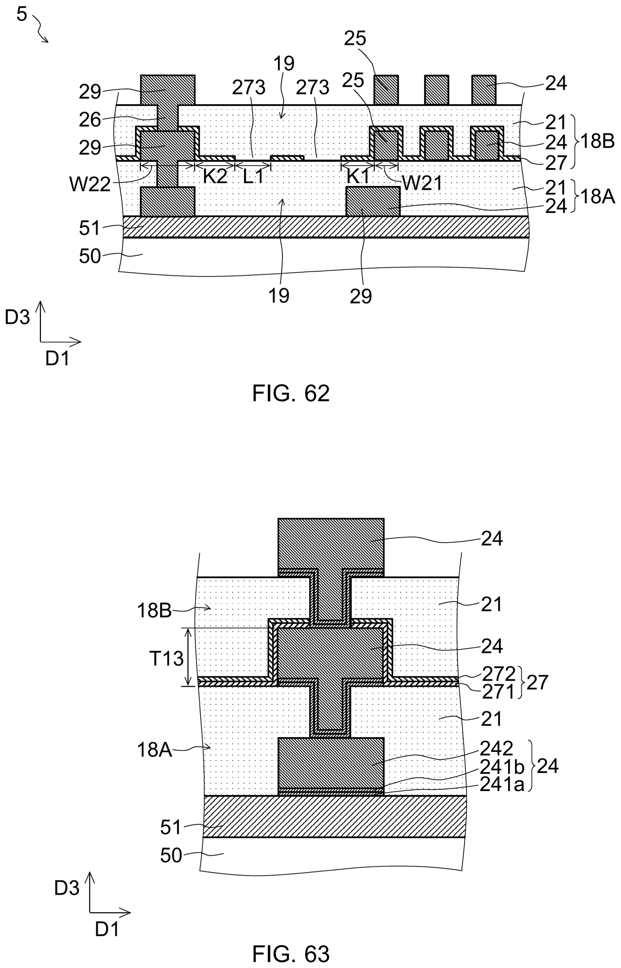

Fig. 62 is a cross-sectional view that shows an example of the redistribution layer 18. In the plurality of wiring layers, the insulating layer 19 includes the organic layer 21. In at least one wiring layer, the insulating layer 19 may include the organic layer 21 and the inorganic layer 27.

In the example shown in Fig. 62, the insulating layer 19 of the first wiring layer 18A includes the organic layer 21. The organic layer 21 of the first wiring layer 18A may be in contact with the conductors 24 so as to at least partially cover the conductors 24. The term "cover" means that, when the redistribution layer 18 is viewed along the normal direction of the lower surface 182, the organic layer 21 and the conductors 24 at least partially overlap.

In the example shown in Fig. 62, the insulating layer 19 of the second wiring layer 18B includes the organic layer 21 and the inorganic layer 27. The inorganic layer 27 of the second wiring layer 18B may be in contact with the conductors 24 so as to at least partially cover the conductors 24. The organic layer 21 of the first wiring layer 18A may be located on the inorganic layer 27. Portions of the inorganic layer 27 of the second wiring layer 18B that do not overlap the conductors 24 may be in contact with the organic layer 21 of the first wiring layer 18A.

The organic layer 21 includes an organic material having insulating properties. Examples of the organic material include polyimide, epoxy, and acrylic.

The organic layer 21 may include a plurality of fillers distributed within the organic material. By mixing a plurality of fillers into the organic material, the mechanical characteristics, thermal properties, and the like, of the organic layer 21 are adjusted. The filler may include an inorganic material and may include an organic material. Examples of the material of the filler include silicon oxide.

The inorganic layer 27 includes an inorganic material. Examples of the inorganic material include metal materials, inorganic oxides, and inorganic nitrides. The inorganic material may have insulating properties. For example, the inorganic material may be an inorganic oxide or inorganic nitride having insulating properties. Examples of the inorganic oxides include silicon oxides, such as SiO₂. Examples of the inorganic nitrides include silicon nitrides, such as SiN. The inorganic material may be SiOC, SiC, SiOF, SiON, SiCN, or the like.

The coefficient of thermal expansion of the inorganic material of the inorganic layer 27 is lower than the coefficient of thermal expansion of the organic material of the organic layer 21. The coefficient of thermal expansion of the inorganic layer 27 is, for example, lower than or equal to 10.0ppm/°C, may be lower than or equal to 8.0ppm/°C, and may be lower than or equal to 5.0ppm/°C.

The thickness of the inorganic layer 27 is, for example, greater than or equal to 0.10 µm, may be greater than or equal to 0.30 µm, and may be greater than or equal to 0.50 µm. The thickness of the inorganic layer 27 is, for example, less than or equal to 5.0 µm, may be less than or equal to 3.0 µm, and may be less than or equal to 1.0 µm.

The step of forming the redistribution layer 18 may include steps performed at high temperatures, such as a step of heating the organic layer 21. The coefficient of thermal expansion of the organic material of the organic layer 21 is higher than the coefficient of thermal expansion of the other component elements of the redistribution layer 18. For example, the coefficient of thermal expansion of the organic material of the organic layer 21 is higher than the coefficient of thermal expansion of the substrate, such as the support carrier 50. For example, the coefficient of thermal expansion of the organic material of the organic layer 21 is higher than the coefficient of thermal expansion of the conductor 24. After the heating step, when the temperature of the component elements of the redistribution layer 18 decreases, stress presumably occurs due to the difference in the coefficient of thermal expansion between the organic layer 21 and the other component elements. For example, it is presumable that stress occurs in the substrate, the conductors 24, and the like.

According to the present embodiment, since the redistribution layer 18 includes the inorganic layer 27, the influence of stress due to the organic layer 21 on the component elements other than the inorganic layer 27 is suppressed. As a result, for example, occurrence of warpage of the redistribution layer 18, the array of wiring devices 5, or the wiring device 10 is suppressed. Since occurrence of stress in the conductors 24 is suppressed, occurrence of defects, such as deformation and damage, in the conductors 24 may be suppressed.

Incidentally, when the temperature of the organic layer 21 increases due to the heating step, or the like, gas may be generated within the organic layer 21. Depending on the type of organic material, gas may be generated within the organic layer 21 due to a change in molecular structure caused by light or heat originating from a storage environment. When gas is retained, for example, at the interface between the organic layer 21 of the first wiring layer 18A and the inorganic layer of the second wiring layer 18B, there is a concern that the inorganic layer 27 may delaminate from the organic layer 21.

To solve such issues, in this present embodiment, it is proposed that an opening penetrating the inorganic layer 27 in the third direction D3 be formed in the inorganic layer 27. For example, as shown in Fig. 62, the inorganic layer 27 of the second wiring layer 18B includes a plurality of first openings 273. The plurality of first openings 273 is formed so as not overlap the conductors 24 of the second wiring layer 18B in plan view.

The organic layer 21 of the second wiring layer 18B may be located in the first openings 273 of the inorganic layer 27. For example, the organic layer 21 of the second wiring layer 18B may be in contact with the organic layer 21 of the first wiring layer 18A at the positions of the first openings 273 of the inorganic layer 27.

Gas generated within the organic layer 21 of the first wiring layer 18A can move to the organic layer 21 of the second wiring layer 18B through the first openings 273. As a result, retention of gas at the interface between the organic layer 21 of the first wiring layer 18A and the inorganic layer 27 of the second wiring layer 18B is suppressed. Gas may be discharged from the organic layer 21 of the second wiring layer 18B to the outside of the redistribution layer 18.

The dimension L1 of the first opening 273 in plan view is set so that gas can appropriately pass through. The dimension L1 is, for example, greater than or equal to 1.0 µm, may be greater than or equal to 2.0 µm, and may be greater than or equal to 3.0 µm. The dimension L1 is, for example, less than or equal to 100 µm, may be less than or equal to 50 µm, may be less than or equal to 30 µm, and may be less than or equal to 20 µm.

Each of the wires 25 of the conductors 24 has a first width W21. The first width W21 is defined in a direction orthogonal to the direction in which the wire 25 extends. The dimension L1 of the first opening 273 may be greater than or equal to the first width W21 of the wire 25. L1/W21 that is the ratio of the dimension L1 to the first width W21 is, for example, greater than or equal to 1.0, may be greater than or equal to 1.2, may be greater than or equal to 1.5, and may be greater than or equal to 2.0. Although not shown in the drawing, the redistribution layer 18 may include wires having a width greater than the dimension L1 in addition to the wires 25 having a first width less than or equal to the dimension L1.

Reference sign K1 represents the distance between the wire 25 of the conductor 24 and the first opening 273. The distance K1 may be defined so that the inorganic layer 27 can appropriately protect the wires 25. The distance K1 may be defined relatively to the first width W21 of the wire 25. K1/W21 that is the ratio of the distance K1 to the first width W21 is, for example, greater than or equal to 0.5, may be greater than or equal to 1.0, and may be greater than or equal to 1.5.

The pad 29 of the conductor 24 has a second width W22. The second width W22 is an equivalent circle diameter. Specifically, the second width W22 is the diameter of a circle that has an area equal to the area of the pad 29 in plan view. A distance K2 may be defined so that the inorganic layer 27 can appropriately protect the pad 29. The distance K2 may be defined relatively to the second width W22 of the pad 29. K2/W22 that is the ratio of the distance K2 to the second width W22 is, for example, greater than or equal to 0.5, may be greater than or equal to 1.0, and may be greater than or equal to 1.5.

The inorganic layer 27 may be formed of a single layer made of the above-described inorganic material. The inorganic layer 27 may include a plurality of layers. Fig. 63 is a cross-sectional view that shows an example of the inorganic layer 27 and the conductors 24. As shown in Fig. 63, the inorganic layer 27 may include a first inorganic layer 271 in contact with the conductor 24 and a second inorganic layer 272 located on the first inorganic layer 271.

The first inorganic layer 271 may have a higher adhesion to the conductor 24 than the second inorganic layer 272. The second inorganic layer 272 may have a lower relative permittivity than the first inorganic layer 271. For example, the first inorganic layer 271 may include silicon nitride, such as SiN, and the second inorganic layer 272 may include silicon oxide, such as SiO₂.

The thickness of the first inorganic layer 271 may be less than the thickness of the second inorganic layer 272. The thickness of the first inorganic layer 271 is, for example, greater than or equal to 0.05 µm, may be greater than or equal to 0.10 µm, and may be greater than or equal to 0.20 µm. The thickness of the first inorganic layer 271 is, for example, less than or equal to 2.0 µm, may be less than or equal to 1.0 µm, and may be less than or equal to 0.50 µm. The thickness of the second inorganic layer 272 is, for example, greater than or equal to 0.10 µm, may be greater than or equal to 0.20 µm, and may be greater than or equal to 0.50 µm. The thickness of the second inorganic layer 272 is, for example, less than or equal to 5.0 µm, may be less than or equal to 2.0 µm, and may be less than or equal to 1.0 µm.

The conductors 24 include a material having electrical conductivity. The conductors 24 may include a metal, such as copper, gold, silver, platinum, rhodium, tin, aluminum, nickel, titanium, chromium, and zinc, or an alloy using one or more of these metals. The thickness T13 of the conductor 24 is, for example, greater than or equal to 0.1 µm, may be greater than or equal to 0.5 µm, and may be greater than or equal to 1.0 µm. The thickness T13 of the conductor 24 is, for example, less than or equal to 15.0 µm, may be less than or equal to 10.0 µm, and may be less than or equal to 6.0 µm.

As shown in Fig. 63, the conductor 24 may include the seed layer 241b and the body layer 242. The seed layer 241b is a layer having electrical conductivity and formed by physical film deposition, such as sputtering. The body layer 242 is a layer having electrical conductivity and formed on the seed layer 241b by electrolytic plating. The conductor 24 may include an adhesion layer 241a located between the insulating layer 19 and the seed layer 241b. The adhesion layer 241a may be a layer having electrical conductivity, and may be a metal oxide layer or a metal nitride layer. The adhesion layer 241a may also be a laminate of these materials.

When the conductor 24 includes the adhesion layer 241a, the adhesion layer 241a and the seed layer 241b may correspond to the first seed layer 241a and the second seed layer 241b of the above-described first embodiment, respectively.

The material of the adhesion layer 241a is different from the material of the seed layer 241b and the material of the body layer 242. Examples of the material of the adhesion layer 241a include titanium, molybdenum, tungsten, tantalum, nickel, chromium, aluminum, compounds of these metals, alloys of these metals, and oxides and nitrides of these metals. The adhesion layer 241a may have a higher adhesion to the insulating layer 19 than the seed layer 241b.

The seed layer 241b may include a metal material, such as copper, nickel, titanium, chromium, zinc, and gold. The seed layer 241b may include a compound of these metal materials. The seed layer 241b may include a plurality of layers. The body layer 242 may include a metal, such as copper, gold, silver, platinum, rhodium, tin, aluminum, nickel, titanium, chromium, and zinc, or an alloy using one or more of these metals.

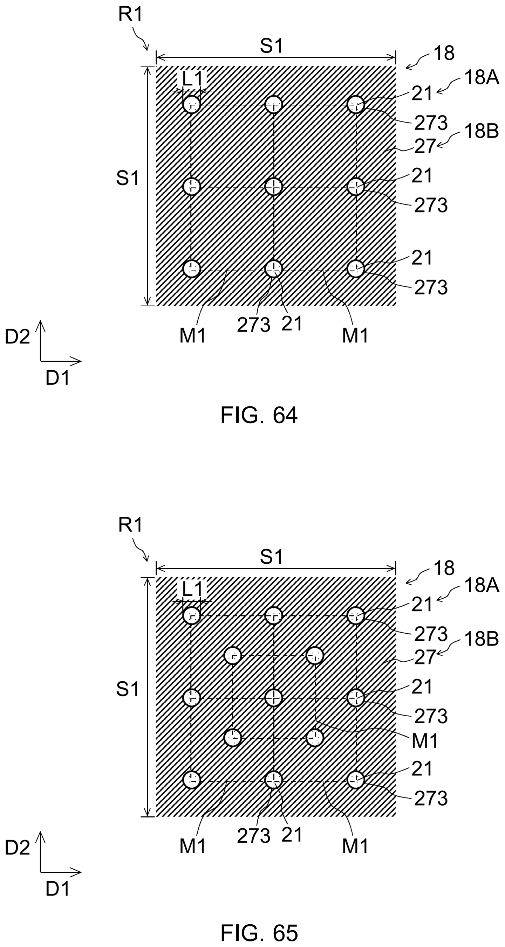

Fig. 64 is a plan view that shows an example of the plurality of first openings 273 in the inorganic layer 27. The plurality of first openings 273 may be regularly distributed in plan view. For example, the plurality of first openings 273 may be arranged in the first direction D1 and the second direction D2.

The first openings 273 regularly distributed are also referred to as distribution openings. The dimension L1 of the distribution opening is an equivalent circle diameter. Specifically, the dimension L1 of the distribution opening is the diameter of a circle that has an area equal to the area of the distribution opening in plan view.

The plurality of first openings 273 may be located at the vertices of a plurality of unit cells M1 arranged in the plane direction of the lower surface 182. The shape of each unit cell M1 is a square, a rectangle, a parallelogram, a rhombus, a triangle, or the like. In the example shown in Fig. 64, the shape of the unit cell M1 is a square.

As shown in Fig. 64, the redistribution layer 18 may include a first region R1 that is a virtual square region with one side having a length of S1 in plan view. The first region R1 is defined by virtually partitioning the redistribution layer 18 into a square in plan view. The first region R1 includes the inorganic layer 27 that includes at least one first opening 273 formed so as not to overlap the conductors in plan view. The area ratio of the first openings 273 in the first region R1 is, for example, higher than or equal to 0.07%, may be higher than or equal to 0.50%, and may be higher than or equal to 1.00%. Since the area ratio of the first openings 273 is higher than or equal to a certain value, gas can appropriately passes through the first openings 273. For example, when the first openings 273 are formed in the inorganic layer 27 of the second wiring layer 18B, gas within the organic layer 21 of the first wiring layer 18A can appropriately pass through the first openings 273.

The area ratio of the first openings 273 in the first region R1 is the percentage of the total area of the first openings 273 included in the first region R1 relative to the area of the first region R1 in plan view. An area ratio of 0.07% corresponds to a case where the first region R1 includes one first opening 273 with a dimension L1 of 30 µm when the length S1 of one side of the first region R1 is 1000 µm. An area ratio of 0.50% corresponds to a case where the first region R1 includes one first opening 273 with a dimension L1 of 80 µm when the length S1 of one side of the first region R1 is 1000 µm.

The redistribution layer 18 preferably includes at least one of the above-described first regions R1. The redistribution layer 18 may include a plurality of the above-described first regions R1.

Fig. 65 is a plan view that shows an example of the plurality of first openings 273 in the inorganic layer 27. In a layout where the plurality of unit cells M1 is arranged in a staggered pattern, the plurality of first openings 273 may be located at the vertices of the unit cells M1, respectively.

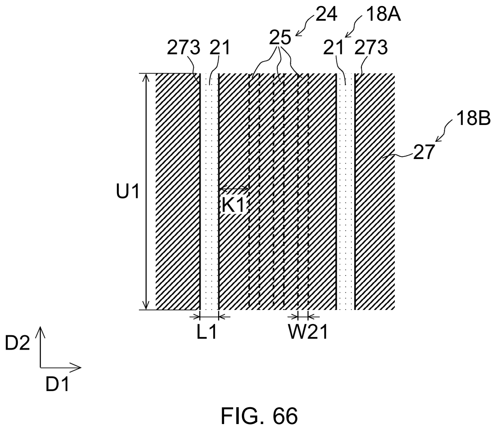

Fig. 66 is a plan view that shows an example of the first openings 273. The first openings 273 may extend along the wires 25 of the conductors 24 in plan view. The first openings 273 extending along the wires 25 are also referred to as linear openings. At least one of the plurality of first openings 273 may be a linear opening.

The dimension L1 of the linear opening is defined in a direction orthogonal to the direction in which the wire 25 extends. The linear opening may have a length U1 in the direction in which the wire 25 extends. The length U1 of the linear opening is, for example, greater than or equal to 100 µm, may be greater than or equal to 300 µm, and may be greater than or equal to 500 µm.

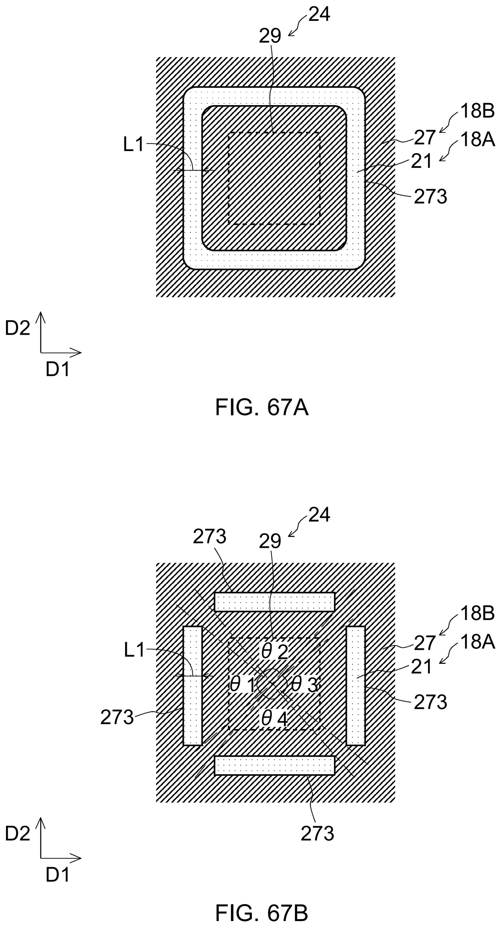

Fig. 67A is a plan view that shows an example of the first opening 273. The first opening 273 may surround the pad 29 of the conductor 24 in plan view. The first opening 273 surrounding the pad 29 is also referred to as a surrounding opening. At least one of the plurality of first openings 273 may be a surrounding opening.

Fig. 67B is a plan view that shows an example of the surrounding opening. The surrounding opening does not need to completely surround the pad 29 in plan view. For example, the surrounding opening may include the plurality of first openings 273 located around the pad 29 in plan view. When the sum of the circumferential angles of the plurality of first openings 273 relative to the center of the pad 29 is greater than or equal to a certain value, it is defined that the surrounding opening is formed of the plurality of first openings 273. In the example shown in Fig. 67B, the surrounding opening includes four first openings 273. The sum of the circumferential angles is the sum of θ1 to θ4. The sum of the circumferential angles may be larger than or equal to 240°, may be larger than or equal to 300°, and may be larger than or equal to 330°.

### (Support Carrier)

The support carrier 50 is a member that supports the redistribution layer 18. Examples of the support carrier 50 may include a glass substrate, a quartz substrate, a sapphire substrate, a resin substrate, a silicon substrate, a metal substrate, a silicon carbide substrate, an alumina (Al2O3) substrate, an aluminum nitride (AIN) substrate, a zirconium oxide (ZrO2) substrate, a lithium niobate substrate, and a tantalum niobate substrate. The resin substrate may include an organic material. For example, the resin substrate may include epoxy resin, polyethylene, polypropylene, or the like. The metal substrate may be made of only a conductive metal, such as copper, aluminum, and nickel, and may be made of a plurality of metals, such as stainless steel. The thickness of the support carrier 50 is, for example, greater than or equal to 100 µm, may be greater than or equal to 200 µm, and may be greater than or equal to 500 µm. The thickness of the support carrier 50 is, for example, less than or equal to 2 mm, may be less than or equal to 1.5 mm, and may be less than or equal to 1 mm.

### (Release Layer)

The release layer 51 is a layer for facilitating separation of the redistribution layer 18 from the support carrier 50. The release layer 51 includes a first lower surface 511 facing the support carrier 50 and a first upper surface 512 located on the side opposite from the first lower surface 511. The release layer 51 includes, for example, a resin.

The release layer 51 is configured such that the adhesion between the release layer 51 and the redistribution layer 18 decreases in response to a certain trigger. The trigger may be irradiating the release layer 51 with light of a specific wavelength. For example, the release layer 51 may decompose when irradiated with light of a specific wavelength. The trigger may be heating the release layer 51. For example, the release layer 51 may include a thermoplastic resin.

The thickness of the release layer 51 is, for example, greater than or equal to 0.1 µm, may be greater than or equal to 0.2 µm, and may be greater than or equal to 0.3 µm. The thickness of the release layer 51 is, for example, less than or equal to 1.0 µm, may be less than or equal to 0.8 µm, and may be less than or equal to 0.5 µm.

### (Manufacturing Method for Array of Wiring Devices)

A manufacturing method for the array of wiring devices 5 will be described.

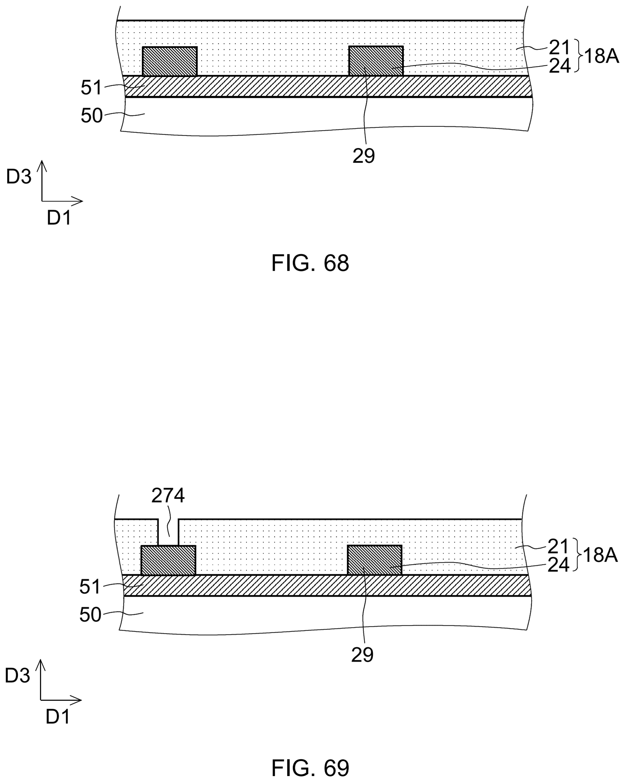

As shown in Fig. 68, the support carrier 50 is prepared. Subsequently, as shown in Fig. 68, the release layer 51 is formed on the support carrier 50. A step of forming the release layer 51 includes, for example, an application step of applying a solution containing resin and solvent, and a drying step of, after the application step, evaporating the solvent. Examples of the solvent include propylene glycol monomethyl ether, 2-methoxy-1-methylethyl acetate, N-methyl-2-pyrrolidone, γ-butyrolactone, ethyl lactate, and toluene. The drying step includes, for example, a step of heating the support carrier 50.

Subsequently, a redistribution step of forming the redistribution layers 18, each including a plurality of wiring layers, on the support carrier 50 is performed. The redistribution step includes, for example, a first wiring step of forming the first wiring layer 18A and a second wiring step of forming the second wiring layer 18B on the first wiring layer 18A.

Fig. 68 is a cross-sectional view that shows the first wiring step of forming the first wiring layer 18A. The first wiring layer 18A may be formed on the release layer 51. The first wiring step includes a step of forming the conductors 24 and a step of forming the organic layer 21. The step of forming the conductors 24 and the step of forming the organic layer 21 will be described in detail in a second wiring step (described later).

Although not shown in the drawing, a step of forming an intermediate layer on the release layer 51 may be performed before the first wiring step. The intermediate layer may be, for example, a layer that shields light irradiated onto the release layer 51.

After the first wiring step, the second wiring step of forming the second wiring layer 18B on the first wiring layer 18A is performed. As shown in Fig. 69, the second wiring step may include a step of forming fourth openings 214 in the organic layer 21 of the first wiring layer 18A.

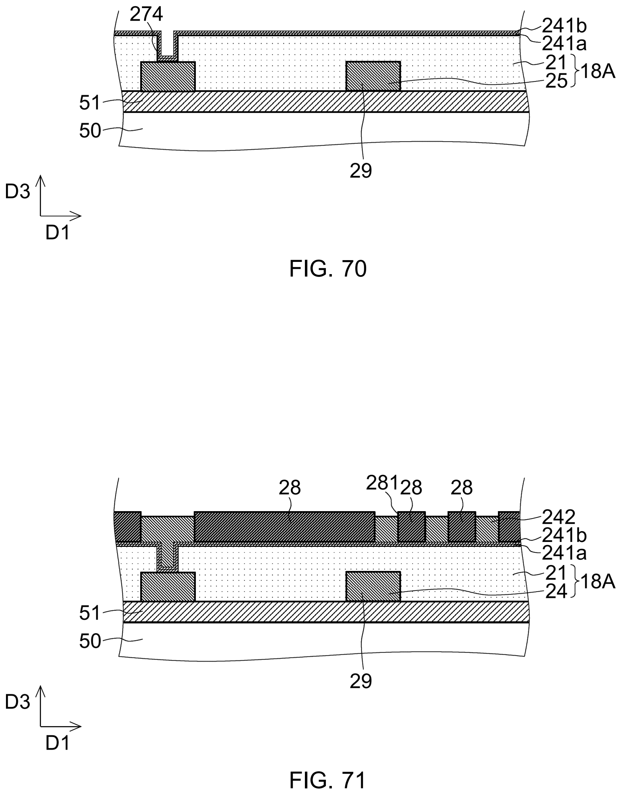

The second wiring step includes a step of forming the conductors 24 on the insulating layer 19 of the first wiring layer 18A. For example, as shown in Fig. 70, the adhesion layer 241a and the seed layer 241b are formed on the organic layer 21 of the insulating layer 19 of the first wiring layer 18A. The adhesion layer 241a and the seed layer 241b are formed, for example, by sputtering. The adhesion layer 241a and the seed layer 241b are also formed on the bottom surfaces and side surfaces of the fourth openings 214 in the organic layer 21 of the first wiring layer 18A.

Subsequently, as shown in Fig. 71, the first resist layer 28 is formed on the seed layer 241b. The first resist layer 28 has openings 281 that penetrate the first resist layer 28 in the thickness direction. Each of the openings 281 has a shape corresponding to the body layer 242 in plan view. Subsequently, the plating step is performed. In the plating step, the body layers 242 are formed in the openings 281 by electrolytic plating, as shown in Fig. 71.

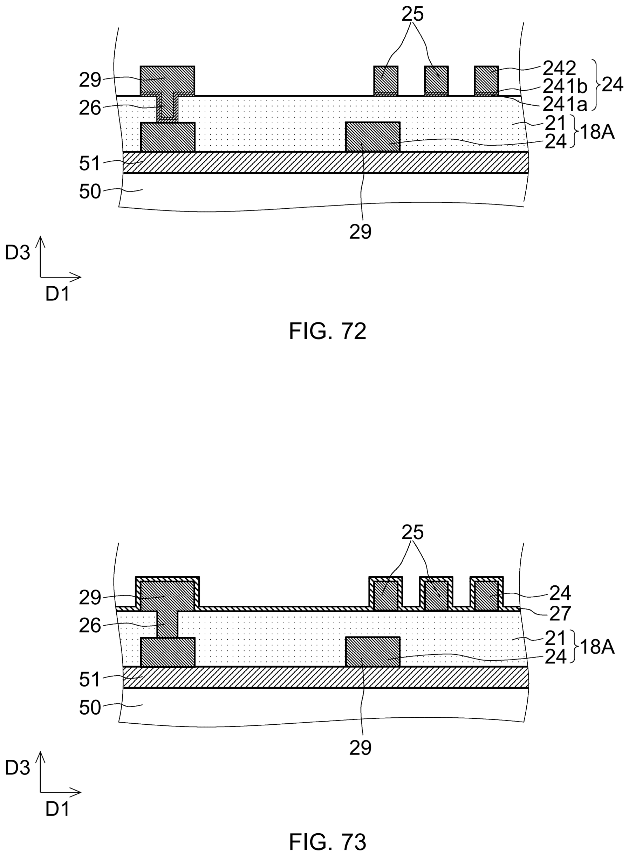

Subsequently, as shown in Fig. 72, a step of removing the first resist layer 28 is performed. Subsequently, as shown in Fig. 72, a step of removing the adhesion layer 241a and the seed layer 241b overlapping the first resist layer 28 is performed. In this way, the conductors 24 each including the adhesion layer 241a, the seed layer 241b, and the body layer 242 are formed.

Subsequently, as shown in Fig. 73, a step of forming the inorganic layer 27 is performed. For example, the inorganic layer 27 is formed by a vapor deposition method, such as CVD, ALD, and PVD. The inorganic layer 27 covers the plurality of conductors 24 and the organic layer 21 of the first wiring layer 18A.

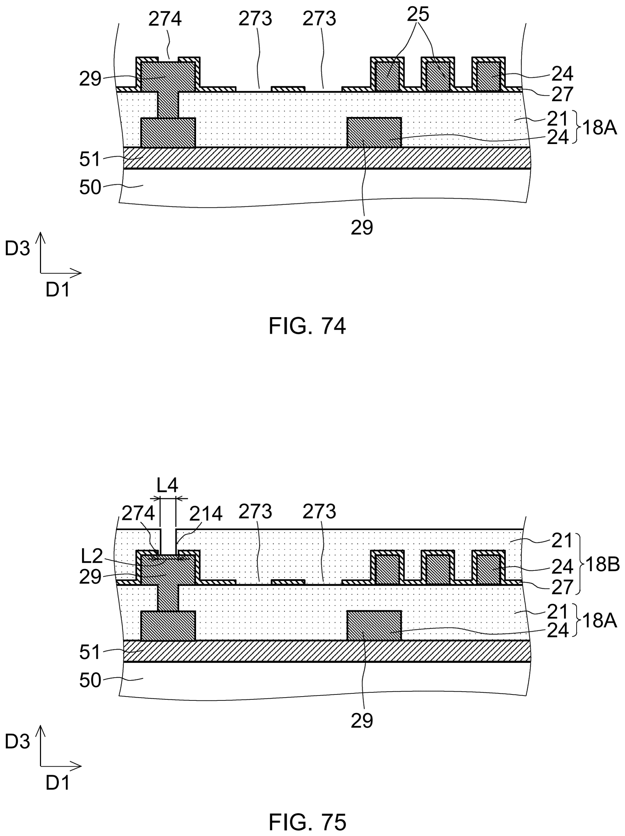

Subsequently, as shown in Fig. 74, a step of forming the plurality of first openings 273 and a plurality of second openings 274 in the inorganic layer 27 is performed. The first openings 273 are formed in the inorganic layer 27 so as not to overlap the conductors 24 in plan view. The second openings 274 are formed in the inorganic layer 27 so as to overlap the pads 29 of the conductors 24 in plan view. The plurality of first openings 273 and the plurality of second openings 274 are formed in the inorganic layer 27 by a method, such as dry etching, wet etching, and blasting. The plurality of second openings 274 may be formed in the inorganic layer 27 simultaneously with the plurality of first openings 273.

Subsequently, as shown in Fig. 75, a step of forming the organic layer 21 covering the inorganic layer 27 is performed. For example, by applying organic material onto the inorganic layer 27 using a method, such as spin coating, the organic layer 21 is formed. Alternatively, a step of forming the organic layer 21 may include a step of sticking a film including an organic material layer onto the inorganic layer 27. The organic layer 21 may be formed by transferring an organic material layer onto the inorganic layer 27. Subsequently, as shown in Fig. 75, a step of forming the fourth openings 214 in the organic layer 21 so as to overlap the second openings 274 in the inorganic layer 27 in plan view is performed. When the organic material has photosensitivity, the fourth openings 214 may be formed in the organic layer 21 through an exposure step and a development step. Subsequently, a heating step of heating the organic layer 21 may be performed. The organic layer 21 is cured through the heating step. The heating temperature is, for example, higher than or equal to 200°C.

Reference sign L2 represents the dimension of the second opening 274 in the plane direction of the lower surface 182. Reference sign L4 represents the dimension of the fourth opening 214 in the plane direction of the lower surface 182. As shown in Fig. 75, the dimension L4 of the fourth opening 214 may be less than the dimension L2 of the second opening 274. In this case, as shown in Fig. 75, part of the organic layer 21 can come into contact with the upper surfaces of the pads 29.

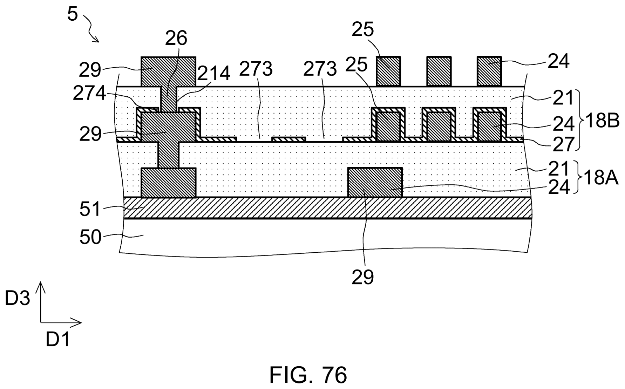

After the second wiring layer 18B including the organic layer 21, the inorganic layer 27, and the conductors 24 is formed, the conductors 24, such as the pads 29, the wires 25, and the through portions 26, may be formed on the second wiring layer 18B, as shown in Fig. 76.

By forming the plurality of redistribution layers 18 on the support carrier 50, the array of wiring devices 5 is obtained.

### (Manufacturing Method for Wiring Device)

Next, a manufacturing method for the wiring device 10 will be described.

The array of wiring devices 5 is prepared. Subsequently, a cutting step of cutting the wiring devices 5 is performed. As a result, the plurality of wiring devices 10 is manufactured. Each of the wiring devices 10 includes the support carrier 50, the release layer 51 located on the support carrier 50, and the redistribution layer 18 located on the release layer 51.

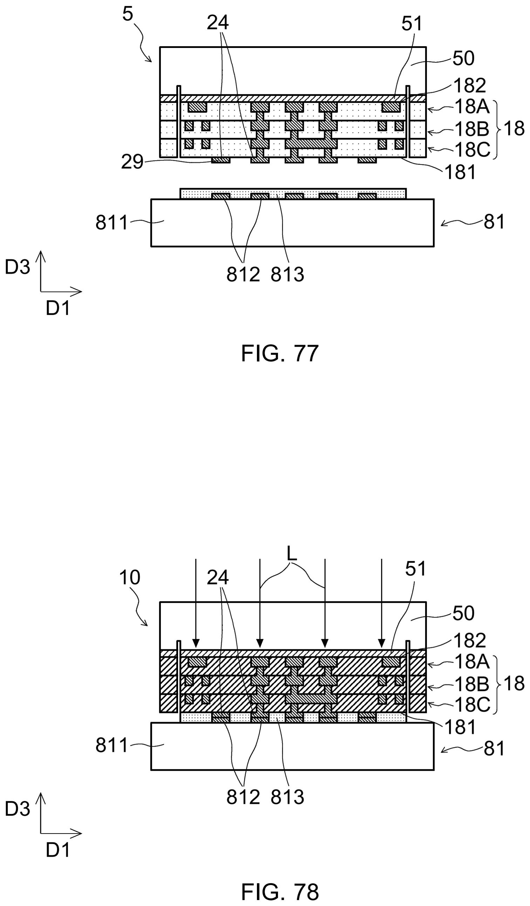

As shown in Figs. 77 and 78, after the cutting step, a joining step of joining the wiring device 10 to a substrate 81 may be performed. The substrate 81 may include a base 811 and a plurality of terminals 812 located on the base 811. The substrate 81 may include a bonding layer 813 covering the plurality of terminals. The bonding layer 813 may be provided on the wiring device 10. In the joining step, as shown in Fig. 78, the conductors 24 located on the upper surface 181 of the redistribution layer 18 and constituting the pads 29 may be electrically connected to the terminals 812 of the substrate 81.

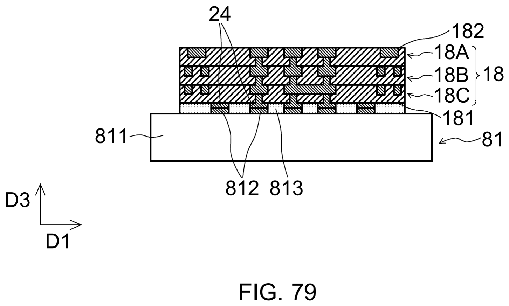

Subsequently, as shown in Figs. 78 and 79, a separating step of separating the redistribution layer 18 from the support carrier 50 may be performed. The separating step may include an irradiation step of irradiating light L onto the release layer 51, as shown in Fig. 78. In the irradiation step, the light L may pass through the support carrier 50 and then reach the release layer 51. The release layer 51 may be decomposed by heat generated due to irradiation of light L. The adhesion between the support carrier 50 and the redistribution layer 18 decreases due to decomposition. For this reason, as shown in Fig. 79, the redistribution layer 18 is transferred from the support carrier 50 to the substrate 81.

The structure including the transferred redistribution layer 18 includes the substrate 81 and the redistribution layer 18 located on the substrate 81. This structure may also be referred to as a wiring device. In the wiring device shown in Fig. 79, the upper surface 181 of the redistribution layer 18 faces the substrate 81.

Although not shown in the drawing, the usage method and distribution form of the redistribution layer 18 are not limited. For example, a semiconductor element may be mounted on the lower surface 182 of the redistribution layer 18. The semiconductor element includes transistors formed of a semiconductor, such as silicon. Examples of the semiconductor element include a CPU, a GPU, an FPGA, a sensor, and a memory. The semiconductor element may be a chiplet into which a semiconductor element, such as a CPU, a GPU, an FPGA, a sensor, and a memory, is separated by function.

Although not shown in the drawing, the redistribution layer 18 may be manufactured on a member, such as the substrate 81, that includes conductive layers, such as the terminals 812. In this case, the redistribution layer 18 is used in a state where the lower surface 182 of the redistribution layer 18 faces the substrate 81. In this case, a semiconductor element may be mounted on the upper surface 181 of the redistribution layer 18.

The redistribution layer 18 may be distributed in the form of the array of wiring devices 5. The redistribution layer 18 may be distributed in the form of the wiring device 10. The redistribution layer 18 may be distributed after being transferred from the support carrier 50 to the substrate 81.

In the present embodiment, at least one wiring layer included in the redistribution layer 18 includes the inorganic layer 27 in which the plurality of second openings 274 is formed. For this reason, retention of gas generated within the organic layer 21 at the interface between the organic layer 21 and the inorganic layer 27 can be suppressed. As a result, delamination of the inorganic layer 27 from the organic layer 21 and the conductors 24 can be suppressed.

The above-described second embodiment can be variously modified. Hereinafter, modifications will be described with reference to the drawings as needed. In the following description and the drawings used in the following description, like reference signs to the reference signs used for corresponding portions in the above-described second embodiment are used for portions that can be similarly configured to those of the above-described second embodiment. Repeated descriptions are omitted. When the operation and advantageous effects obtained in the above-described second embodiment are also apparently obtained in the modifications, the description thereof may be omitted.

### (First Modification)

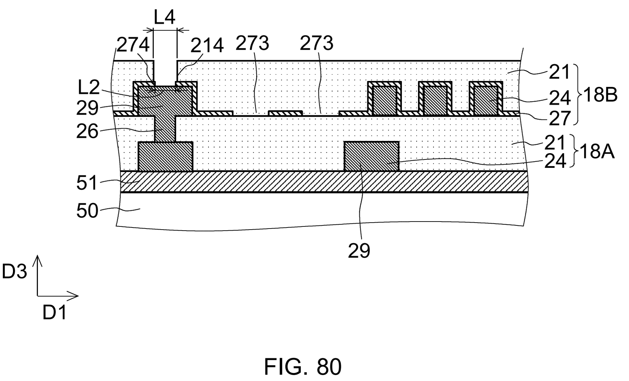

Fig. 80 is a cross-sectional view that shows a step of forming the organic layer 21 of the second wiring layer 18B in the first modification. As shown in Fig. 80, the dimension L4 of the fourth opening 214 in the organic layer 21 may be greater than the dimension L2 of the second opening 274 in the inorganic layer 27. According to the first modification, the step of forming the fourth openings 214 in the organic layer 21 is facilitated as compared to when the dimension L4 is less than the dimension L2. For example, a request for the accuracy of the exposure step performed to form the fourth openings 214 in the organic layer 21 is relaxed.

### (Second Modification)

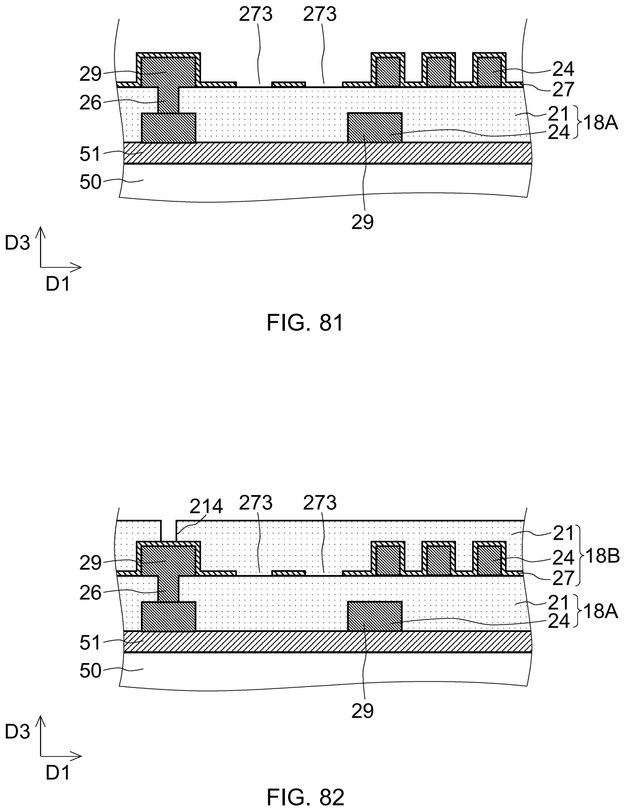

Fig. 81 is a cross-sectional view that shows a step of forming openings in the inorganic layer 27 of the second wiring layer 18B in the second modification. As shown in Fig. 81, when the plurality of first openings 273 is formed in the inorganic layer 27, the second openings 274 do not need to be formed simultaneously.

In the second modification, as shown in Fig. 82, the organic layer 21 is formed on the inorganic layer 27 in a state where the second openings 274 are not formed. Subsequently, a step of forming the fourth openings 214 in the organic layer 21 so as to overlap the pads 29 of the conductors 24 in plan view is performed.

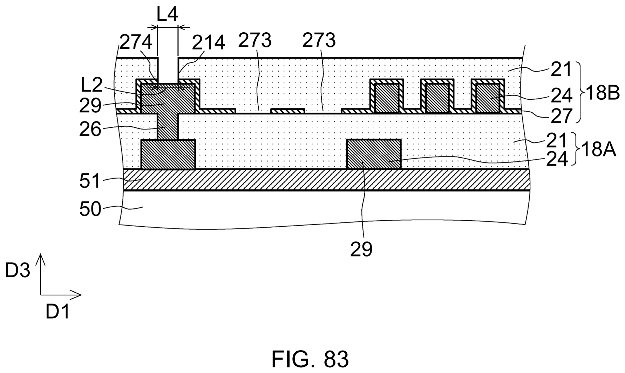

After that, as shown in Fig. 83, a step of forming the second openings 274 in the inorganic layer 27 so as to overlap the fourth openings 214 in plan view is performed. For example, the second openings 274 are formed in the inorganic layer 27 by plasma etching. For example, by the action of plasma gas on the inorganic layer 27 exposed to the fourth opening 214, the second openings 274 are formed in the inorganic layer 27. In this case, the dimension L2 of the second opening 274 is equal to the dimension L4 of the fourth opening 214. The term "equal" means that, at the interface position between the organic layer 21 and the inorganic layer 27 in the third direction D3, the difference between the dimension L2 of the second opening 274 and the dimension L4 of the fourth opening 214 is less than or equal to 0.10 µm.

### (Third Modification)

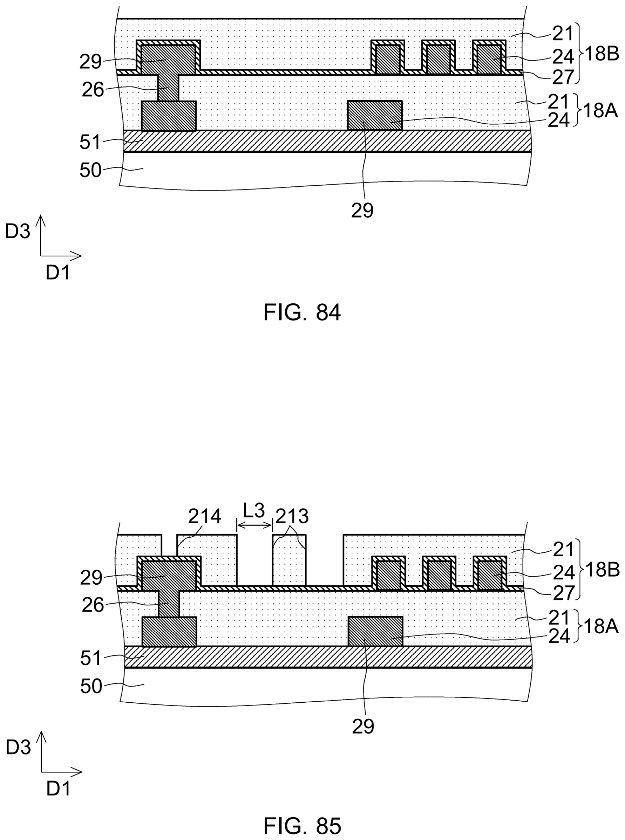

Fig. 84 is a cross-sectional view that shows a step of forming the inorganic layer 27 and organic layer 21 of the second wiring layer 18B in the third modification. In the third modification, as shown in Fig. 84, the organic layer 21 is formed on the inorganic layer 27 in a state where the first openings 273 and the second openings 274 are not formed.

Subsequently, as shown in Fig. 85, a step of forming the plurality of third openings 213 in the organic layer 21 of the second wiring layer 18B so as not to overlap the conductors 24 in plan view is performed. As shown in Fig. 85, the fourth openings 214 may be formed in the organic layer 21 simultaneously with the plurality of third openings 213.

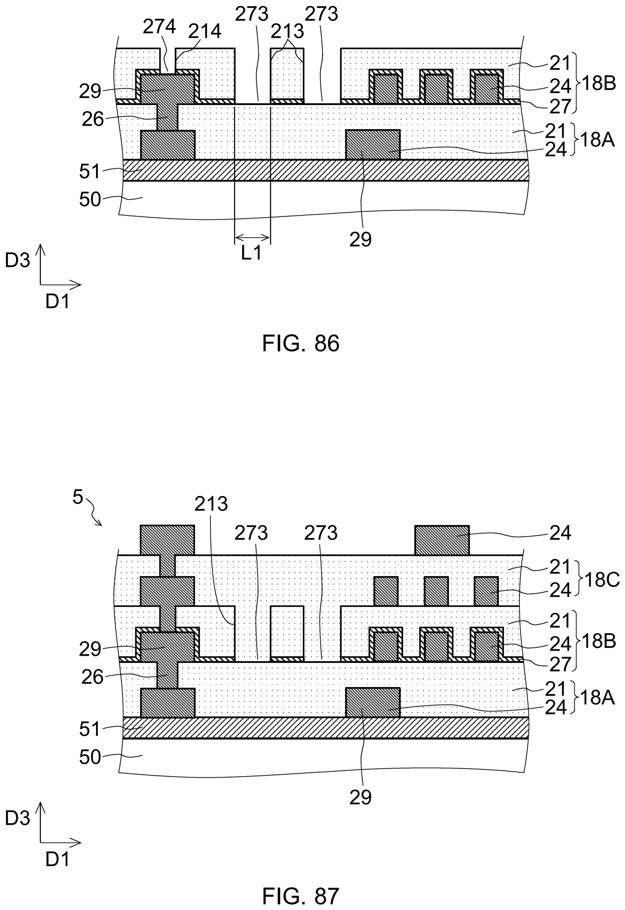

Subsequently, as shown in Fig. 86, a step of forming the plurality of first openings 273 in the inorganic layer 27 so as to overlap the plurality of third openings 213 in plan view is performed. For example, the plurality of first openings 273 is formed in the inorganic layer 27 by plasma etching. For example, by the action of plasma gas on the inorganic layer 27 exposed to the plurality of third openings 213, the plurality of first openings 273 is formed in the inorganic layer 27. In this case, the dimension L1 of the first opening 273 is equal to the dimension L3 of the third opening 213. The term "equal" means that, at the interface position between the organic layer 21 and the inorganic layer 27 in the third direction D3, the difference between the dimension L1 of the first opening 273 and the dimension L3 of the third opening 213 is less than or equal to 0.10 µm.

As shown in Fig. 86, the second openings 274 may be formed in the inorganic layer 27 simultaneously with the plurality of first openings 273. For example, by the action of plasma gas on the inorganic layer 27 exposed to the fourth openings 214, the second openings 274 are formed in the inorganic layer 27 simultaneously with the first openings 273.

Subsequently, as shown in Fig. 87, a third wiring step of forming a third wiring layer 18C on the second wiring layer 18B may be performed. The third wiring layer 18C includes the conductors 24 located on the organic layer 21 of the insulating layer 19 of the second wiring layer 18B and the insulating layer 19 including the organic layer 21 that at least partially covers the conductors 24.

As shown in Fig. 87, the organic layer 21 of the third wiring layer 18C may be in contact with the organic layer 21 of the first wiring layer 18A at the positions of the third openings 213 of the organic layer 21 and the first openings 273 of the inorganic layer 27 in the second wiring layer 18B. Gas generated within the organic layer 21 of the first wiring layer 18A can move to the organic layer 21 of the third wiring layer 18C through the first openings 273 and the third openings 213. As a result, retention of gas at the interface between the organic layer 21 of the first wiring layer 18A and the inorganic layer 27 of the second wiring layer 18B is suppressed. Gas may be discharged from the organic layer 21 of the third wiring layer 18C to the outside of the redistribution layer 18.

### (Fourth Modification)

In the above-described second embodiment, the example in which the second wiring layer 18B includes the inorganic layer 27 with the plurality of first openings 273 has been described. Although not shown in the drawing, the position of the wiring layer that includes the inorganic layer 27 with the plurality of first openings 273 is not limited. For example, the first wiring layer 18A may include the inorganic layer 27 with the plurality of first openings 273. For example, the third wiring layer 18C may include the inorganic layer 27 with the plurality of first openings 273.

The plurality of wiring layers may include the inorganic layer 27 with the plurality of first openings 273. For example, each of the second wiring layer 18B and the third wiring layer 18C may include the inorganic layer 27 with the plurality of first openings 273. For example, each of the first wiring layer 18A, the second wiring layer 18B, and the third wiring layer 18C may include the inorganic layer 27 with the plurality of first openings 273.

### (Fifth Modification)

In the above-described second embodiment, the example in which the wiring layer that includes the inorganic layer 27 with the plurality of first openings 273 is located on another wiring layer has been described. Although not shown in the drawing, the position of the wiring layer that includes the inorganic layer 27 with the plurality of first openings 273 is not limited. The wiring layer that includes the inorganic layer 27 with the plurality of first openings 273 may be located on an organic material layer not covering the conductors, such as a bonding layer and a sealing layer.

### (Sixth Modification)

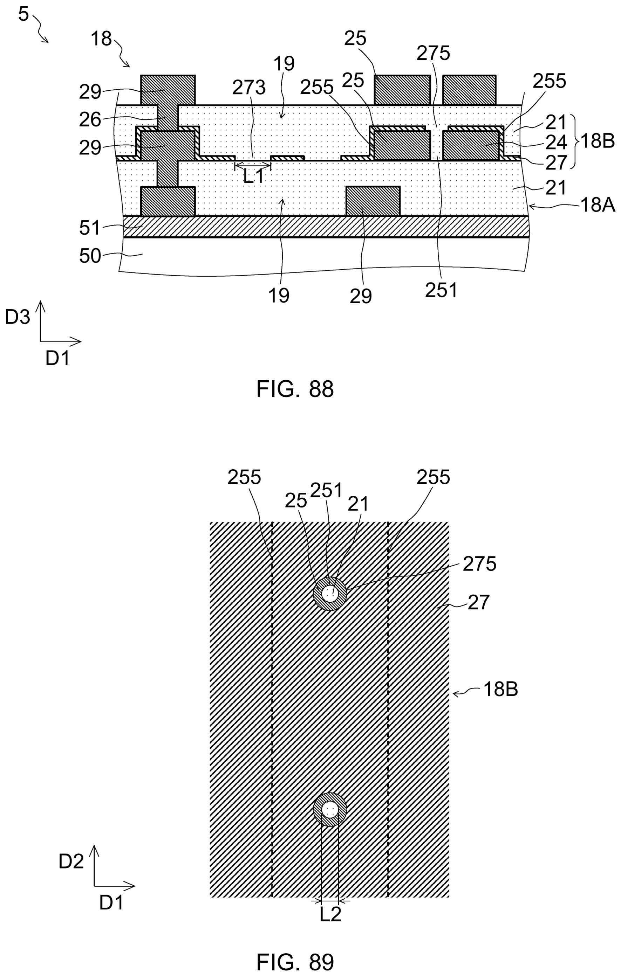

Fig. 88 is a cross-sectional view that shows the redistribution layer 18 in the sixth modification.

It is presumable that emission of gas generated within the organic layer 21 is blocked by the wires 25. For example, when the wire 25 of the second wiring layer 18B has a large width, it is presumable that flow of gas generated within the organic layer 21 of the first wiring layer 18A is obstructed by the wires 25 of the second wiring layer 18B. In consideration of such issues, as shown in Fig. 88, the wire 25 may include at least one opening 251 formed so as to overlap the organic layer 21. The opening 251 formed in the wire 25 is also referred to as a fifth opening. The wire 25 may include a plurality of the fifth openings 251.

According to this modification, retention of gas generated within the organic layer 21 at the interface between the organic layer 21 and the wires 25 can be suppressed. As a result, delamination of the wires 25 from the organic layer 21 can be suppressed.

Whether the fifth opening 251 is formed in the wire 25 may be determined based on the area of the wire 25. For example, when the wire 25 has an area greater than or equal to a threshold area, at least one fifth opening 251 may be formed in the wire 25. The threshold area is, for example, 2500 µm², may be 5000 µm², or may be 7500 µm².

Fig. 89 is a plan view that shows the second wiring layer 18B. The dashed lines indicated by reference sign 255 represent the side surfaces of the wire 25. When the wire 25 is covered by the inorganic layer 27, the inorganic layer 27 may include openings 275 that overlap the fifth openings 251 of the wire 25 in plan view. The openings 275 in the inorganic layer 27, overlapping the fifth openings 251, are also referred to as sixth openings. Each of the sixth openings 275 in the inorganic layer 27 may surround the fifth opening 251 of the wire 25 in plan view.

The sixth openings 275 in the inorganic layer 27 may be formed simultaneously with the first openings 273 in the step of forming the above-described first openings 273. The sixth openings 275 in the inorganic layer 27 may be formed in a step different from the step of forming the above-described first openings 273. The sixth openings 275 in the inorganic layer 27 may be formed simultaneously with the second openings 274 in the step of forming the above-described second openings 274. The sixth openings 275 in the inorganic layer 27 may be formed in a step different from the step of forming the above-described second openings 274. For example, a step of forming the inorganic layer 27, a step of forming the sixth openings 275 in the inorganic layer 27, a step of forming the organic layer 21 on the inorganic layer 27, a step of forming the fourth openings 214 in the organic layer 21, and a step of forming the second openings 274 in the inorganic layer 27 overlapping the fourth openings 214 may be sequentially performed.

As shown in Figs. 88 and 89, the organic layer 21 may be located inside the fifth openings 251 of the wires 25. The organic material is filled into the fifth openings 251 in the step of forming the organic layer 21, so the organic layer 21 is formed inside the fifth openings 251. The organic layer 21 inside the fifth openings 251 of the wires 25 of the second wiring layer 18B may be in contact with the organic layer 21 of the first wiring layer 18A. As the contact area between the organic layer 21 of the second wiring layer 18B and the organic layer 21 of the first wiring layer 18A increases, interlayer delamination is suppressed.

Since the sixth opening 275 in the inorganic layer 27 is larger than the fifth opening 251 in plan view, entry of air bubbles, fragments of the inorganic layer 27, or the like, into the fifth openings 251 during the step of filling the organic material into the fifth openings 251 is suppressed.

The dimension L2 of the fifth opening 251 of the wire 25 in plan view is set so that gas can appropriately pass through. The dimension L2 is, for example, greater than or equal to 1.0 µm, may be greater than or equal to 2.0 µm, and may be greater than or equal to 3.0 µm. The dimension L2 is, for example, less than or equal to 100 µm, may be less than or equal to 50 µm, may be less than or equal to 30 µm, and may be less than or equal to 20 µm.

### (Seventh Modification)

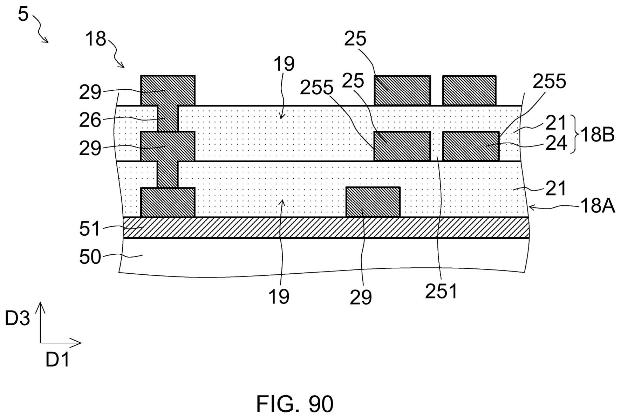

Fig. 90 is a cross-sectional view that shows the redistribution layer 18 in the seventh modification. The redistribution layer 18 shown in Fig. 90 is the same as the redistribution layer 18 shown in Fig. 88 except that the inorganic layer 27 of the second wiring layer 18B is not provided.

In this modification as well, similarly to the sixth modification, each of the wires 25 includes at least one opening 251 formed so as to overlap the organic layer 21. For this reason, retention of gas generated within the organic layer 21 at the interface between the organic layer 21 and the wires 25 can be suppressed. As a result, delamination of the wires 25 from the organic layer 21 can be suppressed.

### (Eighth Modification)

Fig. 91 is a cross-sectional view that shows the redistribution layer 18 in the eighth modification. As shown in Fig. 91, the inorganic layer 27 may be disposed only on and in the vicinity of the conductors 24, such as the pads 29 and the wires 25. In other words, as shown in Fig. 91, the inorganic layer 27 does not need to be disposed in a region that is located at a distance longer than or equal to K3 from the conductors 24 in the plane direction of the redistribution layer 18. The distance K3 is, for example, 2.0 µm, may be 5.0 µm, or may be 10.0 µm.

In the above-described second embodiment, the reason why the inorganic layer 27 is disposed over most of the organic layer 21 is that the inorganic layer 27 can adjust the stress of the array of wiring devices 5 or the entire wiring device 10 to alleviate warpage. When there is no need to dispose the inorganic layer 27 over most of the organic layer 21, such as when it is not necessary to alleviate warpage, the inorganic layer 27 is at least disposed in the vicinity of the conductors 24, such as the wires 25, and the inorganic layer 27 does not need to be disposed in other regions. As a result, it is possible to allow gas to pass more effectively.

Some modifications to the above-described second embodiment have been described; of course, it is also possible to apply a combination of a plurality of modifications as needed to the above-described second embodiment.

A part of the configuration of the above-described second embodiment may be combined with the configuration of the above-described first embodiment. For example, the first inorganic layer 27 of the wiring device 10 of the above-described first embodiment may include openings, such as the first openings 273, the second openings 274, and the sixth openings 275.

### (Third Embodiment)

The third embodiment relates to a wiring device and a manufacturing method for the wiring device.

A packaging technology that mounts a plurality of semiconductor elements with different functions, such as a CPU and a memory, with high density on a single wiring device has been attracting attention. The wiring device includes a redistribution layer that includes an insulating layer and a conductor including fine wires. For example, a wiring device and a manufacturing method therefor are described in PTL 3 (Japanese Unexamined Patent Application Publication No. 2022-109079). Wires are formed by, for example, a damascene process.

In the damascene process, first, recesses are formed in an insulating layer, and then metal material is embedded in the recesses. As a result, wires made of metal are formed in the recesses.

In the damascene process, the wires have cross-sectional shapes corresponding to the recesses in the insulating layer. For this reason, the degree of freedom of the cross-sectional shape of the wire is limited by the degree of freedom of the shape of the recess in the insulating layer. For example, when the depth of the recess in the insulating layer is limited, the height of the wire is also limited.

The third embodiment of the present disclosure aims to provide a wiring device and a manufacturing method for a wiring device, which can effectively solve such inconveniences.

The third embodiment of the present disclosure relates to the following [1] to [19].
[1] A wiring device includes:
   a base layer including a first surface and a second surface located opposite the first surface;
   a plurality of first wires located on the first surface of the base layer; and
   a first organic layer covering the plurality of first wires, wherein
   each of the first wires has an aspect ratio greater than or equal to 2.0 and less than or equal to 4.0.
[2] In the wiring device according to [1], each of the first wires may include a seed layer located on the first surface of the base layer and a body layer located on the seed layer.
[3] In the wiring device according to [1] or [2], each of the first wires may include a bottom portion facing the first surface of the base layer, a top portion located opposite the bottom portion in a thickness direction of the wiring device, a first side surface extending from the bottom portion toward the top portion, a second side surface extending from the top portion toward the bottom portion, and a connecting portion where the first side surface and the second side surface are connected. A second inclination angle that is an angle formed by the second side surface relative to a normal direction of the first surface may be larger than a first inclination angle that is an angle formed by the first side surface relative to the normal direction.
[4] In the wiring device according to [3], a ratio of the second inclination angle to the first inclination angle may be greater than or equal to 2.0.
[5] In the wiring device according to [3] or [4], a distance from a vertex of the top portion to the connecting portion in the thickness direction of the wiring device may be less than or equal to 0.20 times a height of each of the first wires.
[6] In the wiring device according to any one of [3] to [5], each of the first wires may have a first width at the bottom portion, may have a second width at an intermediate position between the bottom portion and a vertex of the top portion in the thickness direction of the wiring device, and may have a third width at the connecting portion, the second width may be less than the first width, and the third width may be less than the second width.
[7] In the wiring device according to [6], a ratio of the second width to the first width may be less than or equal to 0.98.
[8] In the wiring device according to [6] or [7], a ratio of the third width to the second width may be greater than a ratio of the second width to the first width.
[9] In the wiring device according to any one of [3] to [8], a surface roughness of the first side surface may be less than or equal to 50 nm.
[10] In the wiring device according to any one of [3] to [9], a ratio of a shortest distance from a virtual corner of each of the first wires to the second side surface to a width of the first wire may be greater than or equal to 0.05. The virtual corner is a point where a first virtual line and a second virtual line intersect, the first virtual line is a straight line that passes through a point where the bottom portion and the first side surface are connected and extends in the normal direction of the first surface, and the second virtual line is a straight line that passes through a vertex of the top portion and extends parallel to the first surface.
[11] The wiring device according to any one of [1] to [10] may further include a first inorganic layer located between a surface of each of the first wires and the first organic layer.
[12] In the wiring device according to [11], a thickness of the first inorganic layer located on the surface of each of the first wires may be greater than or equal to 50 nm and less than or equal to 400 nm.
[13] In the wiring device according to any one of [1] to [12], a width of each of the first wires may be greater than or equal to 0.5 µm and less than or equal to 2.0 µm.
[14] In the wiring device according to [13], in at least some of the plurality of first wires, a spacing between two adjacent ones of the first wires may be less than or equal to 2.0 µm.
[15] A manufacturing method for a wiring device includes:
   a step of preparing a support carrier;
   a step of forming a base layer on the support carrier;
   a step of forming a seed layer on the base layer;
   a step of forming a resist layer on the seed layer;
   a step of forming a body layer by electrolytic plating in an opening of the resist layer;
   a first removal step of removing the resist layer;
   a second removal step of removing the seed layer that does not overlap the body layer; and
   a step of forming a first organic layer covering the body layer.
[16] In the manufacturing method for a wiring device according to [15], the second removal step may include a step of etching the seed layer by ion milling.
[17] The manufacturing method for a wiring device according to [15] or [16] may further include a step of forming a first inorganic layer on a surface of a first wire including the seed layer and the body layer.

According to the third embodiment of the present disclosure, the cross-sectional shape of the wire can be appropriately controlled. For example, the wire may have an aspect ratio greater than or equal to 2.0 and less than or equal to 4.0.

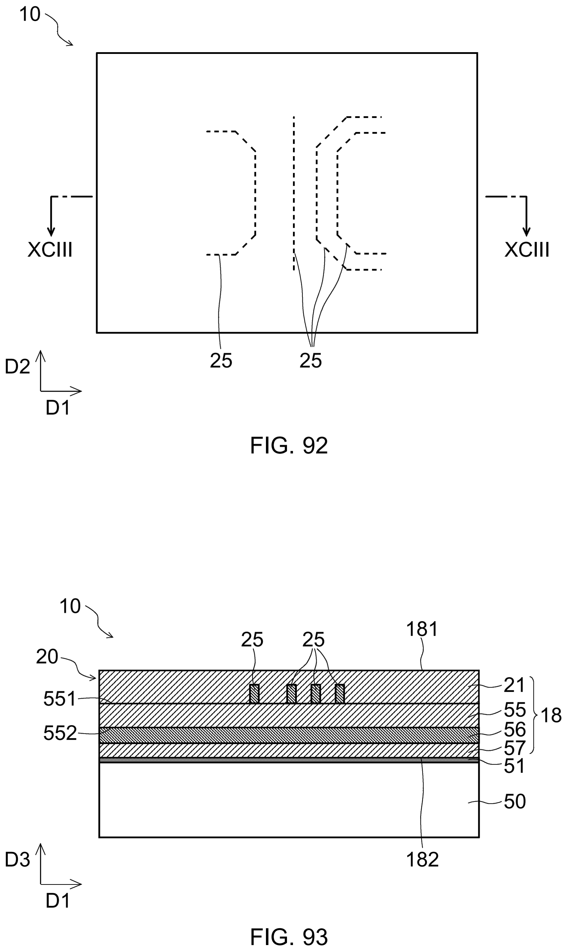

Fig. 92 is a plan view that shows an example of the wiring device 10. Fig. 93 is a cross-sectional view of the wiring device 10, taken along the line XCIII-XCIII in Fig. 92. The wiring device 10 has the first direction D1, the second direction D2, and the third direction D3. The first direction D1 and the second direction D2 are included in the plane direction of the wiring device 10. The first direction D1 is orthogonal to the second direction D2. The third direction D3 is a thickness direction of the wiring device 10. The third direction D3 is orthogonal to the first direction D1 and the second direction D2.

The wiring device 10 includes the redistribution layer 18. The wiring device 10 may include the support carrier 50.

The component elements of the wiring device 10 will be described.

### (Support Carrier)

The support carrier 50 is a member that supports the redistribution layer 18. The support carrier 50 faces the first wiring layer 20 of the redistribution layer 18. The support carrier 50 is configured to be peelable from the redistribution layer 18. The wiring device 10 may include the release layer 51 located between the support carrier 50 and the redistribution layer 18. As a result, the support carrier 50 can be more easily separated from the redistribution layer 18.

Examples of the support carrier 50 may include a glass substrate, a quartz substrate, a sapphire substrate, a resin substrate, a silicon substrate, a silicon carbide substrate, an alumina (Al2O3) substrate, an aluminum nitride (AIN) substrate, a zirconium oxide (ZrO2) substrate, a lithium niobate substrate, and a tantalum niobate substrate. The resin substrate may include an organic material. For example, the resin substrate may include epoxy resin, polyethylene, polypropylene, or the like. The thickness of the support carrier 50 is, for example, greater than or equal to 100 µm, may be greater than or equal to 200 µm, and may be greater than or equal to 500 µm. The thickness of the support carrier 50 is, for example, less than or equal to 2 mm, may be less than or equal to 1.5 mm, and may be less than or equal to 1 mm.

The release layer 51 may include a thermoplastic resin. In this case, by heating the wiring device 10, the release layer 51 is more easily separated from the redistribution layer 18. The release layer 51 may include a resin that has photosensitivity. In this case, by irradiating light onto the release layer 51, the release layer 51 is more easily separated from the redistribution layer 18. The thickness of the release layer 51 is, for example, greater than or equal to 0.3 µm, and may be greater than or equal to 1 µm. The thickness of the release layer 51 is, for example, less than or equal to 30 µm, and may be less than or equal to 50 µm.

### (Redistribution Layer)

The redistribution layer 18 includes the upper surface 181 and the lower surface 182. The lower surface 182 faces the support carrier 50. The lower surface 182 may be in contact with the release layer 51. The upper surface 181 is located on the side opposite from the lower surface 182 in the thickness direction.

The redistribution layer 18 includes at least the base layer 55 and the first wiring layer 20. The base layer 55 includes a first surface 551 and a second surface 552 located on the side opposite from the first surface 551. The first surface 551 faces the first wiring layer 20. The second surface 552 faces the support carrier 50.

The first wiring layer 20 includes the first organic layer 21 and the plurality of first wires 25. The plurality of first wires 25 is located on the first surface 551 of the base layer 55. The first organic layer 21 covers the plurality of first wires 25. The term "cover" means that the first organic layer 21 extends across the plurality of first wires 25 in plan view. The plan view means viewing a target in the normal direction of the first surface 551 of the base layer 55.

As shown in Fig. 92, the first wires 25 extend along the in-plane direction of the wiring device 10. The in-plane direction is a direction along a plane defined by the first direction D1 and the second direction D2.

The redistribution layer 18 may include a conductive layer 56 facing the second surface 552 of the base layer 55. The conductive layer 56 may extend over the entire region of the wiring device 10 in the in-plane direction of the wiring device 10. The conductive layer 56 may be a ground layer or a power supply layer.

The redistribution layer 18 may include an insulating layer 57 located between the conductive layer 56 and the release layer 51. The insulating layer 57 may constitute the lower surface 182 of the redistribution layer 18.

The component elements of the redistribution layer 18 will be described.

### [First Wiring Layer]

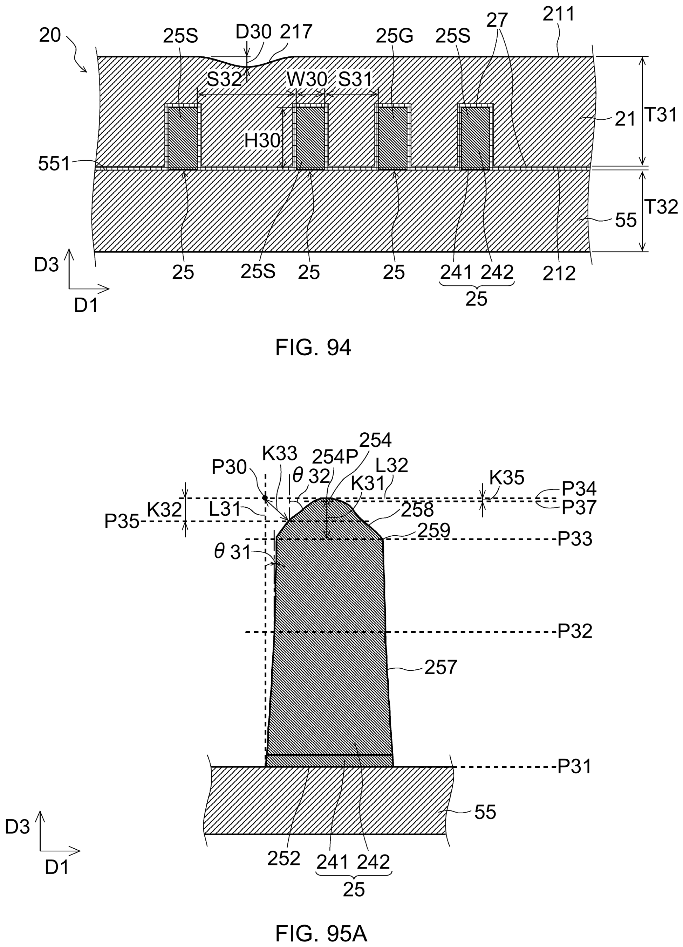

Fig. 94 is a cross-sectional view that shows the first wiring layer 20. The first wiring layer 20 includes at least the first organic layer 21 and the plurality of first wires 25. The first organic layer 21 includes the first upper surface 211 and the first lower surface 212. The first lower surface 212 faces the base layer 55. The first upper surface 211 is located on the side opposite from the first lower surface 212 in the thickness direction. The first organic layer 21 may cover the first wires 25. In other words, the first upper surface 211 of the first organic layer 21 may overlap the top portions of the first wires 25 in plan view.

The first organic layer 21 includes an organic material having insulating properties. Examples of the first organic layer 21 may include polyimide, epoxy-based resin, acrylic-based resin, and a combination of two or more of these resins. The thickness T31 of the first organic layer 21 is, for example, greater than or equal to 2 µm, may be greater than or equal to 3 µm, and may be greater than or equal to 5 µm. The thickness T31 of the first organic layer 21 is, for example, less than or equal to 20 µm, may be less than or equal to 15 µm, and may be less than or equal to 10 µm.

As shown in Fig. 94, a recess 217 may be formed in part of the first upper surface 211 of the first organic layer 21. The recess 217 may be formed so as not to overlap the first wires 25 in plan view. The recess 217 has a depth of D30. The depth D30 may be defined relatively to the height H30 of the first wire 25. D30/H30 that is the ratio of the depth D30 of the recess 217 to the height H30 of the first wire 25 is, for example, greater than or equal to 0.01, may be greater than or equal to 0.03, and may be greater than or equal to 0.05. D30/H30 is, for example, less than or equal to 0.20, may be less than or equal to 0.15, and may be less than or equal to 0.10.

Each of the first wires 25 has a width W30 and a height H30. Reference sign S31 represents the spacing between two adjacent first wires 25. The spacing S31 is measured between two first wires 25 extending parallel in plan view. The width W30 and the spacing S31 are measured in a direction orthogonal to the direction in which the first wire 25 extends in plan view.

As the width W30 and the spacing S31 are reduced, the wiring device 10 can be reduced in size. However, as the width W30 is reduced, the electrical conductivity of the first wire 25 decreases. For example, the electrical resistance of the first wire 25 per unit length increases. As the electrical resistance of the first wire 25 increases, the quality of a signal transmitted by the first wire 25 may degrade. The quality of a signal is, for example, evaluated by the width of the opening of the eye pattern of a high-frequency signal transmitted by the first wire 25.

When the width W30 is constant, the electrical conductivity of the first wire 25 can be enhanced as the height H30 is increased. For example, it is possible to reduce the electrical resistance of the first wire 25 per unit length. Therefore, even when the width W30 is small, the quality of a signal transmitted by the first wire 25 can be ensured by increasing the height H30.

A parameter calculated by dividing the height H30 by the width W30 is referred to as an aspect ratio. The aspect ratio of the first wire 25 is, for example, greater than or equal to 2.0, may be greater than or equal to 2.5, and may be greater than or equal to 3.0. On the other hand, when the aspect ratio is too large, the quality of a signal may degrade due to an increase in wire capacitance between a signal line and a ground line. In addition, when the aspect ratio is too large, it is also conceivable that noise is likely to be superimposed on a signal transmitted by a signal line due to an increase in crosstalk between signal lines. The aspect ratio of the first wire 25 is, for example, less than or equal to 4.5, and may be less than or equal to 4.0.

The width W30 of the first wire 25 is, for example, greater than or equal to 0.2 µm, may be greater than or equal to 0.5 µm, and may be greater than or equal to 1.0 µm. The width W30 is, for example, less than or equal to 3.0 µm, may be less than or equal to 2.5 µm, and may be less than or equal to 2.0 µm.

The minimum value of the spacing S31 between two first wires 25 is, for example, greater than or equal to 0.2 µm, may be greater than or equal to 0.5 µm, and may be greater than or equal to 1.0 µm. The minimum value of the spacing S31 is, for example, less than or equal to 3.0 µm, may be less than or equal to 2.5 µm, and may be less than or equal to 2.0 µm.

The minimum value of the spacing S31 may be defined relatively to the width W30. The ratio of the minimum value of the spacing S31 to the width W30 is, for example, greater than or equal to 0.5, may be greater than or equal to 0.7, and may be greater than or equal to 0.9. The ratio of the minimum value of the spacing S31 to the width W30 is, for example, less than or equal to 5.0, may be less than or equal to 3.0, and may be less than or equal to 2.0.

The height H30 of the first wire 25 is, for example, greater than or equal to 1.0 µm, may be greater than or equal to 2.0 µm, and may be greater than or equal to 3.0 µm. The height H30 is, for example, less than or equal to 10.0 µm, may be less than or equal to 7.0 µm, and may be less than or equal to 5.0 µm.

The first wiring layer 20 may include the first wires 25 that do not satisfy the above-described numeric ranges regarding aspect ratio, width W30, spacing S31, and height H30 in addition to the first wires 25 that satisfy the above-described numeric ranges.

As shown in Fig. 94, the first wires 25 may include signal lines 25S through which signals are transmitted, and a ground line 25G that has a ground potential. The minimum value of the above-described spacing S31 may be defined between the signal line 25S and the ground line 25G.

As shown in Fig. 94, the above-described recess 217 of the first organic layer 21 may be located between two signal lines 25S in plan view. The spacing between the two signal lines 25S is represented specifically by reference sign S32. The spacing S32 is, for example, greater than or equal to 2.0 µm, may be greater than or equal to 3.0 µm, and may be greater than or equal to 4.0 µm.

The frequency of a signal transmitted by the first wire 25 is preferably such that the skin effect does not occur. As a result, an increase in the aspect ratio of the first wire 25 is likely to lead to an improvement in the quality of a signal. The maximum frequency of a signal is, for example, lower than or equal to 16 GHz, may be lower than or equal to 12 GHz, and may be lower than or equal to 8 GHz. The maximum frequency of a signal is, for example, higher than or equal to 0.5 GHz, and may be higher than or equal to 1.0 GHz.

As shown in Fig. 94, each of the first wires 25 may include the seed layer 241 and the body layer 242. The seed layer 241 is a layer having electrical conductivity and formed by physical film deposition, such as sputtering. The seed layer 241 may be located on the first surface 551 of the base layer 55. The body layer 242 is a layer having electrical conductivity and formed on the seed layer 241 by electrolytic plating.

The seed layer 241 may include a metal material, such as copper, nickel, titanium, chromium, and zinc. The seed layer 241 may include a compound of these metal materials. The seed layer 241 may include a plurality of layers. The body layer 242 may include a metal, such as copper, gold, silver, platinum, rhodium, tin, aluminum, nickel, titanium, chromium, and zinc, or an alloy using one or more of these metals.

As shown in Fig. 94, the first wiring layer 20 may include the first inorganic layer 27 located between the surfaces of the first wires 25 and the first organic layer 21. The first inorganic layer 27 may be in contact with the surfaces of the first wires 25. The first inorganic layer 27 can act to protect the first wires 25. For example, the first inorganic layer 27 can suppress occurrence of electromigration in the first wires 25.

As shown in Fig. 94, the first inorganic layer 27 may include a portion located between the first lower surface 212 of the first organic layer 21 and the first surface 551 of the base layer 55 in addition to portions located between the surfaces of the first wires 25 and the first organic layer 21. The first inorganic layer 27 may be in contact with the first lower surface 212 of the first organic layer 21. The first inorganic layer 27 may be in contact with the first surface 551 of the base layer 55.

The first inorganic layer 27 includes an inorganic insulating material. Examples of the inorganic insulating material include silicon nitride and silicon oxide. The first inorganic layer 27 may include a silicon nitride layer and a silicon oxide layer. In other words, the first inorganic layer 27 may include two layers each including an inorganic insulating material. At least one of the two layers may include an inorganic insulating material other than silicon nitride and silicon oxide. The first inorganic layer 27 may include three or more layers each including an inorganic insulating material. Two layers of the three or more layers may be a silicon nitride layer and a silicon oxide layer.

### [Base Layer]

The base layer 55 is a layer that supports the first wiring layer 20. The base layer 55 includes a material having insulating properties. The base layer 55 may include an organic material having insulating properties. Examples of the base layer 55 may include polyimide, epoxy-based resin, acrylic-based resin, and a combination of two or more of these resins. The thickness T32 of the base layer 55 is, for example, greater than or equal to 2 µm, may be greater than or equal to 3 µm, and may be greater than or equal to 5 µm. The thickness T32 of the base layer 55 is, for example, less than or equal to 20 µm, may be less than or equal to 15 µm, and may be less than or equal to 10 µm. The thickness T32 of the base layer 55 may be greater than the thickness T31 of the first organic layer 21 or may be less than the thickness T31 of the first organic layer 21.

### [Conductive Layer]

The conductive layer 56 includes a material having electrical conductivity. Examples of the conductive layer 56 may include metals, such as copper, gold, silver, platinum, rhodium, tin, aluminum, nickel, titanium, chromium, and zinc, and alloys using one or more of these metals. The first wires 25, the base layer 55, and the conductive layer 56 may constitute a microstrip for transmitting high-frequency signals. The thickness of the conductive layer 56 is, for example, greater than or equal to 1 µm, may be greater than or equal to 2 µm, and may be greater than or equal to 3 µm. The thickness T32 of the conductive layer 56 may be, for example, less than or equal to 20 µm, may be less than or equal to 15 µm, may be less than or equal to 10 µm, and may be less than or equal to 5 µm.

### [Insulating Layer]

The insulating layer 57 includes a material having insulating properties. The insulating layer 57 may include an organic insulating material or may include an inorganic insulating material.

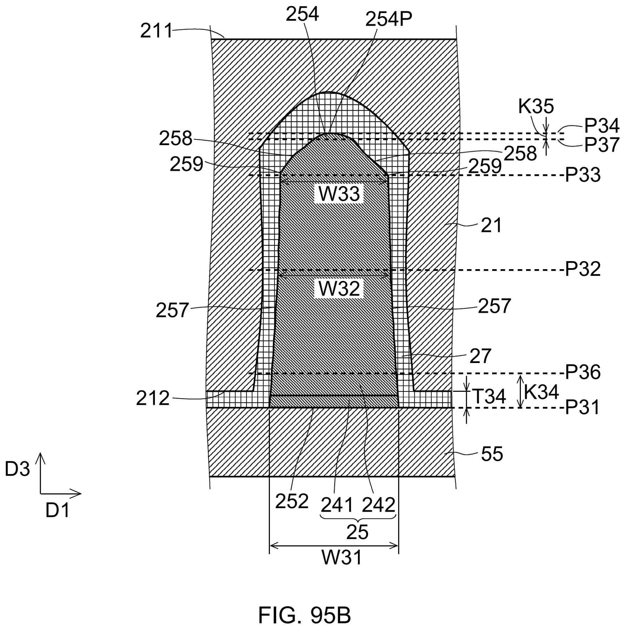

Next, the configuration of the first wire 25 and the first inorganic layer 27 will be described in detail. Figs. 95A and 95B are cross-sectional views that show an example of the first wire 25. In Fig. 95A, the first organic layer 21 and the first inorganic layer 27 are omitted. The cross-sectional views shown in Figs. 95A and 95B are views of the first wire 25, taken in a direction orthogonal to the direction in which the first wire 25 extends in plan view.

The shape of the first wire 25 will be described with reference to Fig. 95A. The surface of the first wire 25 may include a bottom portion 252, a top portion 254, a first side surface 257, a second side surface 258, and a connecting portion 259. The bottom portion 252 faces the first surface 551 of the base layer 55. The top portion 254 is located on the side opposite from the bottom portion 252 in the thickness direction. The top portion 254 includes a vertex 254P. The vertex 254P is a portion of the first wire 25 that is farthest from the bottom portion 252 in the thickness direction.

The first side surface 257 is a surface that extends from the bottom portion 252 toward the top portion 254. The first side surface 257 is connected to the bottom portion 252 but is not connected to the top portion 254. The second side surface 258 is a surface that extends from the top portion 254 toward the bottom portion 252. The second side surface 258 is connected to the top portion 254 but is not connected to the bottom portion 252. The first side surface 257 and the second side surface 258 are connected at the connecting portion 259.

In Fig. 95A, reference signs P31 to P35, and P37 represent the positions of the first wire 25 in the thickness direction, respectively. The first position P31 is a position of the bottom portion 252. The second position P32 is an intermediate position between the bottom portion 252 and the vertex 254P in the thickness direction. The third position P33 is a position of the connecting portion 259. When the positions of the two connecting portions 259 appearing in the cross-sectional view differ in the thickness direction, the position of the connecting portion 259 closer to the bottom portion 252 is defined as the third position P33. The fourth position P34 is a position of the vertex 254P. The fifth position P35 is a position at a distance K32 away from the vertex 254P in the thickness direction. The fifth position P35 is included in the second side surface 258. As will be described later, the fifth position P35 is used to define the inclination angle of the second side surface 258. The seventh position P37 is a position at a distance K35 away from the vertex 254P in the thickness direction. The seventh position P37 is used to define the range of the top portion 254 in the thickness direction. In other words, the top portion 254 is defined as a portion of the first wire 25 where the distance from the vertex 254P in the thickness direction is shorter than or equal to the distance K35. The distance K35 is defined relatively to the height H30 of the first wire 25. Specifically, the distance K35 is 0.01 times the height H30 of the first wire 25.

The distance K32 that determines the fifth position P35 is defined relatively to the height H30 of the first wire 25. Specifically, the distance K32 is 0.07 times the height H30 of the first wire 25.

The above-described height H30 of the first wire 25 is defined as the distance between the bottom portion 252 and the vertex 254P of the top portion 254 in the thickness direction. In other words, the height H30 is the distance between the first position P31 and the fourth position P34. The above-described width W30 of the first wire 25 is defined at the intermediate position between the bottom portion 252 and the vertex 254P of the top portion 254 in the thickness direction. In other words, the width W30 is measured at the second position P32.

In Fig. 95A, reference sign K31 represents the distance between the third position P33 and the fourth position P34. In other words, the distance K31 is the distance between the vertex 254P of the top portion 254 and the connecting portion 259 in the thickness direction. The distance K31 may be shorter than the distance between the bottom portion 252 and the connecting portion 259 in the thickness direction. The range of the distance K31 may be defined relatively to the height H30 of the first wire 25. K31/H30 that is the ratio of the distance K31 to the height H30 of the first wire 25 is, for example, less than or equal to 0.30, may be less than or equal to 0.25, may be less than or equal to 0.20, may be less than or equal to 0.15, and may be less than or equal to 0.10. K31/H30 is, for example, greater than or equal to 0.05, may be greater than or equal to 0.10, and may be greater than or equal to 0.15.

As shown in Fig. 95A, the first side surface 257 and the second side surface 258 may extend in a direction inclined relative to the normal direction of the first surface 551 of the base layer 55. The first side surface 257 and the second side surface 258 may be inclined such that the width of the first wire 25 decreases from the bottom portion 252 toward the top portion 254. In other words, the first wire 25 may have a forward tapered shape.

Since the first wire 25 has a forward tapered shape, the first inorganic layer 27 is more easily formed on the surface of the first wire 25 in the step of forming the first inorganic layer 27. For this reason, the thickness of the first inorganic layer 27 can be reduced. This is because, when the first inorganic layer 27 is difficult to be formed on the surface of the first wire 25, the time used for the forming step to form the first inorganic layer 27 without gaps on the surface of the first wire 25 increases, and the thickness of the first inorganic layer 27 also increases. The small thickness of the first inorganic layer 27 can contribute to an improvement in the quality of a signal transmitted by the first wire 25.

Since the first wire 25 has a forward tapered shape, the width of the first wire 25 in the vicinity of the top portion 254 can be reduced. For this reason, it is possible to suppress the degradation of the quality of a signal due to capacitive coupling in the thickness direction and/or in-plane direction. In the thickness direction, the small width of the first wire 25 in the vicinity of the top portion 254 can contribute to a reduction in capacitive coupling. In the in-plane direction, the wide spacing between two adjacent first wires 25 can contribute to a reduction in capacitive coupling. Since the width of the first wire 25 at the bottom portion 252 is large, the adhesion of the first wire 25 to the base layer 55 can be ensured. For this reason, it is possible to suppress collapse of the first wire 25 during the manufacturing process of the wiring device 10.

The angle formed by the first side surface 257 relative to the normal direction of the first surface 551 of the base layer 55 is also referred to as a first inclination angle θ31. The angle formed by the second side surface 258 relative to the normal direction of the first surface 551 of the base layer 55 is also referred to as a second inclination angle θ32. The first inclination angle θ31 is defined as the inclination angle of the first side surface 257 at the second position P32. The second inclination angle θ32 is defined as the angle formed by a virtual straight line, connecting a point on the second side surface 258 at the fifth position P35 and the center of the top portion 254 in the first direction D1, relative to the normal direction of the first surface 551.

The second inclination angle θ32 may be larger than the first inclination angle θ31. θ32/θ31 that is the ratio of the second inclination angle θ32 to the first inclination angle θ31 is, for example, greater than or equal to 2.0, may be greater than or equal to 3.0, and may be greater than or equal to 5.0. θ32/θ31 is, for example, less than or equal to 30, may be less than or equal to 20, may be less than or equal to 10, and may be less than or equal to 5.

The first inclination angle θ31 is, for example, larger than or equal to 1.0°, may be larger than or equal to 2.0°, and may be larger than or equal to 3.0°. The first inclination angle θ31 is, for example, smaller than or equal to 5.0°, may be smaller than or equal to 4.0°, and may be smaller than or equal to 3.0°.

The second inclination angle θ32 is, for example, larger than or equal to 10°, may be larger than or equal to 15°, and may be larger than or equal to 20°. The second inclination angle θ32 is, for example, smaller than or equal to 60°, may be smaller than or equal to 50°, and may be smaller than or equal to 40°.

As will be described later, the top portion 254, first side surface 257, second side surface 258, and connecting portion 259 of the first wire 25 are formed, for example, by irradiating an ion beam onto the first wire 25 having a substantially rectangular cross-sectional shape. The first side surface 257 has a smoother surface compared to when the first side surface 257 is exposed to wet etching solution. The surface roughness of the first side surface 257 is, for example, less than or equal to 50 nm, may be less than or equal to 40 nm, and may be less than or equal to 30 nm. The surface roughness of the first side surface 257 is, for example, greater than or equal to 5 nm, may be greater than or equal to 10 nm, and may be greater than or equal to 15 nm.

The surface roughness of the first side surface 257 is calculated by averaging the measurement results of the surface roughness of the first side surface 257 at the first position P31, the second position P32, and the third position P33. The surface roughness at the first position P31 is measured by averaging the distances between a plurality of peaks and valleys appearing in the cross-sectional image of the first side surface 257 over a certain range in the thickness direction, including the first position P31. The surface roughness at the second position P32 is measured by averaging the distances between a plurality of peaks and valleys appearing in the cross-sectional image of the first side surface 257 over a certain range in the thickness direction, including the second position P32. The surface roughness at the third position P33 is measured by averaging the distances between a plurality of peaks and valleys appearing in the cross-sectional image of the first side surface 257 over a certain range in the thickness direction, including the third position P33. The certain range is a range of 0.1 times the height H30 of the first wire 25 in the thickness direction.

In Fig. 95A, reference sign P30 represents a virtual corner of the first wire 25. The virtual corner P30 is a point where the first virtual line L31 and the second virtual line L32 intersect. The first virtual line L31 is a straight line that passes through the point where the bottom portion 252 and the first side surface 257 are connected and extends in the normal direction of the first surface 551 of the base layer 55. The second virtual line L32 is a straight line that passes through the vertex 254P of the top portion 254 and extends parallel to the first surface 551 of the base layer 55. Since the first wire 25 has a forward tapered shape, the virtual corner P30 does not overlap the first wire 25.

The virtual corner P30 is preferably sufficiently far from the second side surface 258. As a result, it is possible to suppress capacitive coupling in the thickness direction and/or in-plane direction. The shortest distance K33 from the virtual corner P30 to the second side surface 258 may be defined relatively to the width W30 of the first wire 25. K33/W30 that is the ratio of the shortest distance K33 to the width W30 is, for example, greater than or equal to 0.05, may be greater than or equal to 0.10, and may be greater than or equal to 0.15. K33/W30 is, for example, less than or equal to 0.50, may be less than or equal to 0.35, and may be less than or equal to 0.20.

Next, the shapes of the first wire 25 and the first inorganic layer 27 will be described with reference to Fig. 95B. The first wire 25 has a first width W31 at the bottom portion 252, that is, at the first position P31. The first wire 25 has a second width W32 at the intermediate position between the bottom portion 252 and the vertex 254P of the top portion 254, that is, at the second position P32. The first wire 25 has a third width W33 at the connecting portion 259, that is, at the third position P33. The second width W32 may be less than the first width W31. The third width W33 may be less than the second width W32.

W32/W31 that is the ratio of the second width W32 to the first width W31 is, for example, less than or equal to 0.99, may be less than or equal to 0.95, and may be less than or equal to 0.93. W32/W31 is, for example, greater than or equal to 0.80, may be greater than or equal to 0.85, and may be greater than or equal to 0.90.

W33/W32 that is the ratio of the third width W33 to the second width W32 may be greater than the above-described W32/W31. In other words, the inclination angle of the first side surface 257 between the second position P32 and the third position P33 may be smaller than the inclination angle of the first side surface 257 between the first position P31 and the second position P32. W33/W32 is, for example, less than or equal to 0.99, may be less than or equal to 0.95, and may be less than or equal to 0.90. W33/W32 is, for example, greater than or equal to 0.80, may be greater than or equal to 0.83, and may be greater than or equal to 0.85.

The first inorganic layer 27 will be described. The first inorganic layer 27 may be in contact with the top portion 254, first side surface 257, second side surface 258, and connecting portion 259 of the first wire 25. The first inorganic layer 27 does not need to be in contact with the bottom portion 252.

The thickness of the first inorganic layer 27 is preferably small. As the thickness of the first inorganic layer 27 decreases, it is possible to suppress the degradation of the quality of a signal due to capacitive coupling. The thickness of the first inorganic layer 27 is, for example, greater than or equal to 40 nm, may be greater than or equal to 50 nm, may be greater than or equal to 100 nm, and may be greater than or equal to 150 nm. The thickness of the first inorganic layer 27 is, for example, less than or equal to 500 nm, may be less than or equal to 400 nm, may be less than or equal to 350 nm, may be less than or equal to 300 nm, and may be less than or equal to 200 nm.

The thickness of the first inorganic layer 27 is calculated by averaging the measurement results of the thickness of the first inorganic layer 27 at the first position P31, the second position P32, and the sixth position P36. The sixth position P36 is a position at a distance K34 from the bottom portion 252 in the thickness direction. The distance K34 is twice the thickness T34 of the first inorganic layer 27 located on the base layer 55.

### (Manufacturing Method for Wiring Device)

Next, a manufacturing method for the wiring device 10 will be described.

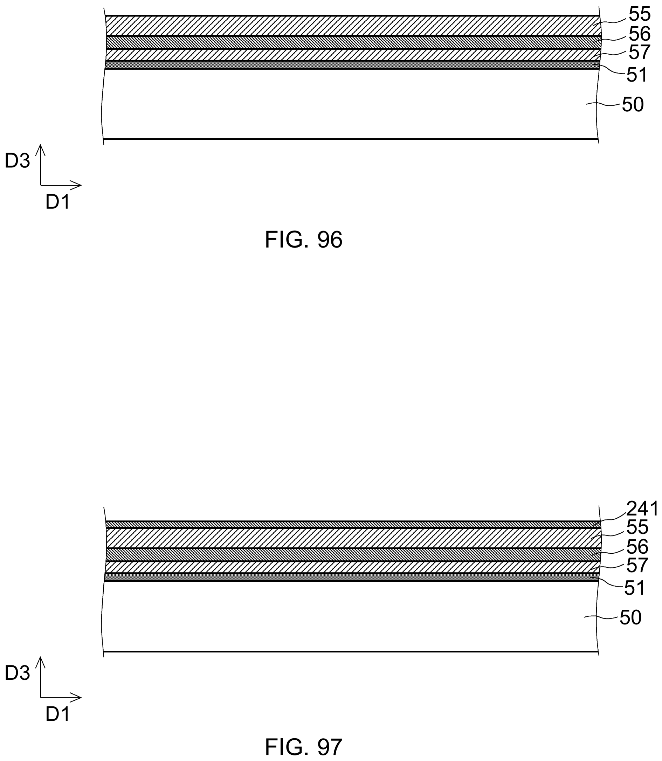

First, as shown in Fig. 96, the support carrier 50 is prepared. Subsequently, the release layer 51 is formed on the support carrier 50. Subsequently, the insulating layer 57, the conductive layer 56, and the base layer 55 are sequentially formed on the release layer 51.

Subsequently, as shown in Fig. 97, the seed layer 241 is formed on the base layer 55. For example, the seed layer 241 is formed through a sputtering step.

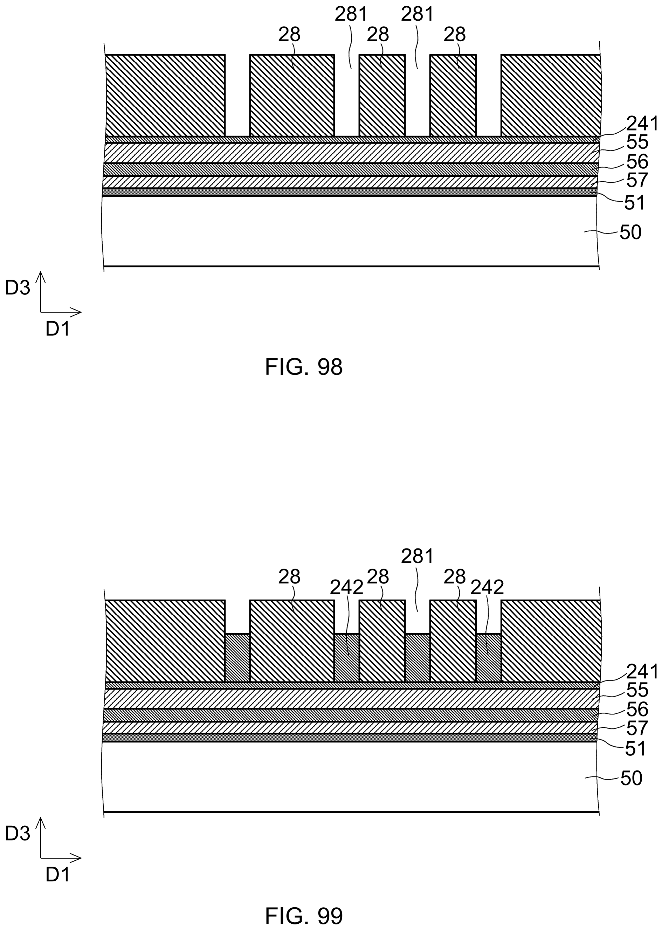

After the seed layer 241 is formed, the first resist layer 28 is formed on the seed layer 241, as shown in Fig. 98. The first resist layer 28 has the openings 281 that penetrate the first resist layer 28 in the thickness direction. Each of the openings 281 has a shape corresponding to the first wire 25 in plan view.

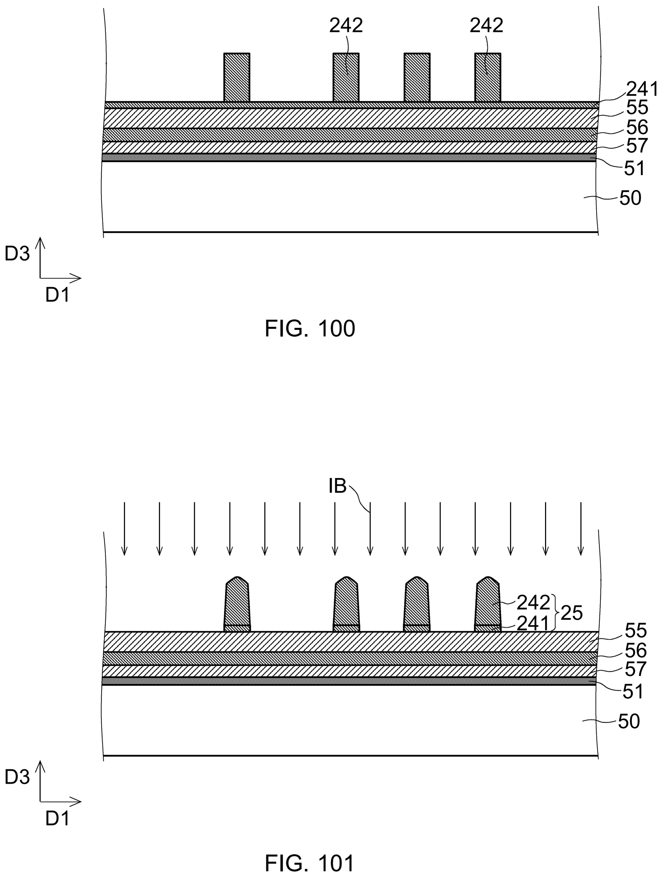

Subsequently, the plating step is performed. In the plating step, as shown in Fig. 99, the body layers 242 are formed in the openings 281 by electrolytic plating. Subsequently, as shown in Fig. 100, a first removal step of removing the first resist layer 28 is performed. For example, by using an organic solvent or an alkaline solution, the first resist layer 28 is peeled from the seed layer 241.

Subsequently, as shown in Fig. 101, a second removal step of removing portions of the seed layer 241 that do not overlap the body layer 242 is performed. As a result, two adjacent body layers 242 are electrically insulated.

The second removal step may include a step of etching the seed layer 241 by ion milling. In ion milling, as shown in Fig. 101, an ion beam IB is irradiated onto the seed layer 241 that does not overlap the body layers 242 to etch the seed layer 241. The ion beam IB is, for example, a beam of argon ions. The first wires 25 each including the seed layer 241 and the body layer 242 are obtained by removing an unnecessary part of the seed layer 241.

The ion beam IB is irradiated onto not only the seed layer 241 but also the body layers 242. The body layers 242 are etched by the ion beam IB to achieve the above-described forward tapered shape.

Wet etching has been generally used as a method of removing an unnecessary part of the seed layer 241. In wet etching, the seed layers 241 overlapping the body layers 242 are also etched by side etching. As a result, the contact area between the base layer 55 and each of the first wires 25 decreases.

In the present embodiment, since an unnecessary part of the seed layer 241 is removed by ion milling, it is possible to suppress a reduction in the contact area between the base layer 55 and each of the first wires 25. Therefore, the adhesion of the first wires 25 to the base layer 55 can be ensured. For this reason, for example, it is possible to suppress collapse of the first wires 25 in the manufacturing process of the wiring device 10.

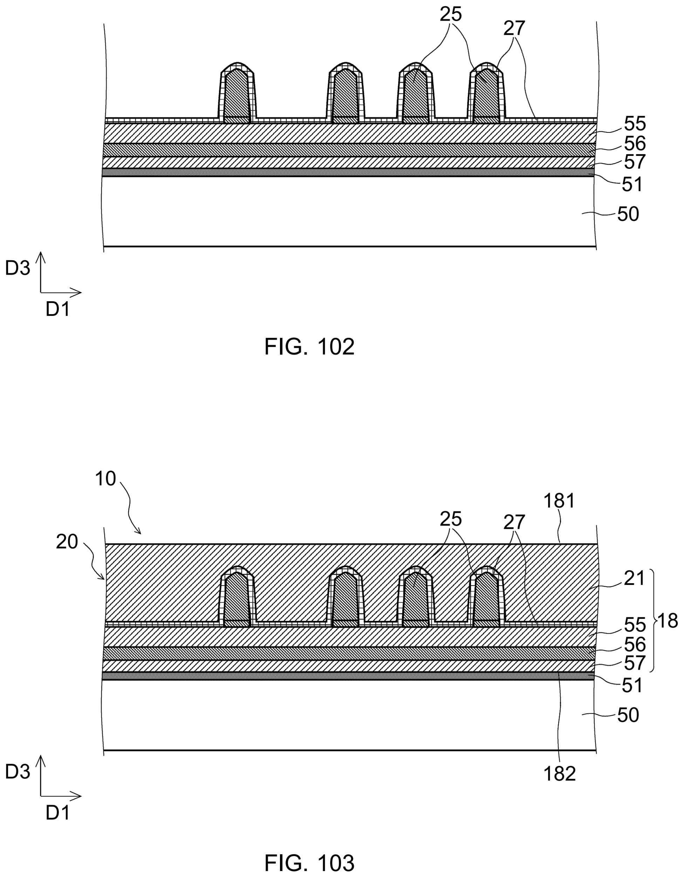

Subsequently, as shown in Fig. 102, a step of forming the first inorganic layer 27 on the surfaces of the first wires 25 is performed. Examples of the method of forming the first inorganic layer 27 include a plasma CVD method, a thermal CVD method, a sputtering method, and a vapor deposition method. Since each of the first wires 25 has a forward tapered shape, the first inorganic layer 27 is more easily formed on the surfaces of the first wires 25.

Subsequently, as shown in Fig. 103, a step of forming the first organic layer 21 is performed. As a result, the wiring device 10 including the base layer 55, the plurality of first wires 25, and the first organic layer 21 is obtained. The wiring device 10 may be distributed in a state where the wiring device 10 includes the support carrier 50. In other words, the wiring device 10 may be distributed in a state where the redistribution layer 18 is supported by the support carrier 50.

The first organic layer 21 may be formed by sticking a film including an organic material, such as polyimide, onto the first wires 25. The first organic layer 21 may be formed by applying a solution containing an organic material, such as polyimide, onto the first wires 25.

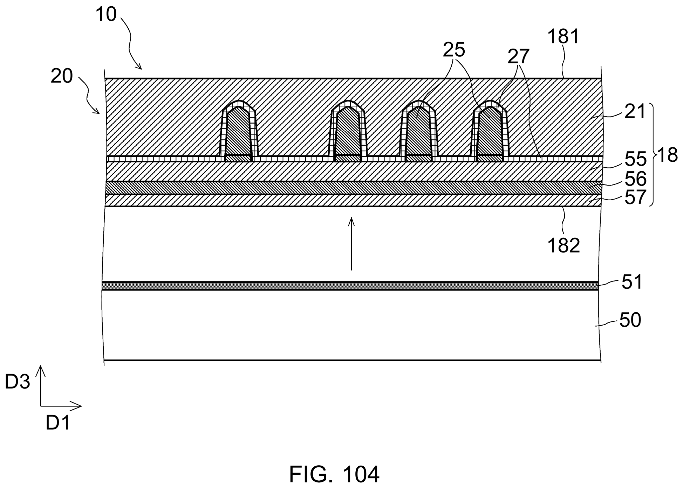

As shown in Fig. 104, a step of separating the redistribution layer 18 from the support carrier 50 may be performed. In other words, the wiring device 10 may be distributed in a state where the wiring device 10 does not include the support carrier 50.

According to the present embodiment, the cross-sectional shape of each of the first wires 25 can be appropriately controlled compared to the case where the first wires 25 are formed by a damascene process. For example, each of the first wires 25 may have an aspect ratio greater than or equal to 2.0 and less than or equal to 4.0. Therefore, even when the width W30 of the first wire 25 is small, the quality of a signal transmitted by the first wire 25 can be ensured.

In the damascene process, after the wire is formed in the recess of the insulating layer, the insulating layer remains in a final product as a layer that is in contact with the side surface of the wire. In contrast, in the present embodiment, the first resist layer 28 is removed after the first wires 25 are formed. In the present embodiment, the layer that is in contact with the side surface of the first wire 25 is formed after the first wire 25 is formed. Therefore, compared to the case where the damascene process is used, the degree of freedom in selecting the layer that is in contact with the side surface of the first wire 25 is high. For example, as described above, the first wiring layer 20 can include the first inorganic layer 27 that is in contact with the top portion 254, first side surface 257, second side surface 258, and connecting portion 259 of the first wire 25 but is not in contact with the bottom portion 252.

According to the present embodiment, since an unnecessary part of the seed layer 241 is removed by ion milling, it is possible to suppress side etching of the seed layer 241. Each of the first wires 25 may have a forward tapered shape.

The above-described embodiment can be variously modified. Hereinafter, modifications will be described with reference to the drawings as needed. In the following description and the drawings used in the following description, like reference signs to the reference signs used for corresponding portions in the above-described embodiment are used for portions that can be similarly configured to those of the above-described embodiment. Repeated descriptions are omitted. When the operation and advantageous effects obtained in the above-described embodiment are also apparently obtained in the modifications, the description thereof may be omitted.

### (First Modification)

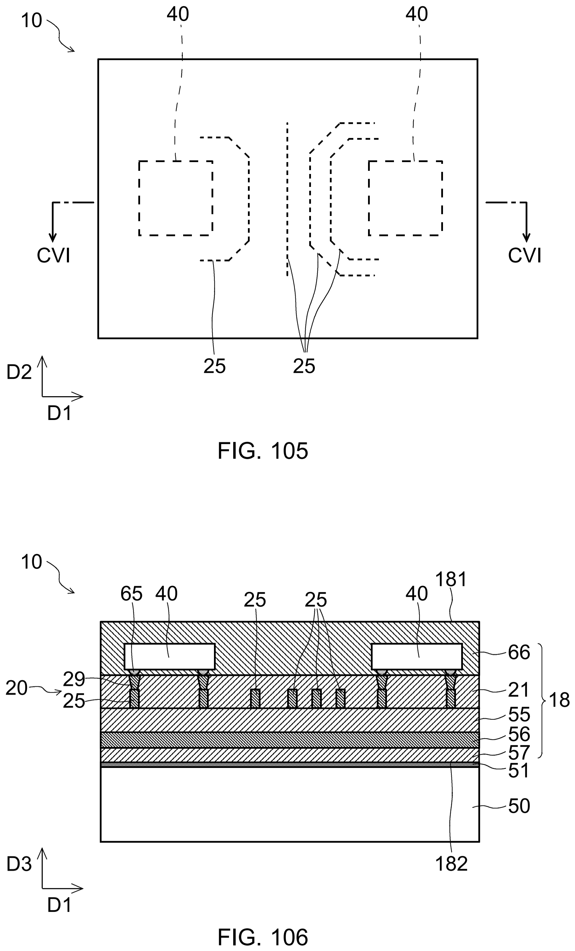

Fig. 105 is a plan view that shows the wiring device 10 in the first modification. Fig. 106 is a cross-sectional view of the wiring device 10, taken along the line CVI-CVI in Fig. 105. The wiring device 10 may include the semiconductor element 40. The semiconductor element 40 is electrically connected to the wires of the redistribution layer 18, such as the first wires 25. The semiconductor element 40 may be electrically connected to the wires of the redistribution layer 18, such as the first wires 25, via bumps 65.

The semiconductor element 40 includes transistors formed of a semiconductor, such as silicon. Examples of the semiconductor element 40 include a CPU, a GPU, an FPGA, a sensor, and a memory. The semiconductor element 40 may be a chiplet into which a semiconductor element, such as a CPU, a GPU, an FPGA, a sensor, and a memory, is separated by function. The semiconductor element 40 may include a plurality of laminated substrates. The number of semiconductor elements 40 may be one for the single wiring device 10 and may be two or more for the single wiring device 10. When the number of semiconductor elements 40 is two or more for the single wiring device 10, the semiconductor elements 40 may have the same function or may have different functions.

The redistribution layer 18 may include first conductive layers 29 overlapping the first wires 25. For example, openings are formed at portions of the first organic layer 21 overlapping the first wires 25, and then the first conductive layers 29 are formed inside the openings. The first conductive layers 29 may be pads where bumps are provided.

The wiring device 10 may include a molding resin layer 66 that is in contact with the semiconductor elements 40. The molding resin layer 66 may cover the semiconductor elements 40.

The molding resin layer 66 includes a resin. The molding resin layer 66 may include, for example, any one of polyimide, epoxy resin, acrylic, bismaleimide, polybenzoxazole, and benzocyclobutene, or a combination of two or more of these resins. The molding resin layer 66 may include a thermosetting resin, such as an epoxy-based resin.

### (Second Modification)

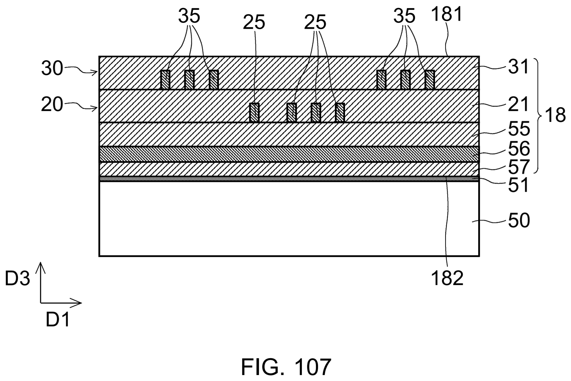

Fig. 107 is a cross-sectional view that shows the wiring device 10 in the second modification. The wiring device 10 may include the second wiring layer 30 adjacent to the first wiring layer 20 in the thickness direction.

The second wiring layer 30 includes the second organic layer 31 and the plurality of second wires 35. The plurality of second wires 35 may be located on the first upper surface 211 of the first organic layer 21. The second organic layer 31 covers the plurality of second wires 35.

The second organic layer 31 includes an organic material having insulating properties. The material of the above-described first organic layer 21 may be adopted as the material of the second organic layer 31. The numeric ranges of the thickness of the above-described first organic layer 21 may be adopted as the numeric ranges of the thickness of the second organic layer 31.

The second wires 35 include a material having electrical conductivity, similarly to the first wires 25. Each of the second wire 35 may include a seed layer and a body layer, similarly to the first wires 25. The numeric ranges of the widths, heights, and spacings of the above-described first wires 25 may be adopted as the numeric ranges of the widths, heights, and spacings of the second wires 35. Each of the second wires 35 may include the bottom portion, the top portion, the first side surface, the second side surface, and the connecting portion, similarly to the first wires 25.

### (Third Modification)

In the above embodiment, an example in which the redistribution layer 18 is supported by the support carrier 50 has been described. The support carrier 50 is a member that becomes a base in the manufacturing process of the redistribution layer 18. Although not shown in the drawing, the redistribution layer 18 may be supported by a substrate other than the support carrier 50. For example, the redistribution layer 18 may be located on the first surface or second surface of a core substrate. The core substrate may include a through via extending from the first surface to the second surface. At least some of the plurality of the first wires 25 of the redistribution layer 18 may be electrically connected to the through vias of the core substrate.

The core substrate may be one of the component elements of the wiring device 10. For example, the wiring device 10 may include a core substrate that includes through vias and the redistribution layer 18 located on the first surface or second surface of the core substrate. The wiring device 10 may include a core substrate, a first redistribution layer 18 located on the first surface of the core substrate, and a second redistribution layer 18 located on the second surface of the core substrate.

Some modifications to the above-described third embodiment have been described; of course, it is also possible to apply a combination of a plurality of modifications as needed to the above-described third embodiment.

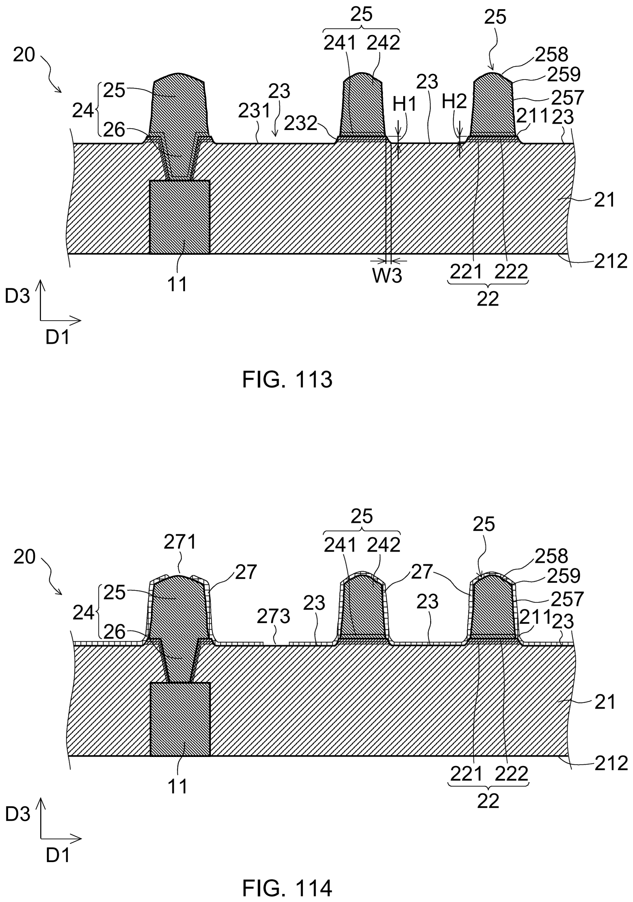

The configurations of the above-described first to third embodiments may be combined as needed. For example, as shown in Fig. 113, each of the first wires 25 of the wiring device 10 of the above-described first embodiment may have an aspect ratio greater than or equal to 2.0 and less than or equal to 4.0. For example, as shown in Fig. 114, each of the first wires 25 of the wiring device 10 of the above-described first embodiment may have an aspect ratio greater than or equal to 2.0 and less than or equal to 4.0 and may be covered by the first inorganic layer 27.

As shown in Fig. 114, the first inorganic layer 27 may include at least one opening 273, similarly to the above-described second embodiment.

Each of the first wires 25 shown in Figs. 113 and 114 may include the first side surface 257, the second side surface 258, and the connecting portion 259, similarly to the above-described third embodiment. The second inclination angle that is the angle formed by the second side surface 258 relative to the normal direction of the first upper surface 211 may be larger than the first inclination angle that is the angle formed by the first side surface 257 relative to the normal direction of the first upper surface 211.

A part of the configuration of the above-described third embodiment may be combined with the configuration of the above-described second embodiment. For example, although not shown in the drawing, the wiring device of the second embodiment, which includes the inorganic layer with the first opening may include wires each having an aspect ratio greater than or equal to 2.0 and less than or equal to 4.0. Each of the wires may include the first side surface, the second side surface, and the connecting portion, similarly to the above-described third embodiment.

### [Examples]

Next, the third embodiment of the present disclosure will be further specifically described by way of examples. The embodiment of the present disclosure is not limited to the following examples without departing from the scope of the present disclosure.

### (Comparative Example B1)

Using the method shown in Figs. 96 to 112, the first wiring layer 20 including the first organic layer 21 and the plurality of first wires 25 was formed on the base layer 55. The first organic layer 21 included polyimide. Each of the first wires 25 included the seed layer 241 and the body layer 242. The seed layer 241 included a titanium layer and a copper layer located on the titanium layer. The body layer 242 was made of copper. The height of the first wire 25 was 1.0 µm, and the width of the first wire 25 was 1.0 µm. Therefore, the aspect ratio of each of the first wires 25 was 1.0.

### (Examples B1 to B4 and Comparative Example B2)

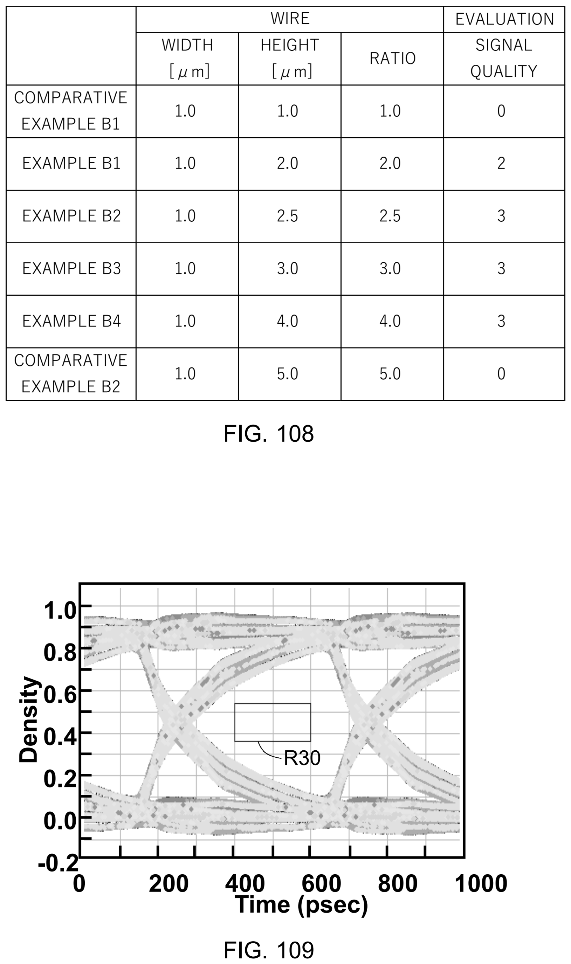

The first wiring layer 20 was formed on the base layer 55 using the method similar to that of Comparative Example B1 except that the aspect ratio of each of the first wires 25 was changed. The widths, heights, and aspect ratios of the first wires 25 in Examples B1 to B4 and Comparative Example B2 are shown in Fig. 108.

The quality of a signal transmitted by the first wires 25 of Examples B1 to B4 and Comparative Examples B1 to B2 was evaluated. The quality of the signal was evaluated by the width of the opening of the eye pattern of a high-frequency signal transmitted by the first wires 25. Fig. 109 shows an example of the eye pattern. The evaluation results are shown in the "Signal Quality" column of Fig. 108. The numeral "0" represents that the eye pattern overlapped the rectangular region R30 shown in Fig. 109. A larger numeral represents a greater margin of the opening of the eye pattern relative to the region R30. The maximum frequency of the high-frequency signal was 1.0 GHz.

As can be understood from the comparison of Examples B1 to B4 and Comparative Examples B1 to B2, when the first wire 25 had an aspect ratio greater than or equal to 2.0 and less than or equal to 4.0, it was possible to suppress the overlap of the eye pattern with the region R30. When the first wire 25 had an aspect ratio greater than or equal to 2.5 and less than or equal to 4.0, the margin of the opening of the eye pattern relative to the region R30 increased.

### (Example B5)

The plurality of first wires 25 was formed on the base layer 55 using a method similar to that of the case of Example B3. Subsequently, the first inorganic layer 27 was formed on the surfaces of the first wires 25. The first inorganic layer 27 included silicon oxide. The thickness of the first inorganic layer 27 was 40 nm.

### (Examples B6 to B9)

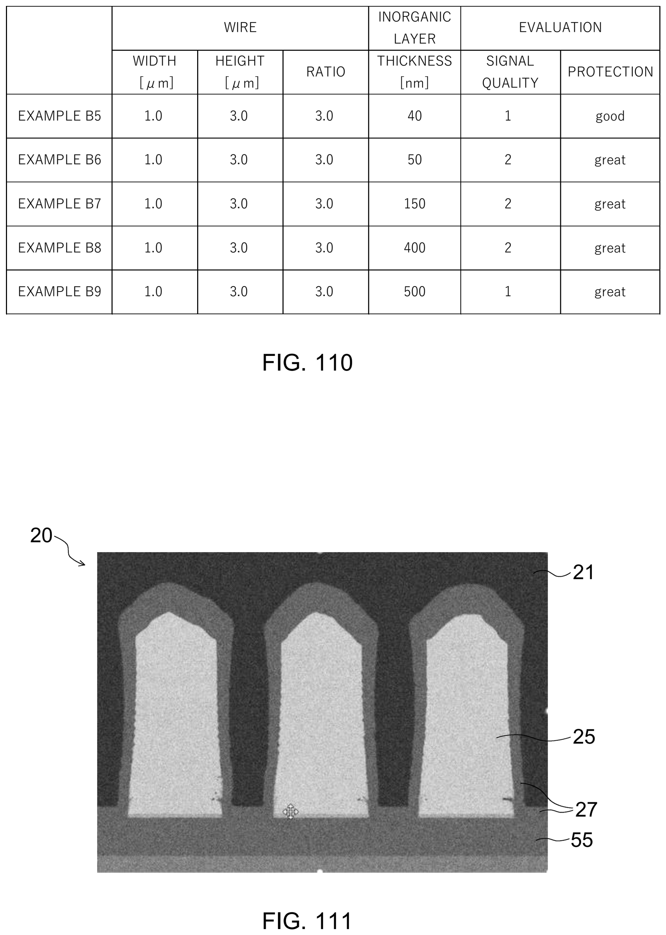

The first wiring layer 20 including the first organic layer 21, the first wires 25, and the first inorganic layer 27 was formed on the base layer 55 using a method similar to that of the case of Example B5 except that the thickness of the first inorganic layer 27 was changed. The widths, heights, and aspect ratios of the first wires 25 and the thickness of the first inorganic layer 27 in Examples B6 to B9 are shown in Fig. 110.

The quality of a signal transmitted by the first wires 25 of Examples B5 to B9 was evaluated in a similar manner to that of the case of Examples B1 to B4 and Comparative Examples B1 to B2. The evaluation results are shown in the "Signal Quality" column of Fig. 110. When the first inorganic layer 27 had a thickness greater than or equal to 40 nm and less than or equal to 500 nm, it was possible to suppress the overlap of the eye pattern with the region R30. When the first inorganic layer 27 had a thickness greater than or equal to 50 nm and less than or equal to 400 nm, the margin of the opening of the eye pattern relative to the region R30 further increased.

The protective characteristics of the first inorganic layer 27 for the first wires 25 improve as the thickness of the first inorganic layer 27 increases. In the "Protection" column of Fig. 110, "great" means that the first wires 25 are more firmly protected by the first inorganic layer 27 compared to "good".

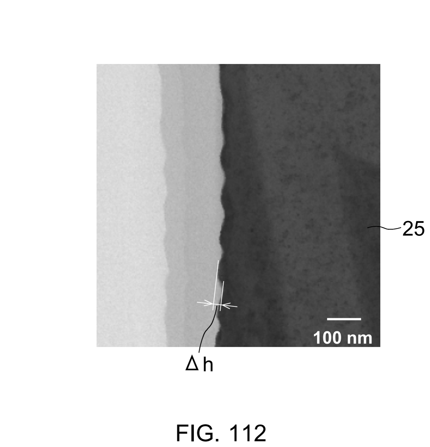

Fig. 111 shows an example of a cross-sectional image of the first wiring layer 20 including the first organic layer 21, the first wires 25, and the first inorganic layer 27. Fig. 112 is an example of a cross-sectional image that shows an enlarged view of the surface of the first wire 25. The surface roughness of the first wire 25 is measured by averaging the distance Δh between a plurality of peaks and valleys that appear in the cross-sectional image of the side surface of the first wire 25 over a certain range in the thickness direction.

### Reference Signs List

1 intermediate
10 wiring device
18 redistribution layer
20 first wiring layer
21 first organic layer
22 first transition layer
221 upper transition layer
222 lower transition layer
23 first recess
231 first bottom surface
232 first side surface
233 outer edge
24 first conductor
241 seed layer
2411 side surface
242 body layer
2421 side surface
2422 upper surface
25 first wire
26 first through portion
27 first inorganic layer
273 opening
28 first resist layer
281 opening
30 second wiring layer
31 second organic layer
34 second conductor
35 second wire
36 second through portion
37 second inorganic layer
40 semiconductor element
48 molding resin layer
60 through-via substrate
70 wiring substrate

## Claims

1. A wiring device comprising:
a first organic layer including a first upper surface and a first lower surface located opposite the first upper surface; and
a plurality of first wires located on the first upper surface, wherein
the first organic layer includes a first recess located on the first upper surface between two adjacent ones of the first wires.

2. The wiring device according to claim 1, wherein
the first recess has a depth greater than or equal to 0.10 µm, and
the depth of the first recess is a distance in a thickness direction of the first organic layer from the first upper surface overlapping the first wires to a first bottom surface of the first recess.

3. The wiring device according to claim 1, wherein
the first organic layer includes a first transition layer that constitutes the first upper surface overlapping the first wires, and
the first transition layer contains metal particles.

4. The wiring device according to claim 3, wherein the first transition layer has a thickness greater than or equal to 0.05 µm.

5. The wiring device according to claim 3, wherein
the first transition layer includes an upper transition layer that constitutes the first upper surface and a lower transition layer that is in contact with the upper transition layer in a thickness direction of the first organic layer,
the upper transition layer contains metal particles at a concentration higher than or equal to a first threshold, and
the lower transition layer contains metal particles at a concentration lower than the first threshold.

6. The wiring device according to any one of claims 1 to 5, further comprising a first inorganic layer covering the first recess.

7. The wiring device according to claim 6, wherein
the first recess includes a first bottom surface and a first side surface extending from the first upper surface toward the first bottom surface, and
the first side surface has a curved shape.

8. The wiring device according to claim 7, wherein the first side surface has a width greater than or equal to 0.10 µm.

9. The wiring device according to claim 6, wherein the first inorganic layer covers the first wires.

10. The wiring device according to claim 6, wherein
each of the plurality of first wires includes a seed layer located on the first upper surface and a body layer located on the seed layer,
the seed layer includes a side surface located inside the body layer, and
the first inorganic layer is in contact with the side surface of the seed layer.

11. The wiring device according to claim 6, wherein the first inorganic layer has a first opening formed so as to overlap the first upper surface in plan view.

12. The wiring device according to any one of claims 3 to 5, further comprising
a first inorganic layer covering the first recess, wherein
the first recess includes a first bottom surface and a first side surface extending from the first upper surface toward the first bottom surface, and
the first transition layer includes an exposed side surface located at the first side surface of the first recess, and
the first inorganic layer is in contact with the exposed side surface.

13. The wiring device according to any one of claims 1 to 5, further comprising a pad located on a surface of the wiring device.

14. The wiring device according to claim 13, further comprising a semiconductor element including a terminal connected to the pad.

15. The wiring device according to any one of claims 1 to 5, further comprising a support carrier facing the first lower surface.

16. The wiring device according to claim 15, further comprising a release layer located between the first lower surface and the support carrier.

17. The wiring device according to any one of claims 1 to 5, further comprising:
a substrate facing the first lower surface; and
a through via penetrating the substrate.

18. The wiring device according to claim 17, further comprising a wiring substrate including a wire electrically connected to the through via, the wiring substrate facing the substrate.

19. The wiring device according to claim 18, wherein the wiring substrate is a BGA substrate.

20. The wiring device according to any one of claims 1 to 5, further comprising:
a second organic layer including a second lower surface covering the first organic layer and the first wires, and a second upper surface located opposite the second lower surface; and
a plurality of second wires located on the second upper surface, wherein
the second organic layer includes a second recess located on the second upper surface between two of the second wires.

21. The wiring device according to any one of claims 1 to 5, wherein each of the first wires has an aspect ratio greater than or equal to 2.0 and less than or equal to 4.0.

22. A redistribution layer comprising
a plurality of wiring layers, wherein
each of the plurality of wiring layers includes a conductive layer and an insulating layer at least partially covering the conductive layer,
in at least one of the wiring layers, the insulating layer includes an inorganic layer that is in contact with the conductive layer so as to at least partially cover the conductive layer, and an organic layer located on the inorganic layer, and
the inorganic layer has a plurality of first openings formed so as not to overlap the conductive layer in plan view.

23. A manufacturing method for a wiring device, the manufacturing method comprising:
a step of preparing a support carrier;
a step of forming a first organic layer on the support carrier;
a first conductor forming step of forming a first conductor including a plurality of first wires located on a first upper surface of the first organic layer; and
a step of forming a first recess on the first upper surface of the first organic layer between two adjacent ones of the first wires.

24. The manufacturing method for a wiring device according to claim 23, wherein the first conductor forming step includes a reverse sputtering step of colliding ions or plasma with the first organic layer, a sputtering step of forming a seed layer on the first organic layer by sputtering, and a plating step of forming a body layer on the seed layer by electrolytic plating.
